(19) Europäisches Patentamt / European Patent Office / Office européen des brevets

(11) **EP 2 680 430 B1**

(12) **EUROPEAN PATENT SPECIFICATION**

(45) Date of publication and mention
of the grant of the patent:
**22.04.2020  Bulletin 2020/17**

(21) Application number: **12748908.6**

(22) Date of filing: **24.01.2012**

(51) Int Cl.:
*H01L 35/16* *(2006.01)*        *H01L 35/32* *(2006.01)*
*H01L 35/34* *(2006.01)*

(86) International application number:
**PCT/JP2012/000415**

(87) International publication number:
**WO 2012/114652 (30.08.2012 Gazette 2012/35)**

(54) **WIRELESS POWER SUPPLY DEVICE AND WIRELESS POWER SUPPLY METHOD**

DRAHTLOSE STROMVERSORGUNGSVORRICHTUNG UND DRAHTLOSES
STROMVERSORGUNGSVERFAHREN

DISPOSITIF D'ALIMENTATION ÉLECTRIQUE SANS FIL ET PROCÉDÉ D'ALIMENTATION
ÉLECTRIQUE SANS FIL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **21.02.2011  JP 2011034572**

(43) Date of publication of application:
**01.01.2014  Bulletin 2014/01**

(73) Proprietor: **Sony Corporation
Tokyo 108-0075 (JP)**

(72) Inventors:
• **YAJIMA, Masakazu
Tokyo 108-0075 (JP)**
• **ENOKI, Osamu
Tokyo 108-0075 (JP)**

(74) Representative: **Müller Hoffmann & Partner
Patentanwälte mbB
St.-Martin-Strasse 58
81541 München (DE)**

(56) References cited:
WO-A1-2010/071749        WO-A1-2011/019077
WO-A2-2010/067367        WO-A2-2010/112554
AT-A1- 507 533            JP-A- 2005 302 783
JP-A- 2006 332 443        JP-A- 2007 526 740
JP-A- 2008 108 900        US-A1- 2009 205 695
US-A1- 2009 301 539

**Description**

Technical Field

The present invention relates to a wireless power supply system and a wireless power supply method.

Background Art

In the past, in a contactless power supply system or a wireless power transmission system, a power supply system by means of radio waves is generally used. Further, an electromagnetic induction system and a magnetic resonance system are examples of such a power supply system (for example, see Japanese Patent Application Laid-open No. 2009-501510 and Japanese Patent Application Laid-open No. 2011-030317). The electromagnetic induction system is used as a power supply system in a state where a power supply device is in the vicinity of a power supplied device. Meanwhile, the magnetic resonance system is capable of supplying electric power in a state where a power supply device is distant from a power supplied device by about several times the wavelength because the magnetic resonance system uses the LC resonance of a circuit, and other devices are hardly affected by power supply, which is advantageous.

    Patent Document 1: Japanese Patent Application Laid-open No. 2009-501510
    Patent Document 2: Japanese Patent Application Laid-open No. 2011-030317

US2009/0205695 discloses an energy conversion device. 11
WO2010/112554 discloses a thermogenerator arrangement.
WO2010/067367 discloses split-thermoelectric structures.
WO2010/071749 discloses a high temperature thermoelectric module. AT507533 relates to a method for converting thermal energy into electrical energy with a thermocouple.
US2009/0301539 discloses a thermoelectric generation system.

Summary of Invention

Problem to be solved by the Invention

Such technologies in the past employ methods of transmitting electric power via radio waves. Meanwhile, if a system including a power generation device includes a means for supplying power supplementarily, it is not necessary to supply electric power via radio waves. Further, according to the technology in the past, it is difficult to supply electric power in an atmosphere or a scene in which a radio wave may not be used, which is problematic. Further, a magnetic resonance system using an LC resonance circuit requires a tuning system using a variable capacity capacitor or the like for frequency matching.
In view of this, an object of the present invention is to provide a wireless power supply device and a wireless power supply method capable of supplying electric power by a wireless system, using a means other than radio waves.

Means for solving the Problem

To attain the above-mentioned object, the invention provides a system according to claim 1.
To attain the above-mentioned object, the invention provides a method according to claim 10.

Effect of the Invention

According to the wireless power supply device or the wireless power supply method of the present invention, instead of supplying electric power via a radio wave, the temperature control device periodically changes the temperature of an atmosphere in which the thermoelectric generation device is arranged, whereby the thermoelectric generation device generates thermoelectricity. That is, it is possible to transmit electric power indirectly. Because of this, a point of use is not restricted, that is, it is possible to supply electric power in an atmosphere or a scene in which a radio wave may not be used, in a space to which a radio wave is hardly transmitted, or in an electromagnetic shielded space, without directionality, easily, safely, and with a simple structure, and other electronic devices may not be affected. Further, thermoelectricity is generated based on an atmosphere in which the thermoelectric generation device is arranged or based on temperature change or temperature fluctuation in an atmosphere, whereby remote monitoring, remote sensing, and the like from a remote place are enabled, and it is possible to previously arrange a power generation device in a place in which it is difficult to arrange a power generation device or a place in which it is difficult to physically provide wirings or wire connection after a power generation device is once installed. Further, it is possible to increase the degree of freedom of design and layout of a power generation device.

Brief Description of Drawings

[Fig. 1] Each of (A) and (B) of Fig. 1 is a conceptual diagram of a wireless power supply device and a book management system of Example 1.

[Fig. 2] Fig. 2 is a graph showing the relation between temperature change in an atmosphere and a voltage output from a thermoelectric generation device, which is obtained based on simulation.

[Fig. 3] Fig. 3 is a graph showing the relation between temperature change in an atmosphere and a voltage output from a thermoelectric generation device, which is obtained based on simulation.

[Fig. 4] (A) of Fig. 4 is a schematic partial sectional view showing a thermoelectric generation device of Example 4, and (B) of Fig. 4 schematically shows the temperature ($T_A$) of a first support member, the temperature ($T_B$) of a second support member, the change of the temperature difference ($\Delta T = T_B - T_A$) between those temperatures, and the change of the voltage $V_{1-2}$ between a first output unit and a second output unit.

[Fig. 5] (A) of Fig. 5 is a schematic partial sectional view showing a thermoelectric generation device of Example 5, and (B) of Fig. 5 schematically shows the temperature ($T_A$) of a first support member, the temperature ($T_B$) of a second support member, the change of the temperature difference ($\Delta T = T_B - T_A$) between those temperatures, and the change of the voltage $V_{1-2}$ between a first output unit and a second output unit.

[Fig. 6] (A) of Fig. 6 is a schematic partial sectional view showing a thermoelectric generation device of Example 6, and (B) of Fig. 6 schematically shows the temperature ($T_A$) of a first support member, the temperature ($T_B$) of a second support member, the change of the temperature difference ($\Delta T = T_B - T_A$) between those temperatures, and the change of the voltage $V_{1-2}$ between a first output unit and a second output unit.

[Fig. 7] Fig. 7 is a schematic partial plan view showing a thermoelectric generation device of Example 7.

[Fig. 8] (A), (B), (C), (D), and (E) of Fig. 8 are schematic partial sectional views showing the thermoelectric generation device of Example 7 shown in Fig. 7 taken along the arrow A-A, the arrow B-B, the arrow C-C, the arrow D-D, and the arrow E-E, respectively.

[Fig. 9] Each of (A) and (B) of Fig. 9 is a schematic partial sectional view showing the thermoelectric generation device suitable of Example 8.

[Fig. 10] Fig. 10 schematically shows the temperature ($T_A$) of the first support member, the temperature ($T_B$) of the second support member, the change of the temperature difference ($\Delta T = T_B - T_A$) between those temperatures, the change of the voltage $V_{1-2}$ between the first output unit and the second output unit, and the change of the voltage $V_{3-4}$ between the third output unit and the fourth output unit of Example 8.

[Fig. 11] Each of (A) and (B) of Fig. 11 is a schematic partial sectional view showing the thermoelectric generation device of Example 9.

[Fig. 12] Fig. 12 schematically shows the temperature ($T_A$) of the first support member, the temperature ($T_B$) of the second support member, the change of the temperature difference ($\Delta T = T_B - T_A$) between those temperatures, the change of the voltage $V_{1-2}$ between the first output unit and the second output unit, and the change of the voltage $V_{3-4}$ between the third output unit and the fourth output unit of Example 9.

[Fig. 13] Each of (A) and (B) of Fig. 13 is a schematic partial sectional view showing the thermoelectric generation device of Example 10.

[Fig. 14] Fig. 14 schematically shows the temperature ($T_A$) of the first support member, the temperature ($T_B$) of the second support member, the change of the temperature difference ($\Delta T = T_B - T_A$) between those temperatures, the change of the voltage $V_{1-2}$ between the first output unit and the second output unit, and the change of the voltage $V_{3-4}$ between the third output unit and the fourth output unit of Example 10.

[Fig. 15] Each of (A) and (B) of Fig. 15 is a schematic partial sectional view showing the thermoelectric generation device suitable for the thermoelectric generation method of Example 11.

[Fig. 16] Fig. 16 schematically shows the temperature ($T_A$) of the first support member, the temperature ($T_B$) of the second support member, the change of the temperature difference ($\Delta T = T_B - 1_A$) between those temperatures, the change of the voltage $V_{1-2}$ between the first output unit and the second output unit, and the change of the voltage $V_{3-4}$ between the third output unit and the fourth output unit of Example 11.

[Fig. 17] Each of (A) and (B) of Fig. 17 is a schematic partial sectional view showing the thermoelectric generation device of Example 12.

[Fig. 18] Fig. 18 schematically shows the temperature ($T_A$) of the first support member, the temperature ($T_B$) of the second support member, the change of the temperature difference ($\Delta T = T_B - T_A$) between those temperatures, the change of the voltage $V_{1-2}$ between the first output unit and the second output unit, and the change of the voltage $V_{3-4}$ between the third output unit and the fourth output unit of Example 12.

[Fig. 19] Each of (A) and (B) of Fig. 19 is a schematic partial sectional view showing the thermoelectric generation device of Example 13.

[Fig. 20] Each of (A), (B), and (C) of Fig. 20 is a circuit diagram showing an example of a rectifier circuit, and (D) of Fig. 20 is a conceptual diagram showing an example of an application of the thermoelectric generation device of the present invention.

[Fig. 21] Fig. 21 is a graph showing the results of simulation of change of the temperature difference $\Delta T$ (=$T_B$-$T_A$) between the temperature $T_B$ of the second support member 12 and the temperature $T_A$ of the first support member 11 corresponding to the change of the temperature if the temperature change of the atmosphere is a sinusoidal wave.

[Fig. 22] Fig. 22 shows the results of simulation of the obtained value $\Delta T$ depending on the value $\tau_1$ where $\tau_2$ is a constant (=0.1), and $\omega$ is variously changed as a parameter. Mode(s) for Carrying Out the Invention

Hereinafter, the present invention will be described based on examples with reference to the drawings. However, the present invention is not limited to the examples, and various numerical values and materials in the examples are shown as examples. Note that the description will be made in the following order.

1. Overall description of a wireless power supply device and a wireless power supply method of the present invention
2. Example 1 (wireless power supply device and wireless power supply method of the present invention)
3. Example 2 (modification of Example 1)
4. Example 3 (another modification of Example 1)
5. Example 4 (thermoelectric generation device and thermoelectric generation method of first mode)
6. Example 5 (thermoelectric generation device and thermoelectric generation method of second mode)
7. Example 6 (thermoelectric generation device and thermoelectric generation method of third mode)
8. Example 7 (modification of Example 6)
9. Example 8 (thermoelectric generation method of fourth-A mode)
10. Example 9 (thermoelectric generation method of fourth-B mode, and thermoelectric generation device of fourth mode)
11. Example 10 (modification of Example 9)
12. Example 11 (thermoelectric generation method of fifth-A mode)
13. Example 12 (thermoelectric generation method of fifth-B mode, and thermoelectric generation device of fifth mode)
14. Example 13 (modification of Example 12)
15. Example 14 (electric signal detecting method of first mode to fifth-B mode, and electric signal detecting device of the present invention), etc.

[Overall description of wireless power supply device and wireless power supply method of the present invention]

The wireless power supply device of the present invention or the wireless power supply method of the present invention (hereinafter, they are sometimes collectively and simply referred to as "the present invention") may include a plurality of thermoelectric generation devices, and thermal response characteristics of the thermoelectric generation devices may be the same. Note that this structure may sometimes be referred to as, for convenience, "first structure of the present invention". According to the first structure of the present invention, the plurality of thermoelectric generation devices are capable of responding to periodic change of atmospheric temperature due to a temperature control device together, and the plurality of thermoelectric generation devices are capable of bringing electric power of the same characteristics to the exterior simultaneously and collectively.

Alternatively, the present invention may include a plurality of thermoelectric generation devices, thermal response characteristics of the thermoelectric generation devices may be different from each other, and the temperature control device is configured to periodically change the temperature of an atmosphere in sequence based on temperature change corresponding to thermoelectric generation devices, thermal response characteristics of the thermoelectric generation devices being different from each other. Note that this structure may sometimes be referred to as, for convenience, "second structure of the present invention". The plurality of thermoelectric generation devices may be a plurality of thermoelectric generation device groups, and the thermal response characteristics of the thermoelectric generation device groups may be different from each other. According to the second structure of the present invention, the plurality of thermoelectric generation devices (or thermoelectric generation device groups having the same thermal response characteristics) are capable of responding to periodic change of the atmospheric temperature of the temperature control device temporally and individually, and the plurality of thermoelectric generation devices or specific thermoelectric generation devices are capable of bringing electric power having different characteristics to the exterior temporally and separately. Note that, instead of making thermal response characteristics of the thermoelectric generation devices themselves different, thermal response characteristics of the thermoelectric generation devices may be the same, and the output unit of each thermoelectric generation device may include a filter, whereby thermal response characteristics of the thermoelectric generation devices are different as a whole.

Alternatively, according to the present invention, the wireless power supply device may include a plurality of thermoelectric generation devices,
thermal response characteristics of the thermoelectric generation devices may be different from each other, and
the temperature control device is configured to periodically change temperature of an atmosphere in sequence based on synthesized temperature change corresponding to thermoelectric generation devices, thermal response characteristics of the thermoelectric generation devices being different from each other. Note that this structure may sometimes be referred to as, for convenience, "third structure of the present invention". The plurality of thermoelectric generation devices may be a plurality of thermoelectric generation device groups, and the thermal response characteristics of the thermoelectric generation device groups may be different from each other. According to the third structure of the present invention, the plurality of thermoelectric generation devices (or thermoelectric generation device groups having the same thermal response characteristics) are capable of responding to periodic change of the atmospheric temperature of the temperature control device temporally and individually, and the plurality of thermoelectric generation devices or specific thermoelectric generation devices are capable of bringing electric power having different characteristics to the exterior temporally and separately. Note that, instead of making thermal response characteristics of the thermoelectric generation devices themselves different, thermal response characteristics of the thermoelectric generation devices may be the same, and the output unit of each thermoelectric generation device may include a filter, whereby thermal response characteristics of the thermoelectric generation devices are different as a whole.

According to the wireless power supply device of the present invention including the first structure to the third structure of the present invention,
the thermoelectric generation device includes

(A) a first support member,
(B) a second support member facing the first support member,
(C) a thermoelectric conversion element arranged between the first support member and the second support member, and
(D) a first output unit and a second output unit connected to the thermoelectric conversion element,
the thermoelectric conversion element includes
(C-1) a first thermoelectric conversion member arranged between the first support member and the second support member, and
(C-2) a second thermoelectric conversion member arranged between the first support member and the second support member, a material of the second thermoelectric conversion member being different from a material of the first thermoelectric conversion member, the second thermoelectric conversion member being electrically connected to the first thermoelectric conversion member in series,
the first output unit is connected to an end of the first thermoelectric conversion member, the end being at the first support member side, and
the second output unit is connected to an end of the second thermoelectric conversion member, the end being at the first support member side.

Further,
$\tau_{SM1} > \tau_{SM2}$ and
$S_{12} \neq S_{22}$ are satisfied
where the area of a first surface of the first thermoelectric conversion member is $S_{11}$, the first surface being on the first support member, the area of a second surface of the first thermoelectric conversion member is $S_{12}$ (where $S_{11} > S_{12}$), the second surface being on the second support member, the area of a first surface of the second thermoelectric conversion member is $S_{21}$, the first surface being on the first support member, the area of a second surface of the second thermoelectric conversion member is $S_{22}$ (where $S_{21} > S_{22}$), the second surface being on the second support member, a constant in thermal response of the first support member is $\tau_{SM1}$, and a constant in thermal response of the second support member is $\tau_{SM2}$. Note that this thermoelectric generation device will be referred to as, for convenience, "thermoelectric generation device of first mode".

Alternatively,
$\tau_{SM1} > \tau_{SM2}$ and
$VL_1 \neq VL_2$ are satisfied
where the volume of the first thermoelectric conversion member is $VL_1$, the volume of the second thermoelectric conversion member is $VL_2$, a constant in thermal response of the first support member is $\tau_{SM1}$, and a constant in thermal response of the second support member is $\tau_{SM2}$. Note that this thermoelectric generation device will be referred to as, for convenience, "thermoelectric generation device of second mode".

Alternatively, according to the wireless power supply device of the present invention including the first structure to the third structure of the present invention,
the thermoelectric generation device includes

(A) a first support member,
(B) a second support member facing the first support member,
(C) a first thermoelectric conversion element arranged between the first support member and the second support member,
(D) a second thermoelectric conversion element arranged between the first support member and the second support member, and
(E) a first output unit and a second output unit,
the first thermoelectric conversion element includes a first-A thermoelectric conversion member on the second support member and a first-B thermoelectric conversion member on the first support member, the first-A thermoelectric conversion member being on the first-B thermoelectric conversion member,
the second thermoelectric conversion element includes a second-A thermoelectric conversion member on the first support member and a second-B thermoelectric conversion member on the second support member, the second-A thermoelectric conversion member being on the second-B thermoelectric conversion member,
the first thermoelectric conversion element and the second thermoelectric conversion element are electrically connected in series,
the first output unit is connected to an end of the first-B thermoelectric conversion member,
the second output unit is connected to an end of the second-A thermoelectric conversion member, and
$\tau_{SM1} \neq \tau_{SM2}$ is satisfied
where a constant in thermal response of the first support member is $\tau_{SM1}$, and a constant in thermal response of the second support member is $\tau_{SM2}$. Note that this thermoelectric generation device will be referred to as, for convenience, "thermoelectric generation device of third mode".

Alternatively, according to the wireless power supply device of the present invention including the first structure to the third structure of the present invention,
the thermoelectric generation device includes

(A) a first support member,
(B) a second support member facing the first support member,
(C) a first thermoelectric conversion element arranged between the first support member and the second support member,
(D) a second thermoelectric conversion element arranged between the first support member and the second support member, and
(E) a first output unit, a second output unit, a third output unit, and a fourth output unit,
the first thermoelectric conversion element includes
(C-1) a first thermoelectric conversion member arranged between the first support member and the second support member, and
(C-2) a second thermoelectric conversion member arranged between the first support member and the second support member, a material of the second thermoelectric conversion member being different from a material of the first thermoelectric conversion member, the second thermoelectric conversion member being electrically connected to the first thermoelectric conversion member in series,
the second thermoelectric conversion element includes
(D-1) a third thermoelectric conversion member arranged between the first support member and the second support member, and
(D-2) a fourth thermoelectric conversion member arranged between the first support member and the second support member, a material of the fourth thermoelectric conversion member being different from a material of the third thermoelectric conversion member, the fourth thermoelectric conversion member being electrically connected to the third thermoelectric conversion member in series,
the first output unit is connected to the first thermoelectric conversion member,
the second output unit is connected to the second thermoelectric conversion member,
the third output unit is connected to the third thermoelectric conversion member,
the fourth output unit is connected to the fourth thermoelectric conversion member, and
$\tau_{SM1} \neq \tau_{SM2}$ is satisfied

where a constant in thermal response of the first support member is $\tau_{SM1}$, and a constant in thermal response of the second support member is $\tau_{SM2}$. Note that this thermoelectric generation device will be referred to as, for convenience, "thermoelectric generation device of fourth mode".

Alternatively, according to the wireless power supply device of the present invention including the first structure to the third structure of the present invention,
the thermoelectric generation device includes

(A) a first support member,
(B) a second support member facing the first support member,
(C) a first thermoelectric conversion element arranged between the first support member and the second support member,
(D) a second thermoelectric conversion element arranged between the first support member and the second support member,
(E) a third thermoelectric conversion element arranged between the first support member and the second support member,
(F) a fourth thermoelectric conversion element arranged between the first support member and the second support member, and
(G) a first output unit, a second output unit, a third output unit, and a fourth output unit,

the first thermoelectric conversion element includes a first-A thermoelectric conversion member on the second support member and a first-B thermoelectric conversion member on the first support member, the first-A thermoelectric conversion member being on the first-B thermoelectric conversion member,
the second thermoelectric conversion element includes a second-A thermoelectric conversion member on the first support member and a second-B thermoelectric conversion member on the second support member, the second-A thermoelectric conversion member being on the second-B thermoelectric conversion member,
the third thermoelectric conversion element includes a third-A thermoelectric conversion member on the second support member and a third-B thermoelectric conversion member on the first support member, the third-A thermoelectric conversion member being on the third-B thermoelectric conversion member,
the fourth thermoelectric conversion element includes a fourth-A thermoelectric conversion member on the first support member and a fourth-B thermoelectric conversion member on the second support member, the fourth-A thermoelectric conversion member being on the fourth-B thermoelectric conversion member,
the first thermoelectric conversion element and the second thermoelectric conversion element are electrically connected in series,
the third thermoelectric conversion element and the fourth thermoelectric conversion element are electrically connected in series,
the first output unit is connected to the first thermoelectric conversion element,
the second output unit is connected to the second thermoelectric conversion element,
the third output unit is connected to the third thermoelectric conversion element,
the fourth output unit is connected to the fourth thermoelectric conversion element, and
$\tau_{SM1} \neq \tau_{SM2}$ is satisfied
where a constant in thermal response of the first support member is $\tau_{SM1}$, and a constant in thermal response of the second support member is $\tau_{SM2}$. Note that this thermoelectric generation device will be referred to as, for convenience, "thermoelectric generation device of fifth mode".

A wireless power supply method of the present invention including the first structure to the third structure of the present invention may be a wireless power supply method using the thermoelectric generation device of the first mode, may be a wireless power supply method using the thermoelectric generation device of the second mode, or may be a wireless power supply method using the thermoelectric generation device of the third mode. Further, the wireless power supply method includes:

arranging the thermoelectric generation device in an atmosphere, the atmospheric temperature changing; and
bringing current to the exterior, the current being generated due to temperature difference between the first support member and the second support member when the temperature of the second support member is higher than the temperature of the first support member, the current flowing from the second thermoelectric conversion member to the first thermoelectric conversion member, the first output unit being a positive electrode, the second output unit being a negative electrode (for convenience, referred to as "thermoelectric generation method of first mode" or "thermoelectric generation method of second mode"); or bringing current to the exterior, the current flowing from the second thermoelectric conversion element to the first thermoelectric conversion element, the first output unit being a positive electrode, the second output unit being a negative electrode (for convenience, referred to as "thermoelectric generation method of third mode").

Alternatively, the wireless power supply method of the present invention including the first structure to the third structure of the present invention may be a wireless power supply method using the thermoelectric generation device of the fourth mode, and includes:

arranging the thermoelectric generation device in an atmosphere, the atmospheric temperature changing;
bringing current to the exterior, the current being generated due to temperature difference between the first support member and the second support member when the temperature of the second support member is higher than the temperature of the first support member, the current flowing from the second thermoelectric conversion member to the first thermoelectric conversion member, the first output unit being a positive electrode, the second output unit being a negative electrode; and
bringing current to the exterior, the current being generated due to temperature difference between the first support member and the second support member when the temperature of the first support member is higher than the temperature of the second support member, the current flowing from the fourth thermoelectric conversion member to the third thermoelectric conversion member, the third output unit being a positive electrode, the fourth output unit being a negative electrode. Note that this thermoelectric generation device will be referred to as, for convenience, "thermoelectric generation method of fourth-A mode".

Alternatively, the wireless power supply method of the present invention including the first structure to the third structure of the present invention includes:

instead of bringing current to the exterior, the current being generated due to temperature difference between the first support member and the second support member when the temperature of the second support member is higher than the temperature of the first support member, the current flowing from the second thermoelectric conversion member to the first thermoelectric conversion member, the first output unit being a positive electrode, the second output unit being a negative electrode, and bringing current to the exterior, the current being generated due to temperature difference between the first support member and the second support member when the temperature of the first support member is higher than the temperature of the second support member, the current flowing from the fourth thermoelectric conversion member to the third thermoelectric conversion member, the third output unit being a positive electrode, the fourth output unit being a negative electrode, of the wireless power supply method according to the thermoelectric generation method of the fourth-A mode,
bringing current to the exterior, the current being generated due to temperature difference between the first support member and the second support member when the temperature of the second support member is higher than the temperature of the first support member, the current flowing from the second thermoelectric conversion member to the first thermoelectric conversion member, the first output unit being a positive electrode, the second output unit being a negative electrode; and bringing current to the exterior, the current flowing from the fourth thermoelectric conversion member to the third thermoelectric conversion member, the third output unit being a positive electrode, the fourth output unit being a negative electrode. Note that this thermoelectric generation device will be referred to as, for convenience, "thermoelectric generation method of fourth-B mode".

Alternatively, the wireless power supply method of the present invention including the first structure to the third structure of the present invention may be a wireless power supply method using the thermoelectric generation device of the fifth mode, and includes:

arranging the thermoelectric generation device in an atmosphere, the atmospheric temperature changing;
bringing current to the exterior, the current being generated due to temperature difference between the first support member and the second support member when the temperature of the second support member is higher than the temperature of the first support member, the current flowing from the second thermoelectric conversion element to the first thermoelectric conversion element, the first output unit being a positive electrode, the second output unit being a negative electrode; and
bringing current to the exterior, the current being generated due to temperature difference between the first support member and the second support member when the temperature of the first support member is higher than the temperature of the second support member, the current flowing from the third thermoelectric conversion element to the fourth thermoelectric conversion element, the fourth output unit being a positive electrode, the third output unit being a negative electrode. Note that this thermoelectric generation device will be referred to as, for convenience, "thermoelectric generation method of fifth-A mode".

Alternatively, the wireless power supply method of the present invention including the first structure to the third structure of the present invention includes:

instead of bringing current to the exterior, the current being generated due to temperature difference between the first support member and the second support member when the temperature of the second support member is higher than the temperature of the first support member, the current flowing from the second thermoelectric conversion element to the first thermoelectric conversion element, the first output unit being a positive electrode, the second output unit being a negative electrode, and bringing current to the exterior, the current being generated due to temperature difference between the first support member and the second support member when the temperature of the first support member is higher than the temperature of the second support member, the current flowing from the third thermoelectric conversion element to the fourth thermoelectric conversion element, the fourth output unit being a positive electrode, the third output unit being a negative electrode, of the wireless power supply method according to the thermoelectric generation method of the fifth-A mode,

bringing current to the exterior, the current being generated due to temperature difference between the first support member and the second support member when the temperature of the second support member is higher than the temperature of the first support member, the current flowing from the second thermoelectric conversion element to the first thermoelectric conversion element, the first output unit being a positive electrode, the second output unit being a negative electrode; and bringing current to the exterior, the current flowing from the fourth thermoelectric conversion element to the third thermoelectric conversion element, the third output unit being a positive electrode, the fourth output unit being a negative electrode. Note that this thermoelectric generation device will be referred to as, for convenience, "thermoelectric generation method of fifth-B mode".

According to the thermoelectric generation device of the thermoelectric generation method of the fourth-A mode or the thermoelectric generation device of the fourth mode (hereinafter, they may sometimes be collectively referred to as "invention of fourth-A mode, etc."), in the thermoelectric generation device,
the first output unit is connected to an end of the first thermoelectric conversion member, the end being at the first support member side,
the second output unit is connected to an end of the second thermoelectric conversion member, the end being at the first support member side,
the third output unit is connected to an end of the third thermoelectric conversion member, the end being at the second support member side, and
the fourth output unit is connected to an end of the fourth thermoelectric conversion member, the end being at the second support member side.

According to the thermoelectric generation device of the thermoelectric generation method of the fourth-B mode or the thermoelectric generation device of the fourth mode (hereinafter, they may sometimes be collectively referred to as "invention of fourth-B mode, etc."), in the thermoelectric generation device,
the first output unit is connected to an end of the first thermoelectric conversion member, the end being at the first support member side,
the second output unit is connected to an end of the second thermoelectric conversion member, the end being at the first support member side,
the third output unit is connected to an end of the third thermoelectric conversion member, the end being at the first support member side, and
the fourth output unit is connected to an end of the fourth thermoelectric conversion member, the end being at the first support member side.

Further, according to the invention of the fourth-B mode including the preferable structure, in the thermoelectric generation device, it is preferable that $\tau_{TE1} \neq \tau_{TE2}$ be satisfied where a constant in thermal response of the first thermoelectric conversion element is $\tau_{TE1}$, and a constant in thermal response of the second thermoelectric conversion element is $\tau_{TE2}$. Further, in this case,
the first thermoelectric conversion member may have a first surface having an area $S_{11}$, and a second surface having an area $S_{12}$ (where $S_{11} > S_{12}$),
the second thermoelectric conversion member may have a first surface having an area $S_{21}$, and a second surface having an area $S_{22}$ (where $S_{21} > S_{22}$),
the third thermoelectric conversion member may have a first surface having an area $S_{31}$, and a second surface having an area $S_{32}$ (where $S_{31} < S_{32}$),
the fourth thermoelectric conversion member may have a first surface having an area $S_{41}$, and a second surface having an area $S_{42}$ (where $S_{41} < S_{42}$),
the first surface of the first thermoelectric conversion member and the first surface of the second thermoelectric conversion member may be on the first support member,

the second surface of the first thermoelectric conversion member and the second surface of the second thermoelectric conversion member may be on the second support member,

the first surface of the third thermoelectric conversion member and the first surface of the fourth thermoelectric conversion member may be on the first support member, and

the second surface of the third thermoelectric conversion member and the second surface of the fourth thermoelectric conversion member may be on the second support member. The specific shape of the first thermoelectric conversion member, the second thermoelectric conversion member, the third thermoelectric conversion member, or the fourth thermoelectric conversion member of this structure may be a truncated pyramid/cone, more specifically, a truncated triangular pyramid, a truncated square pyramid, a truncated hexagonal pyramid, or a truncated cone, for example. Alternatively, in this case,

$VL_1 \neq VL_3$ and

$VL_2 \# VL_4$ may be satisfied

where the volume of the first thermoelectric conversion member is $VL_1$, the volume of the second thermoelectric conversion member is $VL_2$, the volume of the third thermoelectric conversion member is $VL_3$, and the volume of the fourth thermoelectric conversion member is $VL_4$. In this structure, the specific shape of the first thermoelectric conversion member, the second thermoelectric conversion member, the third thermoelectric conversion member, or the fourth thermoelectric conversion member may be a prism/cylinder, more specifically, a triangular prism, a rectangular prism, a hexagonal prism, or a cylinder, for example. Note that it is more preferable that

$VL_1 \neq VL_2$ and

$VL_3 \neq VL_4$ be satisfied.

According to the thermoelectric generation device of the thermoelectric generation method of the fifth-A mode or the thermoelectric generation device (hereinafter, they may sometimes be collectively referred to as "invention of fifth-A mode, etc.") of the fifth mode, in the thermoelectric generation device,

the first output unit may be connected to an end of the first-B thermoelectric conversion member,

the second output unit may be connected to an end of the second-A thermoelectric conversion member,

the third output unit may be connected to an end of the third-A thermoelectric conversion member, and

the fourth output unit may be connected to an end of the fourth-B thermoelectric conversion member.

Alternatively, according to the thermoelectric generation device of the thermoelectric generation method of the fifth-B mode or the thermoelectric generation device (hereinafter, they may sometimes be collectively referred to as "invention of fifth-B mode, etc.") of the fifth mode, in the thermoelectric generation device,

the first output unit may be connected to an end of the first-B thermoelectric conversion member,

the second output unit may be connected to an end of the second-A thermoelectric conversion member,

the third output unit may be connected to an end of the third-B thermoelectric conversion member, and

the fourth output unit may be connected to an end of the fourth-A thermoelectric conversion member.

Further, according to the invention of the fifth-B mode, etc. including the preferable structure, in the thermoelectric generation device, it is preferable that

$\tau_{TE1} \neq \tau_{TE3}$ and

$\tau_{TE2} \neq \tau_{TE4}$ be satisfied

where a constant in thermal response of the first thermoelectric conversion element is $\tau_{TE1}$, a constant in thermal response of the second thermoelectric conversion element is $\tau_{TE2}$, a constant in thermal response of the third thermoelectric conversion element is $\tau_{TE3}$, and a constant in thermal response of the fourth thermoelectric conversion element is $\tau_{TE4}$. Further, in this case,

$VL_1 \neq VL_3$ and

$VL_2 \neq VL_4$ may be satisfied

where the volume of the first thermoelectric conversion member is $VL_1$, the volume of the second thermoelectric conversion member is $VL_2$, the volume of the third thermoelectric conversion member is $VL_3$, and the volume of the fourth thermoelectric conversion member is $VL_4$. Alternatively,

$S_{12} \neq S_{32}$ and

$S_{21} \neq S_{41}$ may be satisfied

where the area of a part of the first-A thermoelectric conversion member, which is on the second support member, is $S_{12}$, the area of a part of the second-B thermoelectric conversion member, which is on the first support member, is $S_{21}$, the area of a part of the third-A thermoelectric conversion member, which is on the second support member, is $S_{32}$, and the area of a part of the fourth-B thermoelectric conversion member, which is on the first support member, is $S_{41}$, and further

$S_{12} \neq S_{21}$ and

$S_{32} \neq S_{41}$ may be satisfied.

According to the thermoelectric generation device of the first mode to the fifth mode including the various preferable structures and the thermoelectric generation device (hereinafter, they may sometimes be collectively and simply referred to as "thermoelectric generation devices of the present invention") used in the thermoelectric generation method of the first mode to the fifth-B mode, the constant in thermal response $\tau_{SM1}$ of the first support member is different from the constant in thermal response $\tau_{SM2}$ of the second support member. Because of this, if the thermoelectric generation device is arranged in an atmosphere, of which temperature changes, the temperature of the first support member may be different from the temperature of the second support member. As a result, the thermoelectric conversion element, the first thermoelectric conversion element, or the second thermoelectric conversion element generates thermoelectricity. In other words, if the constant in thermal response $\tau_{SM1}$ of the first support member is the same as the constant in thermal response $\tau_{SM2}$ of the second support member, even if the thermoelectric generation device is arranged in an atmosphere, of which temperature does not change, the temperature of the first support member is not different from the temperature of the second support member, whereby the thermoelectric conversion element, the first thermoelectric conversion element, or the second thermoelectric conversion element does not generate thermoelectricity.

According to the thermoelectric generation devices of the present invention, the number of the thermoelectric conversion elements of the thermoelectric generation device is essentially an arbitrary value, and the number of the thermoelectric conversion elements may be determined based on a thermoelectricity generation amount required for the thermoelectric generation device.

The constant in thermal response $\tau$ is determined depending on the density p, the specific heat c, and the heat transfer coefficient h of the materials of the support member, the thermoelectric conversion element, and the thermoelectric conversion member, and depending on the volume VL and the area S of the support member, the thermoelectric conversion element, and the thermoelectric conversion member. If a material having a larger density, a larger specific heat, and a smaller heat transfer coefficient is used, if the volume is larger, and if the area is smaller, the value of the constant in thermal response is larger. Here, the constant in thermal response $\tau$ may be obtained based on the following equation (1).

$$\tau = (\rho \cdot c/h) \times (V/S) \quad (1)$$

According to the thermoelectric generation devices of the present invention, the temperature of an end of the thermoelectric generation device is changed in a stepwise manner, and for example an infrared thermometer monitors a temperature transient response at this time, whereby the constant in thermal response may be measured. Alternatively, a thermocouple, of which thermal time constant is large enough, is mounted on the support member, and temperature transit is measured, whereby the constant in thermal response may be measured. Further, the similar temperature change is supplied to the thermoelectric generation device, and thereafter the waveform output from the thermoelectric generation device is monitored, whereby the temperature difference between the upper end and the lower end of the thermoelectric conversion element may be estimated, and a time period between the maximum point and the minimum point of the output voltage is measured, to thereby obtain the constant in thermal response of the thermoelectric conversion element.

Further, the temperature $T_{SM}$ of the support member is obtained based on the following equation (2) where $T_{amb}$ is indicative of the atmospheric temperature of an atmosphere in which the thermoelectric generation device is arranged, and $\tau_{SM}$ is indicative of the constant in thermal response of the support member.

$$T_{amb} = T_{SM} + \tau_{SM} \times (dT_{SM}/dt) \quad (2)$$

Here, let's say that the temperature change of the atmospheric temperature $T_{amb}$ is a sinusoidal wave expressed by the following equation (3).

$$T_{amb} = \Delta T_{amb} \times \sin(\omega \cdot t) + A \quad (3)$$

where

$\Delta T_{amb}$: amplitude of temperature change of atmospheric temperature $T_{amb}$,
$\omega$: angular velocity, i.e., 2n/inverse number of cycle (TM) of temperature change, and
A: constant.

With respect to the temperature change of the atmospheric temperature $T_{amb}$, the thermal responses $T_1$, $T_2$ of the support members having the constants in thermal response $\tau_1$, $\tau_2$ are expressed by the following equation (4-1) and equation (4-2), respectively.

$$T_1 = \Delta T_{amb} (1 + {\tau_1}^2 \omega^2)^{-1} \times \sin(\omega \cdot t + k_1) + B_1 \quad (4-1)$$

$$T_2 = \Delta T_{amb} (1 + {\tau_2}^2 \omega^2)^{-1} \times \sin(\omega \cdot t + k_2) + B_2 \quad (4-2)$$

where

$$\sin(k_1) = (\tau_1 \cdot \omega) \cdot (1 + {\tau_1}^2 \omega^2)^{-1}$$

$$\cos(k_1) = (1 + {\tau_1}^2 \omega^2)^{-1}$$

$$\sin(k_2) = (\tau_2 \cdot \omega) \cdot (1 + {\tau_2}^2 \omega^2)^{-1}$$

$$\cos(k_2) = (1 + {\tau_2}^2 \omega^2)^{-1}$$

$k_1$ or $k_2$ is indicative of a phase lag, and $B_1$ or $B_2$ is indicative of the center temperature of temperature change.

Therefore, the temperature difference ($\Delta T = T_B - T_A$) between the temperature ($T_A$) of the first support member and the temperature ($T_B$) of the second support member may be approximated based on the following equation (5).

$$\Delta T = [\Delta T_{amb} \cdot \omega (\tau_1 - \tau_2)] \times (1 + {\tau_1}^2 \omega^2)^{-1} \times (1 + {\tau_2}^2 \omega^2)^{-1}$$
$$\times \sin(\omega \cdot t + \phi) + C \quad (5)$$

where

$$\sin(\phi) = N (M^2 + N^2)^{-1}$$

$$\cos(\phi) = M (M^2 + N^2)^{-1}$$

$$C = B_1 - B_2$$

$$M = \omega ({\tau_1}^2 - {\tau_2}^2)$$

$$N = \tau_2 (1 + {\tau_1}^2 \omega^2) - \tau_1 (1 + {\tau_2}^2 \omega^2)$$

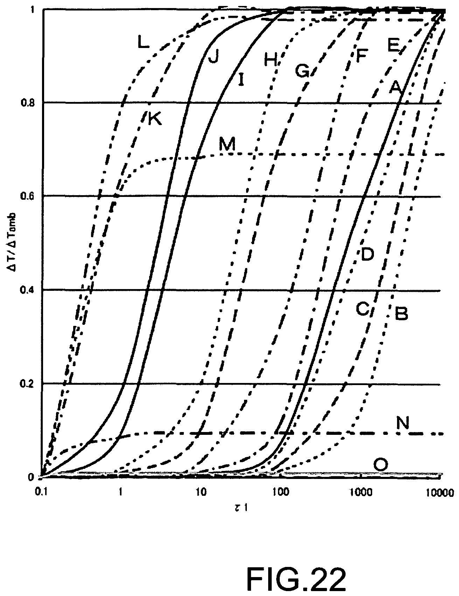

Fig. 22 shows the results of simulation of the obtained value $\Delta T$ depending on the value $\tau_1$ where $\tau_2$ is a constant (=0.1), and $\omega$ is variously changed as a parameter. Note that the value $\Delta T$ is standardized such that the maximum value is "1". Note that the symbols "A" to "O" of Fig. 22 shows the cycle TM of the following temperature change.

According to the inventions of the fourth-A mode, the fourth-B mode, the fifth-A mode, and the fifth-B mode, the layout of the first thermoelectric conversion elements and the second thermoelectric conversion elements is essentially an arbitrary layout, and the examples include: a layout in which the first thermoelectric conversion elements and the second thermoelectric conversion elements are arranged alternately in one row; a layout in which groups each including the plurality of first thermoelectric conversion elements and groups each including the plurality of second thermoelectric conversion elements are arranged alternately in one row; a layout in which the first thermoelectric conversion elements are arranged in one row, and the second thermoelectric conversion elements are arranged in the adjacent row; a layout in which the first thermoelectric conversion elements are arranged in a plurality of rows, and the second thermoelectric conversion elements are arranged in the plurality of adjacent rows; and a layout in which a thermoelectric generation device is divided into a plurality of areas, and the plurality of first thermoelectric conversion elements or the plurality of second thermoelectric conversion elements are arranged in each area.

According to the thermoelectric generation devices of the present invention, a material of the thermoelectric conversion member may be a known material, and may be, for example, a bismuth tellurium series material (specifically, for example, $Bi_2Te_3$, $Bi_2Te_{2.85}Se_{0.15}$), a bismuth tellurium antimony series material, an antimony tellurium series material (specifically, for example, $Sb_2Te_3$), a thallium tellurium series material, a bismuth selenium series material (specifically, for example, $Bi_2Se_3$), a lead tellurium series material, a tin tellurium series material, a germanium tellurium series material, a $Pb_{1-x}Sn_xTe$ compound, a bismuth antimony series material, a zinc antimony series material (specifically, for example, $Zn_4Sb_3$), a cobalt antimony series material (specifically, for example, $CoSb_3$), an iron cobalt antimony series material, a silver antimony tellurium series material (specifically, for example, $AgSbTe_2$), a TAGS (Telluride of Antimony, Germanium and Silver) compound, a Si-Ge series material, a silicide series material [a Fe-Si series material (specifically, for example, $\beta$-$FeSi_2$), a Mn-Si series material (specifically, for example, $MnSi_2$), a Cr-Si series material (specifically, for example, $CrSi_2$), a Mg-Si series material (specifically, for example, $Mg_2Si$)], a skutterudite series material [a $MX_3$ compound (where M is Co, Rh, Ir, and X is P, As, Sb), or a $RM'_4X_{12}$ compound (where R is La, Ce, Eu, Yb, etc., and M' is Fe, Ru, Os)], a boron compound [specifically, for example, $MB_6$ (where M is an alkali earth metal of Ca, Sr, Ba, and a rare-earth metal such as Y)], a Si series material, a Ge series material, a clathrate compound, a Heusler compound, a half-Heusler compound, a rare-earth-based Kondo semiconductor material, a a transition metal oxide series material (specifically, for example, $Na_xCoO_2$, $NaCo_2O_4$, $Ca_3Co_4O_9$), a zinc oxide series material, a titanium oxide series material, a cobalt oxide series material, $SrTiO_3$, an organic thermoelectric conversion material (specifically, for example, polythiophene, polyaniline), a chromel alloy, constantan, an alumel alloy, TGS (Triglycine Sulfate), $PbTiO_3$, $Sr_{0.5}Ba_{0.5}Nb_2O_6$, PZT, a $BaO$-$TiO_2$ series compound, tungsten bronze ($A_xBO_3$), a 15 perovskite series material, a 24-series perovskite series material, $BiFeO_3$, and a Bi layer perovskite series material. The material of the thermoelectric conversion member may be non-stoichiometric composition. Further, out of all the materials, it is preferable to use a bismuth tellurium series material and a bismuth tellurium antimony series material in combination. More specifically, for example, it is preferable that the first thermoelectric conversion member, the third thermoelectric conversion member, the first-A thermoelectric conversion member, the second-A thermoelectric conversion member, the third-A thermoelectric conversion member, and the fourth-A thermoelectric conversion member be made from bismuth tellurium antimony series materials, and the second thermoelectric conversion member, the fourth thermoelectric conversion member, the first-B thermoelectric conversion member, the second-B thermoelectric conversion member, the third-B thermoelectric conversion member, and the fourth-B thermoelectric conversion member be made from bismuth tellurium series materials. Note that, in this case, the first thermoelectric conversion member, the third thermoelectric conversion member, the first-A thermoelectric conversion member, the second-A thermoelectric conversion member, the third-A thermoelectric conversion member, and the fourth-A thermoelectric conversion member function as p-type semiconductors, and the second thermoelectric conversion member, the fourth thermoelectric conversion member, the first-B thermoelectric conversion member, the second-B thermoelectric conversion member, the third-B thermoelectric conversion member, and the fourth-B thermoelectric conversion member function as n-type semiconductors. Both the material of the first thermoelectric conversion member and the material of the second thermoelectric conversion member may exhibit Seebeck effect, or only one of the materials may exhibit Seebeck effect. Similarly, both the material of the third thermoelectric conversion member and the material of the fourth thermoelectric conversion member may exhibit Seebeck effect, or one of the materials may exhibit Seebeck effect. The same applies to the combination of the first-A thermoelectric conversion member and the first-B thermoelectric conversion member, the combination of the second-A thermoelectric conversion member and the second-B thermoelectric conversion member, the combination of the third-A thermoelectric conversion member and the third-B thermoelectric conversion member, and the combination of the fourth-A thermoelectric conversion member and the fourth-B thermoelectric conversion member.

Examples of a method of manufacturing the thermoelectric conversion member or the thermoelectric conversion element and a method of shaping the thermoelectric conversion member or the thermoelectric conversion element to have a desired shape include a method of cutting an ingot of the material of the thermoelectric conversion member, a method of etching the material of the thermoelectric conversion member, a method of forming by using a mold, a plate processing method of forming a film, a combination of a PVD method or a CVD method and a patterning technology, and a liftoff method.

Examples of a material of the first support member and a material of the second support member include fluorine resin, epoxy resin, acrylic resin, polycarbonate resin, polypropylene resin, polystyrene resin, polyethylene resin, thermoset elastomer, thermoplastic elastomer (silicon rubber, ethylene rubber, propylene rubber, chloroprene rubber), a latent heat storage material such as for example normal paraffin, a chemical heat storage material, vulcanized rubber (natural rubber), glass, ceramics (for example, $Al_2O_3$, MgO, BeO, AlN, SiC, $TiO_2$, a pottery, a porcelain), a carbon series material such as diamond like carbon (DLC) or graphite, wood, various kinds of metal [for example, copper (Cu), aluminum (Al), silver (Ag), gold (Au), chrome (Cr), iron (Fe), magnesium (Mg), nickel (Ni), silicon (Si), tin (Sn), tantalum (Ta), titanium (Ti), tungsten (W), antimony (Sb), bismuth (Bi), tellurium (Te), selenium (Se)], alloys of those metals, copper nanoparticles, and the like. Those materials may be appropriately selected and used in combination to thereby obtain the first support member and the second support member. For example, a fin or a heat sink may be mounted on the outer surface of the first support member or the second support member, or the outer surface of the first support member or the second support member may be a rough surface or patterned, whereby heat exchange efficiency may be increased.

A latent heat storage material stores latent heat, which is exchanged with the exterior in a case of phase transition or displacement of a material, as a heat energy. Phase transition of the normal paraffin (for example, n-tetradecane, n-pentadecane, n-hexadecane, n-heptadecane, n-octadecane, n-nonadecane, n-icosane, etc.) is generated depending on the composition even if it is in the room temperature atmosphere. Such a latent heat storage material as a heat storage material is used for the first support member, the second support member, a part of the first support member, or a part of the second support member, whereby a structure having a larger heat capacity and a smaller volume may be realized. As a result, the thermoelectric conversion element of the thermoelectric generation device may be smaller in size and in height. Further, the temperature hardly changes, whereby the material may be used as a material of a thermoelectric conversion element, which detects temperature fluctuation for a long period of time. For example, while melting heat of epoxy resin is 2.2 J/kg, melting heat of normal paraffin, of which melting point is 25°C, is for example 85 kJ/kg. That is, normal paraffin is capable of storing heat about 40 times more than heat that epoxy resin stores. The chemical heat storage material uses heat of chemical reaction of a material, and may be, for example, $Ca(OH)_2/CaO_2+H_2$, $Na_2S+5H_2O$, or the like.

The support member may include an electrode to electrically connect, in series, the first thermoelectric conversion member and the second thermoelectric conversion member, the third thermoelectric conversion member and the fourth thermoelectric conversion member, the first thermoelectric conversion element and the second thermoelectric conversion element, and the third thermoelectric conversion element and the fourth thermoelectric conversion element. However, the electrode may not necessarily be provided. An arbitrary material having a conductive property may essentially be used for the electrode, and for example, an electrode structure in which a titanium layer, a gold layer, and a nickel layer are layered from the thermoelectric conversion member side or the thermoelectric conversion element side. It is preferable that a part of the electrode also function as an output unit, from the viewpoints of the structure of the thermoelectric generation device and a simple structure. In some cases, an elongated portion of the thermoelectric conversion member or the thermoelectric conversion element may structure an electrode.

The thermoelectric generation device may be sealed with an appropriate resin, for example. The first support member or the second support member may include a heat storage means. A gap between the thermoelectric conversion member and the thermoelectric conversion member or a gap between the thermoelectric conversion element and the thermoelectric conversion element may be a gap as it is, or may be filled with an insulation material.

The thermoelectric generation devices of the present invention may be applied to any technical field in which thermoelectricity is generated in an atmosphere in which the temperature changes. Specifically, the technical field or a suitable device, in which the thermoelectric generation device of the present invention is incorporated, may be, for example, a sensor network system. The thermoelectric generation device may collectively supply electric power to electronic devices, sensors, and electronic components in the sensor network system. Specifically, the thermoelectric generation device is useful as an auxiliary power source for a device having a self power generation function such as an energy harvesting device, and is useful to assist behaviors of the device. Further, by only adding a frequency control function of temperature change to an existing temperature control device, as an energy transmission side, a system may be constructed. As a result, it is possible to reduce investment in new facilities. Further, in a case where a plurality of sensors and devices are arranged in a sensor network system or the like, there may be constructed a system capable of collectively calibrating all the sensors and devices or a part of sensors and devices, not calibrating sensors and devices one by one. That is, the present invention is capable of not only supplying electric power and generating electric power indirectly and collectively, but also calibrating sensors and devices collectively. Further, the present invention may be applied to, for example, a method of determining a location of a specific article (for example, the present invention is applied to a technology of mounting the device of the present invention on a key, a mobile phone, and the like, and of easily detecting them. A system of intermittently transmitting the location information is constructed).

More specifically, the present invention may be applied to, for example, book management using electronic tags (IC tags, kind of RFID), and electronic tags attached to a plurality of books may be indirectly activated at one time or sequentially based on wireless electric power transmission. Further, it is possible to collectively supply electric power to electronic devices in a WSN (Wireless Sensor Network) or a BAN (Body Area Network), and activate the electronic devices at one time or sequentially. Further, it is possible to supply electric power to a circuit including an IC of electronic money such as Suica or Felica, for example.

Alternatively, the thermoelectric generation devices of the present invention may be applied to: remote control devices for controlling various devices such as a television receiver, a recorder device, an air conditioning device, an electronic book terminal, a game machine, and a navigation system; various measuring devices (for example, measuring device for monitoring status of soil, and measuring device for monitoring weather and meteorological phenomena); a remote monitoring device and a remote sensing device in a remote place; a mobile communication device; a clock; a measuring device for obtaining biological information of bodies, animals, livestock, and pets such as body temperature, blood pressure, and pulse, and an device of detecting/extracting various information based on the biological information; a power source for charging a secondary battery; a power generation device using exhaust heat of an automobile; a battery-less wireless system; a sensor node or a wireless sensor network; a tire pressure monitoring system (TPMS); a remote control device and a switch for controlling an illumination device; a system for synchronizing temperature information, as an input signal or as an input signal and an energy source, and an input signal; and a mobile music reproduction device, a hearing aid, and a noise cancelling system for a mobile music reproduction device. Further, the thermoelectric generation devices of the present invention are preferably applied to a place in which it is difficult to arrange the power generation device or a place in which it is difficult to physically provide wirings or wire connection after the power generation device is once installed. Further, the thermoelectric generation devices of the present invention as electric signal detecting devices are mounted on a machine or a building, and the temperature of the machine or the building is changed periodically, whereby it is possible to detect occurrence of abnormalities.

Examples of the temperature control device includes an air conditioner, a heating wire, a Peltier device, a compressor, a burning appliances, and the like, and combinations thereof.

Example 1

Example 1 relates to the wireless power supply device and the wireless power supply method of the present invention, and specifically relates to the first structure of the present invention. Here, "wireless power supply" means to supply electric power without a wire, and does not mean to supply electric power via a radio wave.

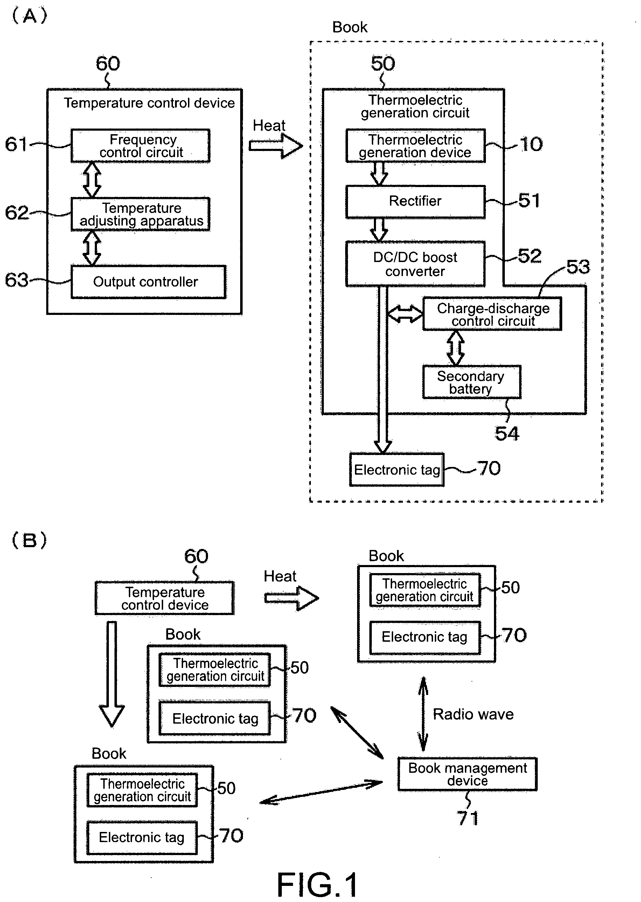

As shown in the conceptual diagram of (A) of Fig. 1, the wireless power supply device of Example 1 includes:

(A) a thermoelectric generation device 10 configured to generate thermoelectricity in response to temperature change of an atmosphere; and
(B) a temperature control device 60 configured to periodically change the temperature of an atmosphere, the thermoelectric generation device 10 being arranged in the atmosphere.

Further, the wireless power supply method of Example 1 is a wireless power supply method using a wireless power supply device, the wireless power supply device including the thermoelectric generation device 10 and the temperature control device 60, the wireless power supply method including:

periodically changing, by the temperature control device 60, the temperature of an atmosphere, the thermoelectric generation device 10 being arranged in the atmosphere; generating, by the thermoelectric generation device 10, thermoelectricity in response to temperature change of the atmosphere; and bringing the obtained electric power to the exterior.

Note that the thermoelectric generation device will be described in detail in Example 4 to Example 13.

Further, in Example 1, the wireless power supply device includes the plurality of thermoelectric generation devices 10, and thermal response characteristics of the thermoelectric generation devices 10 are the same. The plurality of thermoelectric generation devices 10 are capable of responding to periodic change of atmospheric temperature due to the temperature control device 60 together, and the plurality of thermoelectric generation devices 10 are capable of bringing electric power of the same characteristics to the exterior collectively.

In Example 1, as shown in the conceptual diagram of a book management system of (B) of Fig. 1, the thermoelectric generation device 10 is connected to an electronic tag (IC tag, kind of RFID) 70, and the electronic tag 70 manages a book. Specifically, the book management system causes the electronic tags 70, which are attached to a plurality of books, to indirectly activate at one time based on wireless electric power transmission.

In the thermoelectric generation device having the structure of Example 6 (described later), a first support member 11 is made of an aluminum plate (height x width x thickness: 10 mm x 10 mm x 0.1 mm), a second support member 12 is made of a rubber plate (height x width x thickness: 10 mm x 10 mm x 1.0 mm), a first thermoelectric conversion element 121C is made from bismuth tellurium antimony, a second thermoelectric conversion element 122C is made from bismuth tellurium, the size of the entire layered body including the first thermoelectric conversion element 121C and the second thermoelectric conversion element 122C is height x width x thickness = 0.1 mm x 0.1 mm x 1 mm, 625 layered bodies each including the first thermoelectric conversion element 121C and the second thermoelectric conversion element 122C are connected in series, and the amount of voltage and the amount of current obtained from the thermoelectric generation device are simulated. The following Table 1 shows the results. Note that the amplitude ($\Delta T_{amb}$) of temperature change is 2°C.

**EP 2 680 430 B1**

[Table 1]

| Cycle ($t_0$) | Voltage | Current |
|---|---|---|
| 0.1 seconds | 100 $\mu$V | 10 nA |
| 0.5 seconds | 0.35 mV | 150 nA |
| 1.0 seconds | 0.60 mV | 300 nA |
| 10 seconds | 5.0 mV | 3 $\mu$A |

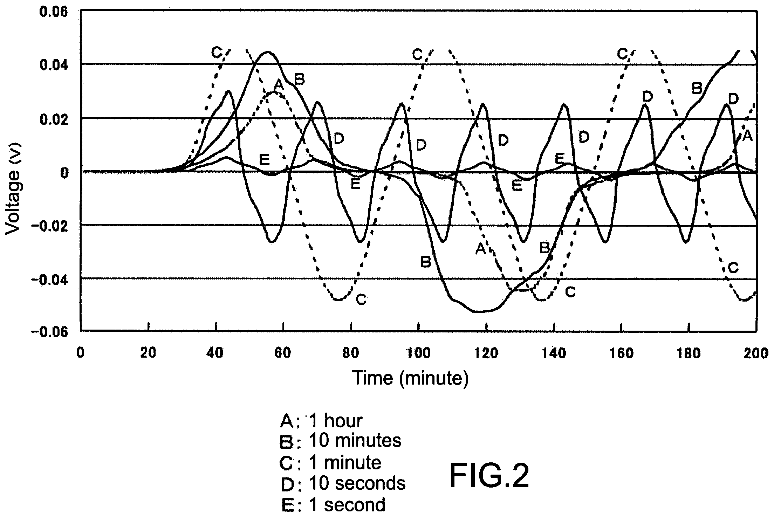

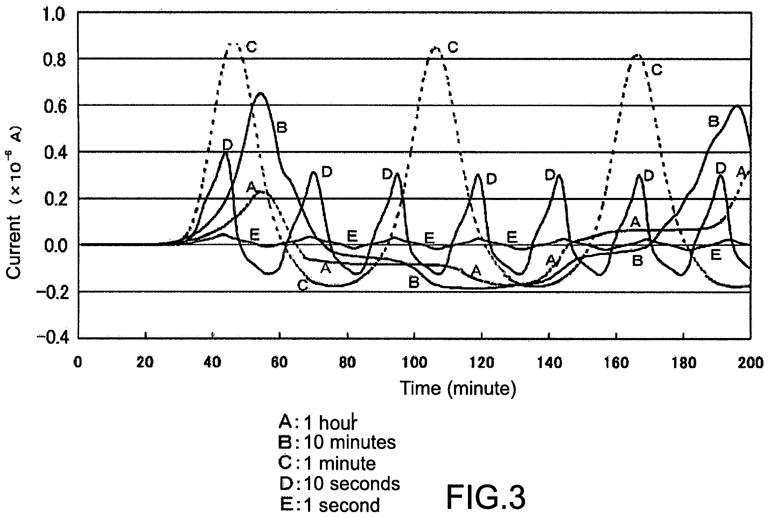

Further, in the above-mentioned thermoelectric generation device, the amplitude ($\Delta T_{amb}$) of temperature change is 2°C, the cycle ($t_0$) is a parameter, the output from the thermoelectric generation device is voltage doubler rectified, and the amount of voltage and the amount of current obtained from an external load, of which impedance matches with the impedance of the thermoelectric generation device, are simulated. Fig. 2 and Fig. 3 show the results. Note that, in each of Fig. 2 and Fig. 3, the curve "A" shows the case of $t_0$=1 hour, the curve "B" shows the case of $t_0$=10 minutes, the curve "C" shows the case of $t_0$=1 minute, the curve "D" shows the case of $t_0$=10 seconds, the curve "E" shows the case of $t_0$=1 second, and the horizontal axis (time) means an elapsed time.

In Example 1, specifically, the temperature control device 60 comprises an air conditioner, which is configured to cause an intended change of temperature to an atmosphere, i.e., for example, temperature change of the amplitude ($\Delta T_{amb}$) 2°C at the cycle ($t_0$) of 10 minutes, or temperature change of the amplitude ($\Delta T_{amb}$) 2°C at the cycle ($t_0$) of 100 minutes. The temperature control device 60 includes, for example, a frequency control circuit 61, a temperature adjusting device 62, and an output controller 63.

More specifically, for example, as described above, the temperature control device 60 comprising an air conditioner changes the atmospheric temperature of a room in which books are stored at night. As a result, each thermoelectric generation device 10 generates electric power of, for example, 4 millivolts and 0.4 microamperes, or 20 millivolts and 0.25 microamperes. A thermoelectric generation circuit 50 includes the thermoelectric generation device 10, a rectifier 51, a DC/DC boost converter 52, a charge-discharge control circuit 53, and a secondary battery 54. Electricity obtained by the thermoelectric generation device 10 is brought to the exterior (to the exterior of the thermoelectric generation device 10). That is, the rectifier 51 rectifies voltage from the thermoelectric generation device 10, the DC/DC boost converter 52 boosts to a desired voltage, and the charge-discharge control circuit 53 charges the secondary battery 54. Further, the electronic tag 70 is driven by electric power output from the thermoelectric generation circuit 50. Note that the thermoelectric generation devices 10 may be stacked in parallel or in series, and pressure may be boosted and current may be amplified appropriately.

In response to a request from a book management device 71, the electronic tag 70 transmits information (in other words, information unique to book on which the electronic tag 70 is attached) unique to the electronic tag 70 to the book management device 71 via a radio wave. The book management device 71 confirms that there is a book, on which the electronic tag 70 is attached, based on the received information unique to the electronic tag 70. The book management device 71 performs the confirmation of all the books, for example. If the book management device 71 does not receive information unique to the electronic tag 70 attached to a book, which is supposed to exist, after a predetermined time period passes, the book management device 71 alerts that the book is lost, whereby a person who manages books is capable of recognizing that the book is lost. Note that, for example, the charge amount of the secondary battery 54 is about a charge amount, which is enough to complete the above-mentioned behavior and is not enough to drive the electronic tag 70 after the above-mentioned behavior is completed.

According to the wireless power supply device or the wireless power supply method of Example 1, instead of supplying electric power via a radio wave, the temperature control device periodically changes the temperature of an atmosphere in which the thermoelectric generation device is arranged, whereby the thermoelectric generation device generates thermoelectricity. Further, the energy waveform of the energy transmission side (i.e., pattern and cycle of periodic change of atmospheric temperature changed by temperature control device) is set to a pattern and a cycle, with which the thermoelectric generation device as a receiver side generates thermoelectricity efficiently, that is, various parameters of the thermoelectric generation device are designed so as to be capable of generating thermoelectricity efficiently, whereby it is possible to generate electric power efficiently. The thermoelectric generation device receives energy (i.e., heat), which is necessary to generate electric power, and generates electric power. That is, it is possible to transmit electric power indirectly. Because of this, a point of use is not restricted, that is, it is possible to supply electric power in an atmosphere or a scene in which a radio wave may not be used, in a space to which a radio wave is hardly transmitted, or in an electromagnetic shielded space, without directionality, easily, safely, and with a simple structure, and other electronic device may not be affected. Further, thermoelectricity is generated based on an atmosphere in which the thermoelectric generation device is arranged or based on temperature change or temperature fluctuation in an atmosphere, whereby remote monitoring, remote sensing, and the like from a remote place are enabled, and it is possible to previously mount a power generation device in a place in which it is difficult to arrange a power generation device or a place in which it is difficult to physically provide wirings or wire connection after a power generation device

16

is once installed. Further, it is possible to increase the degree of freedom of design and layout of a power generation device.

Example 2

Example 2 is a modification of Example 1, and specifically relates to the second structure of the present invention. According to Example 2, the wireless power supply device includes a plurality of thermoelectric generation devices 10, thermal response characteristics of the thermoelectric generation devices 10 being different from each other. Further, the temperature control device 60 is configured to periodically change the temperature of an atmosphere in sequence based on temperature change corresponding to thermoelectric generation devices 10, thermal response characteristics of the thermoelectric generation devices 10 being different from each other. The plurality of thermoelectric generation devices 10 (or thermoelectric generation device groups having the same thermal response characteristics) are capable of responding to periodic change of the atmospheric temperature of the temperature control device 60 temporally and individually, and the plurality of thermoelectric generation devices 10 or specific thermoelectric generation devices 10 are capable of bringing electric power having different characteristics to the exterior temporally and separately.

Also in Example 2, the thermoelectric generation device 10 is connected to the electronic tag 70, and books are managed by using the electronic tags 70. Specifically, the electronic tags 70 attached to the plurality of books are indirectly activated in sequence based on wireless electric power transmission.

In Example 2, the temperature control device 60 being an air conditioner changes the temperature of an atmosphere preferably, i.e., for example, temperature change of the amplitude ($\Delta T_{amb}$) 2°C at the cycle ($t_0$) of 10 minutes (for convenience, referred to as "temperature change-1"), and next, temperature change of the amplitude ($\Delta T_{amb}$) 2°C at the cycle ($t_0$) of 600 seconds (for convenience, referred to as "temperature change-2"). Note that some thermoelectric generation devices out of the plurality of thermoelectric generation devices are designed such that they generate thermoelectricity under the temperature change-1, and do not generate thermoelectricity under the temperature change-2. Further, the other thermoelectric generation devices out of the plurality of thermoelectric generation devices are designed such that they generate thermoelectricity under the temperature change-2, and do not generate thermoelectricity under the temperature change-1. The same applies to Example 3 -(described later).

More specifically, for example, as described above, the temperature control device 60 being an air conditioner changes the atmospheric temperature of a room in which books are stored at night. As a result, under the temperature change-1, some of the plurality of thermoelectric generation devices (for convenience, referred to as "thermoelectric generation device group-1") generate current of 9 millivolts and 0.3 microamperes. Under the temperature change-1, the other of the plurality of thermoelectric generation devices (for convenience, referred to as "thermoelectric generation device group-2") do not generate electric power. As a result, the electronic tag 70, on which the thermoelectric generation device group-1 is mounted, is driven, and the electronic tag 70, on which the thermoelectric generation device group-2 is mounted, is not driven. Meanwhile, under the temperature change-2, the thermoelectric generation device group-2 generates current of 7 millivolts and 0.25 microamperes. Under the temperature change-2, the thermoelectric generation device group-1 does not generate electric power. As a result, the electronic tag 70, on which the thermoelectric generation device group-2 is mounted, is driven, and the electronic tag 70, on which the thermoelectric generation device group-1 is mounted, is not driven. In this manner, it is possible to manage books separately between the group of books on each of which the thermoelectric generation device group-1 is mounted and the group of books on each of which the thermoelectric generation device group-2 is mounted. Note that the thermoelectric generation devices may be stacked in parallel or in series, and pressure may be boosted and current may be amplified appropriately.

Example 3

Example 3 is also a modification of Example 1, and specifically relates to the third structure of the present invention. In Example 3, the wireless power supply device includes a plurality of thermoelectric generation devices 10, thermal response characteristics of the thermoelectric generation devices 10 are different from each other, and the temperature control device 60 is configured to periodically change temperature of an atmosphere in sequence based on synthesized temperature change corresponding to thermoelectric generation devices 10, thermal response characteristics of the thermoelectric generation devices 10 being different from each other. The plurality of thermoelectric generation devices 10 (or thermoelectric generation device groups having the same thermal response characteristics) are capable of responding to periodic change of the atmospheric temperature of the temperature control device 60 temporally and individually, and the plurality of thermoelectric generation devices 10 are capable of bringing electric power having different characteristics to the exterior temporally and separately.

Also in Example 3, the thermoelectric generation device 10 is connected to the electronic tag 70, and books are managed by using the electronic tags 70. Specifically, the electronic tags 70 attached to the plurality of books are indirectly activated in sequence based on wireless electric power transmission.

In Example 3, the temperature control device 60 being an air conditioner changes the temperature of an atmosphere preferably, i.e., for example, the temperature change-1 of the amplitude ($\Delta T_{amb}$) 2°C at the cycle ($t_0$) of 10 minutes, and simultaneously, the temperature change-2 of the amplitude ($\Delta T_{amb}$) 2°C at the cycle ($t_0$) of 600 seconds. That is, actually, temperature change, which is obtained by synthesizing the temperature change-1 and the temperature change-2, is generated.

More specifically, for example, as described above, the temperature control device 60 being an air conditioner changes the atmospheric temperature of a room in which books are stored at night. As a result, under the temperature change-1, the thermoelectric generation device group-1 generates current of 8 millivolts and 0.1 microamperes, and the electronic tag 70 on which the thermoelectric generation device group-1 is mounted is driven. Simultaneously, under the temperature change-2, the thermoelectric generation device group-2 generates current of 3 millivolts and 0.1 microamperes, and the electronic tag 70 on which the thermoelectric generation device group-2 is mounted is driven. In this manner, it is possible to manage books separately between the group of books on each of which the thermoelectric generation device group-1 is mounted and the group of books on each of which the thermoelectric generation device group-2 is mounted. Note that the thermoelectric generation devices 10 may be stacked in parallel or in series, and pressure may be boosted and current may be amplified appropriately.

Example 4

Meanwhile, according to a thermoelectric generation device in the past, the temperature of a heat receiving portion should be different from the temperature of a heat releasing portion. Therefore, for example, if heat from the heat receiving portion flows in the heat releasing portion because of heat conduction of a thermoelectric conversion element, and if the difference between the temperature of the heat receiving portion and the temperature of the heat releasing portion is lost, it is not possible to generate thermoelectricity. Further, if heat does not originally flow from a heat source to the heat receiving portion, it is not possible to generate thermoelectricity. Because of this, if an existing thermoelectric generation device is left in, for example, a normal living environment, that is, if a thermoelectric generation device is left in, for example, a room, it is difficult to generate thermoelectricity. Further, a status where an existing thermoelectric generation device is capable of always generating thermoelectricity is restricted, and specifically, it is difficult to always generate thermoelectricity under a normal temperature. Further, normally, a sensing device needs energy, and in general, a battery or a commercial power source supplies the energy. Because of this, a battery is replaced or charged, and the battery or the commercial power source may not be used if a wire is connected, which are problematic. Further, some thermoelectric generation device includes power generation devices, which generate electric power due to body temperature, but it is necessary to provide a sensing device and a power generation device separately, whereby the size of the device may be large or the device may be complicated.

Hereinafter, various thermoelectric generation devices and thermoelectric generation methods will be described specifically. As described above, the thermoelectric generation devices are capable of generating thermoelectricity even if there is no heat source.

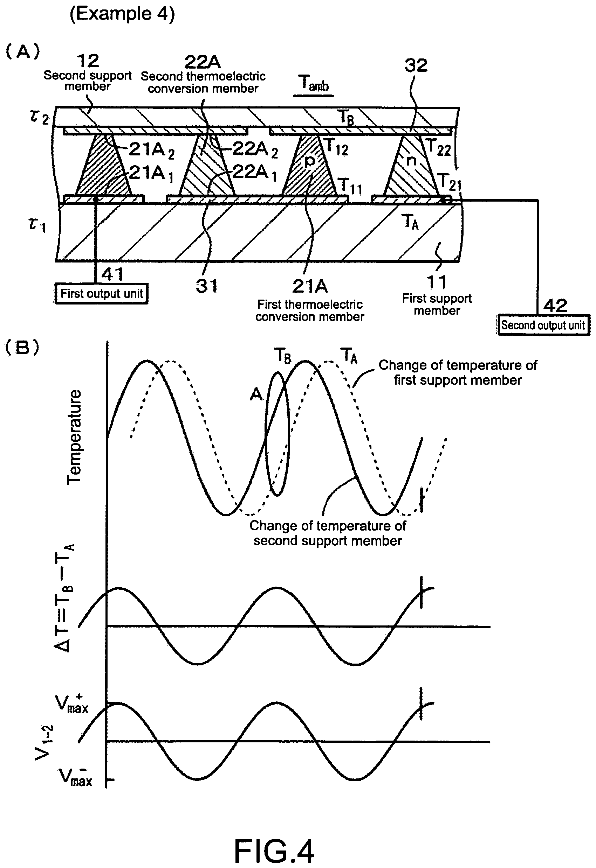

Example 4 relates to the thermoelectric generation device of the first mode and the thermoelectric generation method of the first mode. (A) of Fig. 4 shows a schematic partial sectional view showing the thermoelectric generation device of Example 4, and (B) of Fig. 4 schematically shows the temperature ($T_A$) of a first support member, the temperature ($T_B$) of a second support member, the change of the temperature difference ($\Delta T = T_B - T_A$) between those temperatures, and the change of the voltage $V_{1-2}$ between the first output unit and the second output unit. Note that the diagrams for explaining examples show four or eight thermoelectric conversion elements and four or eight thermoelectric conversion members, but the number of the thermoelectric conversion elements and the number of the thermoelectric conversion members are not limited to them.

According to Example 4 or Example 5 (described later), the thermoelectric generation device includes

(A) a first support member 11,
(B) a second support member 12 facing the first support member 11,
(C) a thermoelectric conversion element arranged between the first support member 11 and the second support member 12, and
(D) a first output unit 41 and a second output unit 42 connected to the thermoelectric conversion element.

Further, according to Example 4 or Example 5 (described later), the thermoelectric conversion element includes

(C-1) a first thermoelectric conversion member 21A, 21B arranged between the first support member 11 and the second support member 12, and
(C-2) a second thermoelectric conversion member 22A, 22B arranged between the first support member 11 and the second support member 12, a material of the second thermoelectric conversion member 22A, 22B being different from a material of the first thermoelectric conversion member 21A, 21B, the second thermoelectric conversion member 22A, 22B being electrically connected to the first thermoelectric conversion member 21A, 21B in series.

Further, according to the thermoelectric generation device of Example 4 or Example 5 (described later), more specifically, the first thermoelectric conversion member 21A, 21B is electrically connected to the second thermoelectric conversion member 22A, 22B in series via a wiring 32 provided on the second support member 12, and further, the second thermoelectric conversion member 22A, 22B is electrically connected to the first thermoelectric conversion member 21A, 21B in series via a wiring 31 provided on the first support member 11. Further, a first output unit 41 is connected to an end of the first thermoelectric conversion member 21A, 21B at the first support member side, and a second output unit 42 is connected to an end of the second thermoelectric conversion member 22A, 22B at the first support member side.

Here, the first support member 11 is made from $Al_2O_3$, and the second support member 12 is made from epoxy resin. The first thermoelectric conversion member, and the third thermoelectric conversion member, the first-A thermoelectric conversion member, the second-A thermoelectric conversion member, the third-A thermoelectric conversion member, and the fourth-A thermoelectric conversion member (described later) are made from p-type bismuth tellurium antimony, and the second thermoelectric conversion member, and the fourth thermoelectric conversion member, the first-B thermoelectric conversion member, the second-B thermoelectric conversion member, the third-B thermoelectric conversion member, and the fourth-B thermoelectric conversion member (described later) are made from n-type bismuth tellurium. The first output unit 41, the second output unit 42, the wiring 31, or a wiring 32 has a multilayer structure including a titanium layer, a gold layer, and a nickel layer from the support member side. The thermoelectric conversion member may be bonded to the wiring by means of a known bonding technology. Further, Seebeck coefficient of the first thermoelectric conversion member and the first thermoelectric conversion element is $SB_1$, Seebeck coefficient of the second thermoelectric conversion member and the second thermoelectric conversion element is $SB_2$, Seebeck coefficient of the third thermoelectric conversion member and the third thermoelectric conversion element is $SB_3$, and Seebeck coefficient of the fourth thermoelectric conversion member and the fourth thermoelectric conversion element is $SB_4$. The same applies to Example 5 to Example 13 (described later).

Further, according to the thermoelectric generation device of Example 4, $\tau_{SM1} > \tau_{SM2}$ is satisfied where the area of a first surface $21A_1$ of the first thermoelectric conversion member 21A is $S_{11}$, the first surface $21A_1$ being on the first support member 11, the area of a second surface $21A_2$ of the first thermoelectric conversion member 21A is $S_{12}$ (where $S_{11} > S_{12}$), the second surface $21A_2$ being on the second support member 12, the area of a first surface $22A_1$ of the second thermoelectric conversion member 22A is $S_{21}$, the first surface $22A_1$ being on the first support member 11, the area of a second surface $22A_2$ of the second thermoelectric conversion member 22A is $S_{22}$ (where $S_{21} > S_{22}$), the second surface $22A_2$ being on the second support member 12, a constant in thermal response of the first support member 11 is $\tau_{SM1}$, and a constant in thermal response of the second support member 12 is $\tau_{SM2}$.

Further, in Example 4, $S_{12} \neq S_{22}$ is satisfied.

Note that the first thermoelectric conversion member 21A or the second thermoelectric conversion member 22A is a truncated pyramid/cone, more specifically, a truncated square pyramid.

According to Example 4 or Example 5 (described later), the wireless power supply method includes: arranging the thermoelectric generation device in an atmosphere, the atmospheric temperature changing; and bringing current to the exterior, the current being generated due to temperature difference between the first support member 11 and the second support member 12 when the temperature of the second support member 12 is higher than the temperature of the first support member 11, the current flowing from the second thermoelectric conversion member 22A, 22B to the first thermoelectric conversion member 21A, 21B, the first output unit 41 being a positive electrode (+ electrode), the second output unit 42 being a negative electrode (- electrode). In this case, alternate current flows between the first output unit 41 and the second output unit 42, and a known half-wave rectifier circuit may convert the alternate current into direct current, and may further smooth the current. Note that current may be brought to the exterior, the current being generated due to temperature difference between the first support member 11 and the second support member 12 when the temperature of the first support member 11 is higher than the temperature of the second support member 12, the current flowing from the first thermoelectric conversion member 21A, 21B to the second thermoelectric conversion member 22A, 22B, the second output unit 42 being a positive electrode, the first output unit 41 being a negative electrode. Further, in this case, a known full-wave rectifier circuit may convert alternate current into direct current, and may further smooth the current.

Here, because $\tau_{SM1} > \tau_{SM2}$ is satisfied, if the thermoelectric generation device is arranged in an atmosphere of which temperature changes (in (B) of Fig. 4, atmospheric temperature at time surrounded by ellipse "A" is $T_{amb}$), the temperature $T_B$ of the second support member 12 immediately reaches the atmospheric temperature $T_{amb}$ or the temperature in the vicinity thereof. Meanwhile, because $\tau_{SM1} > \tau_{SM2}$ is satisfied, the temperature $T_A$ of the first support member 11 changes after the temperature of the second support member 12 changes. Therefore, the temperature difference $\Delta T$ $(=T_B-T_A)$ is generated between the temperature $T_A$ ($<T_{amb}$) of the first support member 11 and the temperature $T_B$

(=$T_{amb}$) of the second support member 12.

$$T_{12}=T_{22}>T_{11}=T_{21}$$

is generally satisfied where the temperature in the vicinity of the first surface $21A_1$ of the first thermoelectric conversion member 21A on the first support member 11 is $T_{11}$, the temperature in the vicinity of the second surface $21A_2$ of the first thermoelectric conversion member 21A on the second support member 12 is $T_{12}$, the temperature in the vicinity of the first surface $22A_1$ of the second thermoelectric conversion member 22A on the first support member 11 is $T_{21}$, and the temperature in the vicinity of the second surface $22A_2$ of the second thermoelectric conversion member 22A on the second support member 12 is $T_{22}$. Further, an electromotive force EMF of one thermoelectric conversion element is obtained based on the following equation.

$$EMF=T_{12}xSB_1-T_{21}xSB_2$$

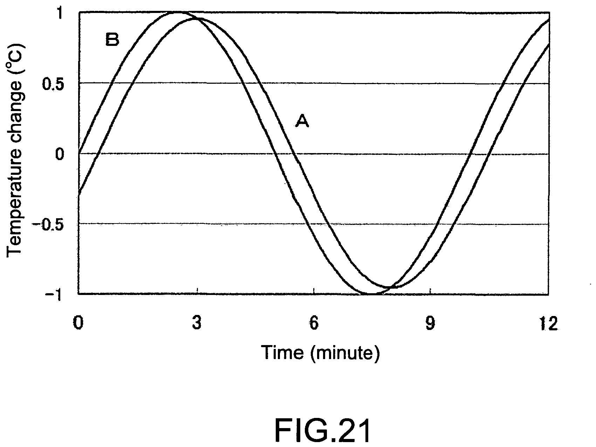

Let's say that the temperature change of an atmosphere is a sinusoidal wave, the difference $\Delta T_{amb}$ between the maximum temperature and the minimum temperature due to temperature change is 2°C, and the cycle (TM=$2\pi/\omega$) of temperature change is 10 minutes. Further, Fig. 21 shows the results of simulation of change of the temperature difference $\Delta T$ (=$T_B-T_A$) between the temperature $T_B$ of the second support member 12 and the temperature $T_A$ of the first support member 11 corresponding to the change of the temperature. Note that, in Fig. 21, the curve "B" shows the temperature change of the temperature $T_B$ of the second support member 12, and the curve "A" shows the temperature change of the temperature $T_A$ of the first support member 11.

As described above, according to the thermoelectric generation device of each of Example 4 and Example 5 to Example 13 (described later), the constant in thermal response $\tau_{SM1}$ of the first support member is different from the constant in thermal response $\tau_{SM2}$ of the second support member, whereby a temperature difference may be generated between the temperature of the first support member and the temperature of the second support member if the thermoelectric generation device is arranged in an atmosphere of which temperature changes. As a result, the thermoelectric conversion element, the first thermoelectric conversion element, or the second thermoelectric conversion element may generate thermoelectricity.

Example 5

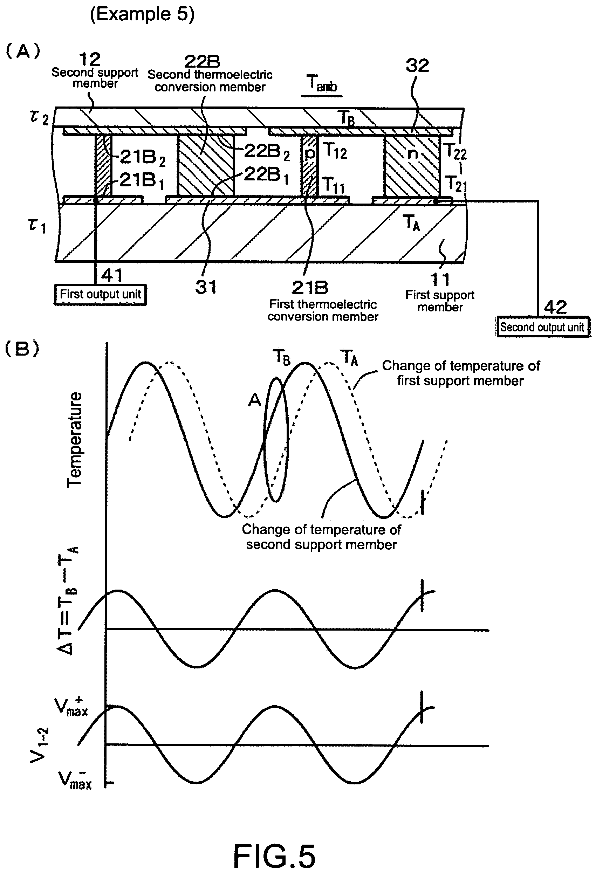

Example 5 relates to the thermoelectric generation device of the second mode and the thermoelectric generation method of the second mode. (A) of Fig. 5 shows a schematic partial sectional view showing the thermoelectric generation device of Example 5, and (B) of Fig. 5 schematically shows the temperature ($T_A$) of a first support member, the temperature ($T_B$) of a second support member, the change of the temperature difference ($\Delta T=T_B-T_A$) between those temperatures, and the change of the voltage $V_{1-2}$ between the first output unit and the second output unit.

Different from Example 4, in Example 5, the first thermoelectric conversion member 21B or the second thermoelectric conversion member 22B is a prism, more specifically, a rectangular prism. Further,

$\tau_{SM1} > \tau_{SM2}$ and

$VL_1 \neq VL_2$ are satisfied (note that, in Example 5, specifically, $VL_1<VL_2$)

where the volume of the first thermoelectric conversion member is $VL_1$, the volume of the second thermoelectric conversion member is $VL_2$, a constant in thermal response of the first support member is $\tau_{SM1}$, and a constant in thermal response of the second support member is $\tau_{SM2}$.

Here, because $\tau_{SM1}>\tau_{SM2}$ is satisfied, if the thermoelectric generation device is arranged in an atmosphere of which temperature changes (in (B) of Fig. 5, atmospheric temperature at time surrounded by ellipse "A" is $T_{amb}$), the temperature $T_B$ of the second support member 12 immediately reaches the atmospheric temperature $T_{amb}$ or the temperature in the vicinity thereof. Meanwhile, because $\tau_{SM1}>\tau_{SM2}$ is satisfied, the temperature $T_A$ of the first support member 11 changes after the temperature of the second support member 12 changes. Therefore, the temperature difference $\Delta T$ (=$T_B-T_A$) is generated between the temperature $T_A$ (<$T_{amb}$) of the first support member 11 and the temperature $T_B$ (=$T_{amb}$) of the second support member 12.

$T_{12}>T_{22}>T_{11}>T_{21}$ and

$T_{12}-T_{11}>T_{22}-T_{21}$ are satisfied

where the temperature in the vicinity of the first surface $21B_1$ of the first thermoelectric conversion member 21B on the first support member 11 is $T_{11}$, the temperature in the vicinity of the second surface $21B_2$ of the first thermoelectric conversion member 21B on the second support member 12 is $T_{12}$, the temperature in the vicinity of the first surface

$22B_1$ of the second thermoelectric conversion member 22B on the first support member 11 is $T_{21}$, the temperature in the vicinity of the second surface $22B_2$ of the second thermoelectric conversion member 22B on the second support member 12 is $T_{22}$, and $VL_1 < VL_2$ is satisfied. Further, an electromotive force EMF of one thermoelectric conversion element is obtained based on the following equation.

$$EMF = (T_{12} - T_{11}) \times SB_1 + (T_{21} - T_{22}) \times SB_2$$

The thermoelectric generation device having the structure of Example 5 is used, and electric power is extracted via a voltage doubler rectifier circuit and a boost circuit (Seiko Instruments Inc.: ultra-low voltage operation charge pump for step-up DC-DC converter startup IC S-882Z18). The thermoelectric generation device is installed in the following atmosphere of which temperature changes.
$\Delta T_{amb}$: about 4.5°C
Cycle TM of temperature change: 15 minutes
Air flows in the atmosphere at the wind speed about 1 m/second. In this atmosphere, voltage (750 millivolts at maximum) is obtained from the thermoelectric generation device.

Example 6

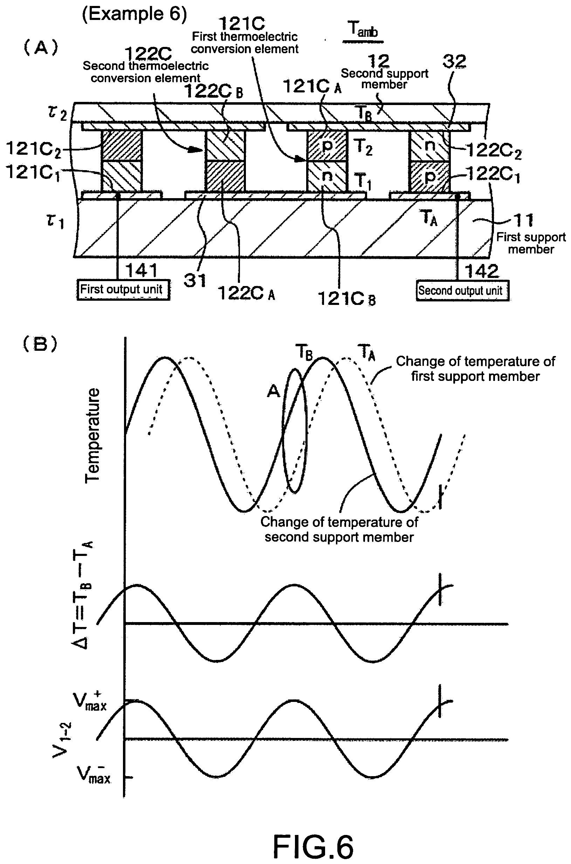

Example 6 relates to the thermoelectric generation device of the third mode and the thermoelectric generation method of the third mode. (A) of Fig. 6 shows a schematic partial sectional view showing the thermoelectric generation device of Example 6, and (B) of Fig. 6 schematically shows the temperature ($T_A$) of a first support member, the temperature ($T_B$) of a second support member, the change of the temperature difference ($\Delta T = T_B - T_A$) between those temperatures, and the change of the voltage $V_{1-2}$ between the first output unit and the second output unit.
According to Example 6, the thermoelectric generation device includes

(A) a first support member 11,
(B) a second support member 12 facing the first support member 11,
(C) a first thermoelectric conversion element 121C arranged between the first support member 11 and the second support member 12,
(D) a second thermoelectric conversion element 122C arranged between the first support member 11 and the second support member 12, and
(E) a first output unit 141 and a second output unit 142.

Further, in the thermoelectric generation device of Example 6, the first thermoelectric conversion element 121C includes a first-A thermoelectric conversion member $121C_A$ on the second support member 12, and a first-B thermoelectric conversion member $121C_B$ on the first support member 11, the first-A thermoelectric conversion member $121C_A$ being (specifically, layered) on the first-B thermoelectric conversion member $121C_B$. Further, the second thermoelectric conversion element 122C includes a second-A thermoelectric conversion member $122C_A$ on the first support member 11, and a second-B thermoelectric conversion member $122C_B$ on the second support member 12, the second-A thermoelectric conversion member $122C_A$ being (specifically, layered) on the second-B thermoelectric conversion member $122C_B$. Further, the first thermoelectric conversion element 121C is electrically connected to the second thermoelectric conversion element 122C in series. Further, the first output unit 141 is connected to an end of the first-B thermoelectric conversion member $121C_B$, and the second output unit 142 is connected to an end of the second-A thermoelectric conversion member $122C_A$. The first-A thermoelectric conversion member $121C_A$ is electrically connected to the second-B thermoelectric conversion member $122C_B$ via the wiring 32 provided on the second support member 12, and the second-A thermoelectric conversion member $122C_A$ is electrically connected to the first-B thermoelectric conversion member $121C_B$ via the wiring 31 provided on the first support member 11.
Further,
$\tau_{SM1} \# \tau_{SM2}$ is satisfied
where a constant in thermal response of the first support member 11 is $\tau_{SM1}$, and a constant in thermal response of the second support member 12 is $\tau_{SM2}$. The first thermoelectric conversion element 121C or the second thermoelectric conversion element 122C is a prism, more specifically, a rectangular prism.
The thermoelectric generation method of Example 6 includes arranging the thermoelectric generation device in an atmosphere, the atmospheric temperature changing. Further, current is brought to the exterior, the current being generated due to temperature difference between the first support member 11 and the second support member 12 when the temperature of the second support member 12 is higher than the temperature of the first support member 11, the current flowing from the second thermoelectric conversion element 122C to the first thermoelectric conversion element 121C, the first output unit 141 being a positive electrode, the second output unit 142 being a negative electrode. In this case, alternate current flows between the first output unit 141 and the second output unit 142, and a known half-wave rectifier circuit may convert the alternate current into direct current, and may further smooth the current. Note that current may be brought to the exterior, the current being generated due to temperature difference between the first support member 11 and the second support member 12 when the temperature of the first support member 11 is higher than the temperature of the second support member 12, the current flowing from the first thermoelectric conversion element 121C to the second thermoelectric conversion element 122C, the second output unit 142 being a positive electrode, the first output unit 141 being a negative electrode. In this case, a known full-wave rectifier circuit may convert alternate current into direct current, and may further smooth the current.

Here, if $\tau_{SM1}>\tau_{SM2}$ is satisfied, if the thermoelectric generation device is arranged in an atmosphere of which temperature changes (in (B) of Fig. 6, atmospheric temperature at time surrounded by ellipse "A" is $T_{amb}$), the temperature $T_B$ of the second support member 12 immediately reaches the atmospheric temperature $T_{amb}$ or the temperature in the vicinity thereof. Meanwhile, because $\tau_{SM1}>\tau_{SM2}$ is satisfied, the temperature $T_A$ of the first support member 11 changes after the temperature of the second support member 12 changes. Therefore, the temperature difference $\Delta T$ (=$T_B$-$T_A$) is generated between the temperature $T_A$ (<$T_{amb}$) of the first support member 11 and the temperature $T_B$ (=$T_{amb}$) of the second support member 12.

$T_2>T_1$ is satisfied

where the temperature in the vicinity of the second surface $121C_2$ of the first thermoelectric conversion element 121C and the second surface $122C_2$ of the second thermoelectric conversion element 122C, which are on the second support member 12, is $T_2$, and the temperature in the vicinity of the first surface $121C_1$ of the first thermoelectric conversion element 121C and the first surface $122C_1$ of the second thermoelectric conversion element 122C, which are on the first support member 11, is $T_1$. Further, an electromotive force EMF of the pair of thermoelectric conversion elements 121C, 122C is obtained by the following equation.

$$EMF=T_2 \times SB_1 - T_1 \times SB_2$$

Example 7

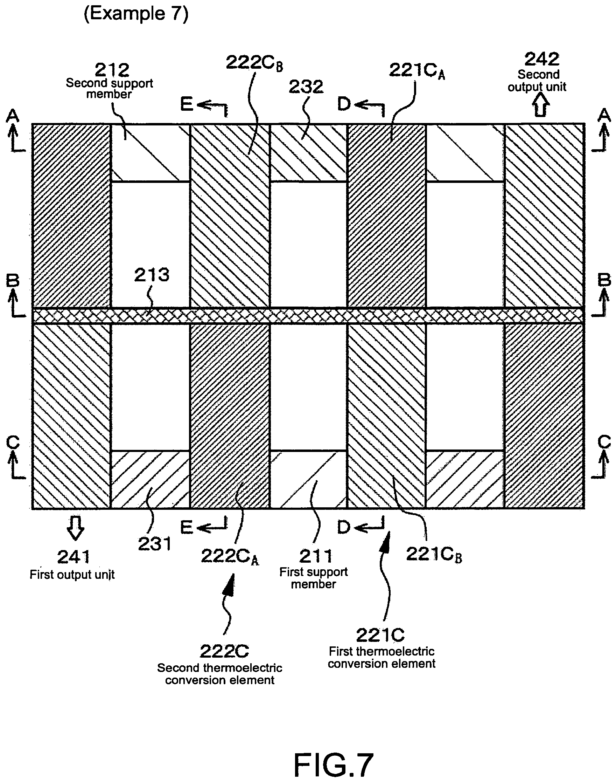

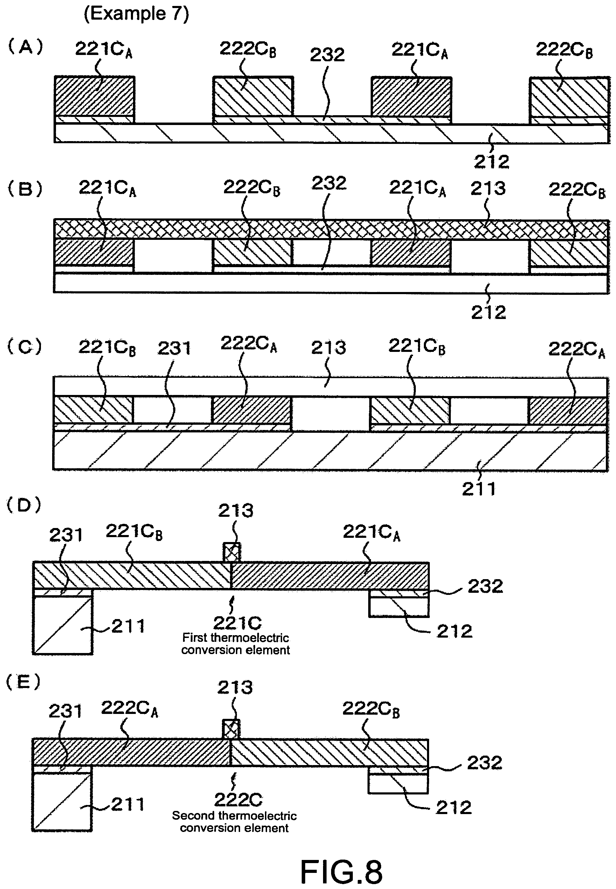

Example 7 is a modification of Example 6. In Example 6, the first thermoelectric conversion element 121C and the second thermoelectric conversion element 122C are layered. That is, the first-A thermoelectric conversion member $121C_A$ and the first-B thermoelectric conversion member $121C_B$ are layered, and the second-A thermoelectric conversion member $122C_A$ and the second-B thermoelectric conversion member $122C_B$ are layered. Meanwhile, in Example 7, a first thermoelectric conversion element 221C and a second thermoelectric conversion element 222C are horizontally arranged. Fig. 7 is a schematic partial plan view showing a thermoelectric generation device of Example 7, and (A), (B), (C), (D), and (E) of Fig. 8 are schematic partial sectional views showing the thermoelectric generation device of Example 7 shown in Fig. 7 taken along the arrow A-A, the arrow B-B, the arrow C-C, the arrow D-D, and the arrow E-E, respectively. Note that Fig. 7 is hatched in order to make the structural elements of the thermoelectric generation device clear.

In Example 7, in a first thermoelectric conversion element 221C, a first-A thermoelectric conversion member $221C_A$ on a second support member 212 is on a first-B thermoelectric conversion member $221C_B$ on a first support member 211 in the horizontal direction. Further, in the second thermoelectric conversion element 222C, a second-A thermoelectric conversion member $222C_A$ on the first support member 211 is on a second-B thermoelectric conversion member $222C_B$ on the second support member 212 in the horizontal direction. More specifically, an end surface of the first-A thermoelectric conversion member $221C_A$ is on an end surface of the first-B thermoelectric conversion member $221C_B$ via the bonding member 213 in the horizontal direction. Similarly, an end surface of the second-A thermoelectric conversion member $222C_A$ is on an end surface of the second-B thermoelectric conversion member $222C_B$ via the bonding member 213 in the horizontal direction. Further, the second support member 212 is arranged under an end of the first-A thermoelectric conversion member $221C_A$ and an end of the second-B thermoelectric conversion member $222C_B$, and the second support member 212 supports the first-A thermoelectric conversion member $221C_A$ and the second-B thermoelectric conversion member $222C_B$. Similarly, the first support member 211 is arranged under an end of the first-B thermoelectric conversion member $221C_B$ and an end of the second-A thermoelectric conversion member $222C_A$, and the first support member 211 supports the first-B thermoelectric conversion member $221C_B$ and the second-A thermoelectric conversion member $222C_A$.

Further, the first thermoelectric conversion element 221C and the second thermoelectric conversion element 222C are electrically connected in series. Further, a first output unit 241 is connected to an end of the first-B thermoelectric conversion member $221C_B$, and a second output unit 242 is connected to an end of the second-A thermoelectric conversion member $222C_A$. The first-A thermoelectric conversion member $221C_A$ and the second-B thermoelectric conversion member $222C_B$ are electrically connected via a wiring 232 provided on the second support member 212, and the second-A thermoelectric conversion member $222C_A$ and the first-B thermoelectric conversion member $221C_B$ are electrically connected via a wiring 231 provided on the first support member 12.

Further, similar to Example 6,

$\tau_{SM1} \neq \tau_{SM2}$ is satisfied

where a constant in thermal response of the first support member 211 is $\tau_{SM1}$, and a constant in thermal response of the second support member 212 is $\tau_{SM2}$. Each of the first thermoelectric conversion element 221C and the second thermoelectric conversion element 222C is a rectangular parallelepiped (flat plate shape).

The thermoelectric generation method of Example 7 includes: arranging the thermoelectric generation device in an atmosphere, the atmospheric temperature changing; and bringing current to the exterior, the current being generated due to temperature difference between the first support member 211 and the second support member 212 when the temperature of the second support member 212 is higher than the temperature of the first support member 211, the current flowing from the second thermoelectric conversion element 222C to the first thermoelectric conversion element 221C, the first output unit 241 being a positive electrode, the second output unit 242 being a negative electrode. In this case, alternate current flows between the first output unit 241 and the second output unit 242, and a known half-wave rectifier circuit may convert the alternate current into direct current, and may further smooth the current. Note that current may be brought to the exterior, the current being generated due to temperature difference between the first support member 211 and the second support member 212 when the temperature of the first support member 211 is higher than the temperature of the second support member 212, the current flowing from the first thermoelectric conversion element 221C to the second thermoelectric conversion element 222C, the second output unit 242 being a positive electrode, the first output unit 241 being a negative electrode. In this case, a known full-wave rectifier circuit may convert alternate current into direct current, and may further smooth the current.

Here, if $\tau_{SM1} > \tau_{SM2}$ is satisfied, and if the thermoelectric generation device is arranged in an atmosphere of which temperature changes (in (B) of Fig. 6, atmospheric temperature at time surrounded by ellipse "A" is $T_{amb}$), the temperature $T_B$ of the second support member 212 immediately reaches the atmospheric temperature $T_{amb}$ or the temperature in the vicinity thereof. Meanwhile, because $\tau_{SM1} > \tau_{SM2}$ is satisfied, the temperature $T_A$ of the first support member 211 changes after the temperature of the second support member 212 changes. Therefore, the temperature difference $\Delta T$ ($=T_B-T_A$) is generated between the temperature $T_A$ ($<T_{amb}$) of the first support member 211 and the temperature $T_B$ ($=T_{amb}$) of the second support member 212.

$T_2 > T_1$ is satisfied

where the temperature in the vicinity of the first-A thermoelectric conversion member $221C_A$ and the second-B thermoelectric conversion member $222C_B$, which are on the second support member 212, is $T_2$, and the temperature in the vicinity of the first-B thermoelectric conversion member $221C_B$ and the second-A thermoelectric conversion member $222C_A$, which are on the first support member 211, is $T_1$. Further, an electromotive force EMF of the pair of thermoelectric conversion elements 221C, 222C is obtained based on the following equation.

$$EMF = T_2 \times SB_1 - T_1 \times SB_2$$

In some cases,

$\tau_{SM}3 \neq \tau_{SM1}$,

$\tau_{SM}3 \neq T_{SM2}$, and

$\tau_{SM1} = \tau_{SM2}$ may be satisfied

where the constant in thermal response of the bonding member 213 is $\tau_{SM}3$.

Example 8

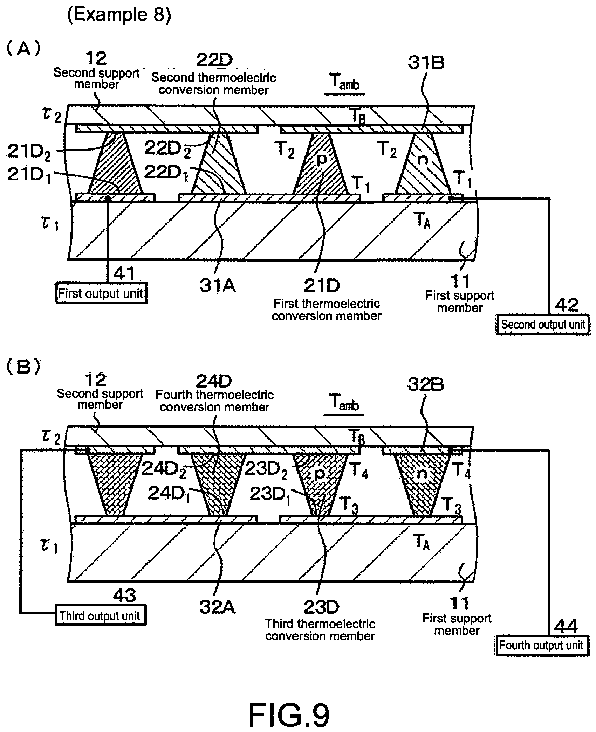

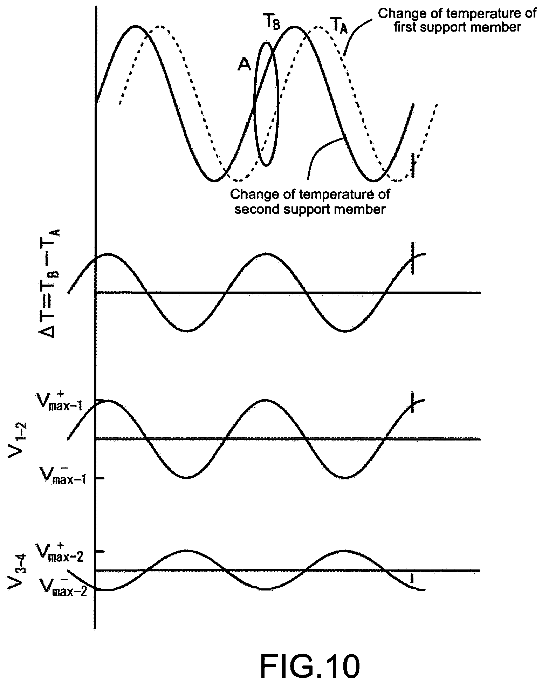

Example 8 relates to the thermoelectric generation method of the fourth-A mode. Each of (A) and (B) of Fig. 9 is a schematic partial sectional view showing the thermoelectric generation device suitable for the thermoelectric generation method of Example 8. Fig. 10 schematically shows the temperature ($T_A$) of the first support member, the temperature ($T_B$) of the second support member, the change of the temperature difference ($\Delta T = T_B - T_A$) between those temperatures, the change of the voltage $V_{1-2}$ between the first output unit and the second output unit, and the change of the voltage $V_{3-4}$ between the third output unit and the fourth output unit.

According to Example 8 or Example 9 to Example 10 (described later), the thermoelectric generation device includes

(A) a first support member 11,

(B) a second support member 12 facing the first support member 11,

(C) a first thermoelectric conversion element arranged between the first support member 11 and the second support member 12,

(D) a second thermoelectric conversion element arranged between the first support member 11 and the second support member 12, and

(E) a first output unit 41, a second output unit 42, a third output unit 43, and a fourth output unit 44,

the first thermoelectric conversion element includes

(C-1) a first thermoelectric conversion member 21D, 21E, 21F arranged between the first support member 11 and the second support member 12, and

(C-2) a second thermoelectric conversion member 22D, 22E, 22F arranged between the first support member 11 and the second support member 12, a material of the second thermoelectric conversion member 22D, 22E, 22F being different from a material of the first thermoelectric conversion member 21D, 21E, 21F, the second thermoelectric conversion member 22D, 22E, 22F being electrically connected to the first thermoelectric conversion member 21D, 21E, 21F in series, and

the second thermoelectric conversion element includes

(D-1) a third thermoelectric conversion member 23D, 23E, 23F arranged between the first support member 11 and the second support member 12, and

(D-2) a fourth thermoelectric conversion member 24D, 24E, 24F arranged between the first support member 11 and the second support member 12, a material of the fourth thermoelectric conversion member 24D, 24E, 24F being different from a material of the third thermoelectric conversion member 23D, 23E, 23F, the fourth thermoelectric conversion member 24D, 24E, 24F being electrically connected to the third thermoelectric conversion member 23D, 23E, 23F in series.

Further, the first output unit 41 is connected to the first thermoelectric conversion member 21D, 21E, 21F, the second output unit 42 is connected to the second thermoelectric conversion member 22D, 22E, 22F, the third output unit 43 is connected to the third thermoelectric conversion member 23D, 23E, 23F, and the fourth output unit 44 is connected to the fourth thermoelectric conversion member 24D, 24E, 24F.

More specifically, in Example 8 or Example 9 to Example 10 (described later), the first thermoelectric conversion member 21D, 21E, 21F and the second thermoelectric conversion member 22D, 22E, 22F are electrically connected in series via a wiring 31B provided on the second support member 12, and the second thermoelectric conversion member 22D, 22E, 22F and the first thermoelectric conversion member 21D, 21E, 21F are electrically connected in series via a wiring 31A provided on the first support member 11. Further, the third thermoelectric conversion member 23D, 23E, 23F and the fourth thermoelectric conversion member 24D, 24E, 24F are electrically connected in series via a wiring 32A provided on the first support member 11, and the fourth thermoelectric conversion member 24D, 24E, 24F and the third thermoelectric conversion member 23D, 23E, 23F are electrically connected in series via a wiring 32B provided on the second support member 12.

The first thermoelectric conversion member 21D includes a first surface $21D_1$ having an area $S_{11}$ and a second surface $21D_2$ having an area $S_{12}$ (where $S_{11}>S_{12}$), the second thermoelectric conversion member 22D includes a first surface $22D_1$ having an area $S_{21}$ and a second surface $22D_2$ having an area $S_{22}$ (where $S_{21}>S_{22}$), the third thermoelectric conversion member 23D includes a first surface $23D_1$ having an area $S_{31}$ and a second surface $23D_2$ having an area $S_{32}$ (where $S_{31}<S_{32}$), and the fourth thermoelectric conversion member 24D includes a first surface $24D_1$ having an area $S_{41}$ and a second surface $24D_2$ having an area $S_{42}$ (where $S_{41}<S_{42}$). Further, the first surface $21D_1$ of the first thermoelectric conversion member 21D and the first surface $22D_1$ of the second thermoelectric conversion member 22D contact the first support member 11, the second surface $21D_2$ of the first thermoelectric conversion member 21D and the second surface $22D_2$ of the second thermoelectric conversion member 22D contact the second support member 12, the first surface $23D_1$ of the third thermoelectric conversion member 23D and the first surface $24D_1$ of the fourth thermoelectric conversion member 24D contact the first support member 11, and the second surface $23D_2$ of the third thermoelectric conversion member 23D and the second surface $24D_2$ of the fourth thermoelectric conversion member 24D contact the second support member 12. Each of the first thermoelectric conversion member 21D, the second thermoelectric conversion member 22D, the third thermoelectric conversion member 23D, and the fourth thermoelectric conversion member 24D is a truncated pyramid/cone, more specifically, a truncated square pyramid. Note that structures of the first thermoelectric conversion member to the fourth thermoelectric conversion member of the thermoelectric generation device of Example 9 (described later) are the same as the above-mentioned structures of the first thermoelectric conversion member to the fourth thermoelectric conversion member of the thermoelectric generation device of Example 8.

Further,

$\tau_{SM1}\neq\tau_{SM2}$ is satisfied

where a constant in thermal response of the first support member 11 is $\tau_{SM1}$, and a constant in thermal response of the second support member 12 is $\tau_{SM2}$. Further,

$\tau_{TE1} \neq \tau_{TE2}$ is satisfied

where a constant in thermal response of the first thermoelectric conversion element is $\tau_{TE1}$, and a constant in thermal response of the second thermoelectric conversion element is $\tau_{TE2}$.

Here, the first output unit 41 is connected to an end of the first thermoelectric conversion member 21D at the first support member side, the second output unit 42 is connected to an end of the second thermoelectric conversion member 22D at the first support member side, the third output unit 43 is connected to an end of the third thermoelectric conversion member 23D at the second support member side, and the fourth output unit 44 is connected to an end of the fourth thermoelectric conversion member 24D at the second support member side. That is, the first output unit 41 is arranged on a support member and the second output unit 42 is arranged on another support member, and the third output unit 43 is arranged on a support member and the fourth output unit 44 is arranged on another support member.

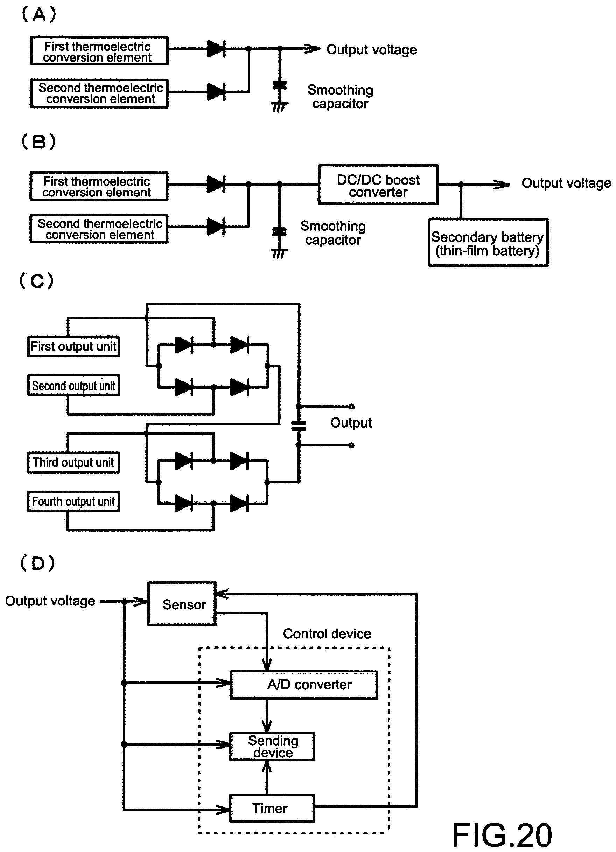

The thermoelectric generation method of Example 8 includes: arranging the thermoelectric generation device in an atmosphere, the atmospheric temperature changing; and bringing current to the exterior, the current being generated due to temperature difference between the first support member 11 and the second support member 12 when the temperature of the second support member 12 is higher than the temperature of the first support member 11, the current flowing from the second thermoelectric conversion member 22D to the first thermoelectric conversion member 21D, the first output unit 41 being a positive electrode, the second output unit 42 being a negative electrode. Meanwhile, current is brought to the exterior, the current being generated due to temperature difference between the first support member 11 and the second support member 12 when the temperature of the first support member 11 is higher than the temperature of the second support member 12, the current flowing from the fourth thermoelectric conversion member 24D to the third thermoelectric conversion member 23D, the third output unit 43 being a positive electrode, the fourth output unit 44 being a negative electrode. In this case, alternate current flows between the first output unit 41 and the second output unit 42, alternate current flows between the third output unit 43 and the fourth output unit 44, and a known half-wave rectifier circuit may convert the alternate current into direct current, and may further smooth the current. Here, a circuit shown in (A) of Fig. 20 may convert the alternate current into direct current, and may further smooth the current. Alternatively, a circuit shown in (B) of Fig. 20 may convert the alternate current into direct current, may further smooth the current, and a secondary battery (for example, including thin-film battery) may be charged. The rectifier circuit shown in (A) or (B) of Fig. 20 may be applied to the other examples. Note that the phase (for convenience, referred to as "phase-1") of the voltage brought to the exterior, where the first output unit 41 is a positive electrode and the second output unit 42 is a negative electrode, is out of phase with the phase (for convenience, referred to as "phase-2") of the voltage brought to the exterior where the third output unit 43 is a positive electrode and the fourth output unit 44 is a negative electrode, by about 180 degrees. That is, the phase-1 and the phase-2 are in the relation of opposite phase or approximately opposite phase.

Current may be brought to the exterior, the current being generated due to temperature difference between the first support member 11 and the second support member 12 when the temperature of the first support member 11 is higher than the temperature of the second support member 12, the current flowing from the first thermoelectric conversion member 21D to the second thermoelectric conversion member 22D, the second output unit 42 being a positive electrode, the first output unit 41 being a negative electrode. Further, current may be brought to the exterior, when the temperature of the second support member 12 is higher than the temperature of the first support member 11, the current flowing from the third thermoelectric conversion member 23D to the fourth thermoelectric conversion member 24D, the fourth output unit 44 being a positive electrode, the third output unit 43 being a negative electrode. In this case, a full-wave rectifier circuit may convert alternate current into direct current, and may further smooth the current. The above description may be applied to Example 9 to Example 10 (described later).

Example 9

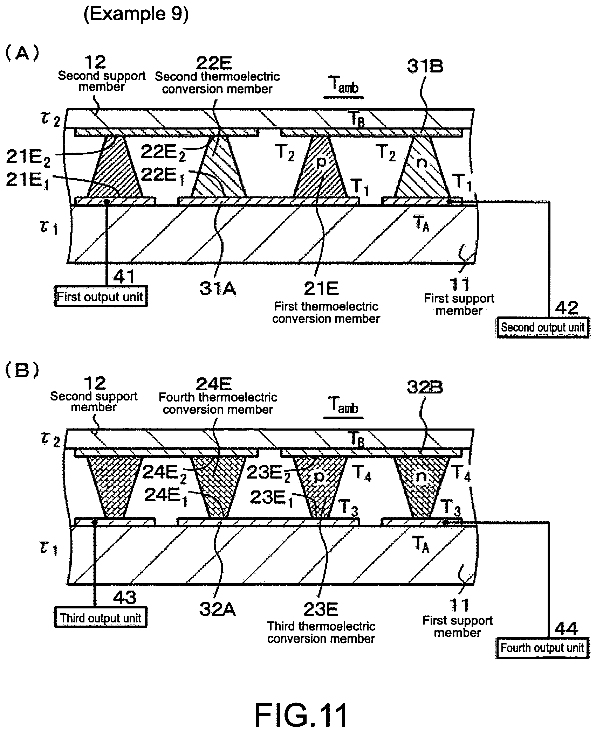

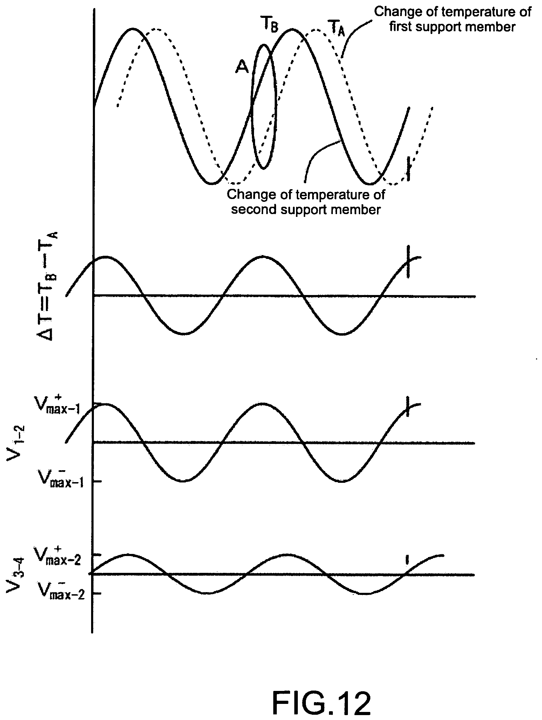

Example 9 relates to the thermoelectric generation device of the fourth mode, and the thermoelectric generation method of the fourth-B mode. Each of (A) and (B) of Fig. 11 is a schematic partial sectional view showing the thermoelectric generation device of Example 9. Fig. 12 schematically shows the temperature ($T_A$) of the first support member, the temperature ($T_B$) of the second support member, the change of the temperature difference ($\Delta T = T_B - T_A$) between those temperatures, the change of the voltage $V_{1-2}$ between the first output unit and the second output unit, and the change of the voltage $V_{3-4}$ between the third output unit and the fourth output unit.

In the thermoelectric generation device of Example 9, similar to the thermoelectric generation device of Example 8, the first output unit 41 is connected to an end of the first thermoelectric conversion member 21E at the first support member side, and the second output unit 42 is connected to an end of the second thermoelectric conversion member 22E at the first support member side. However, the third output unit 43 is connected to an end of the third thermoelectric conversion member 23E at the first support member side, and the fourth output unit 44 is connected to an end of the fourth thermoelectric conversion member 24E at the first support member side. That is, the first output unit 41, the second output unit 42, the third output unit 43, and the fourth output unit 44 are arranged on the same support member.

Further, in Example 9,

$\tau_{SM1} \neq \tau_{SM2}$ and

$\tau_{TE1} \neq \tau_{TE2}$ are satisfied

where a constant in thermal response of the first support member 11 is $\tau_{SM1}$, a constant in thermal response of the second support member 12 is $\tau_{SM2}$, a constant in thermal response of the first thermoelectric conversion element is $\tau_{TE1}$, and a constant in thermal response of the second thermoelectric conversion element is $\tau_{TE2}$.

The thermoelectric generation method of Example 9 includes: arranging the thermoelectric generation device in an atmosphere, the atmospheric temperature changing; bringing current to the exterior, the current being generated due to temperature difference between the first support member 11 and the second support member 12 when the temperature of the second support member 12 is higher than the temperature of the first support member 11, the current flowing from the second thermoelectric conversion member 22E to the first thermoelectric conversion member 21E, the first output unit 41 being a positive electrode, the second output unit 42 being a negative electrode; and bringing current to the exterior, the current flowing from the fourth thermoelectric conversion member 24E to the third thermoelectric conversion member 23E, the third output unit 43 being a positive electrode, the fourth output unit 44 being a negative electrode. In this case, alternate current flows between the first output unit 41 and the second output unit 42, and alternate current flows between the third output unit 43 and the fourth output unit 44. So, for example, a full-wave rectifier circuit shown in (C) of Fig. 20 may convert alternate current into direct current, and may further smooth the current. The full-wave rectifier circuit shown in (C) of Fig. 20 may be applied to the other examples. Note that the phase-1 of the voltage brought to the exterior, where the first output unit 41 is a positive electrode and the second output unit 42 is a negative electrode, is out of phase with the phase-2 of the voltage brought to the exterior where the third output unit 43 is a positive electrode and the fourth output unit 44 is a negative electrode, by more than 0 degrees and less than 180 degrees.

Example 10

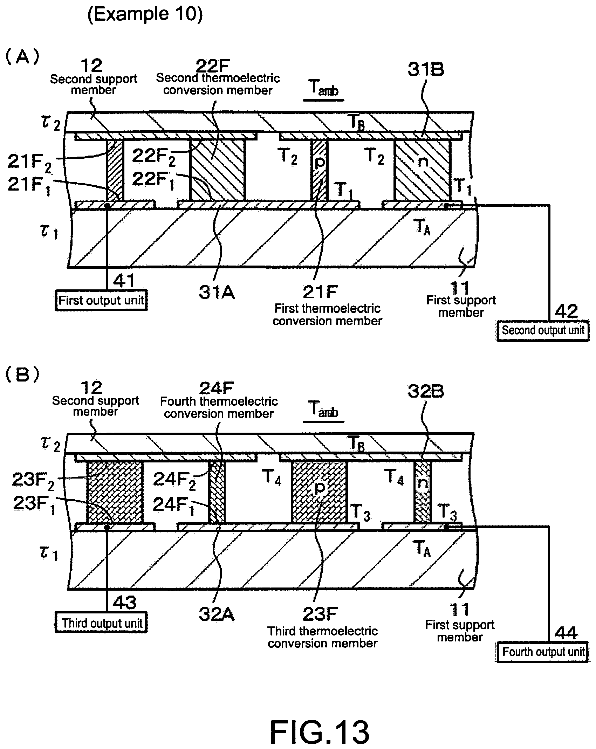

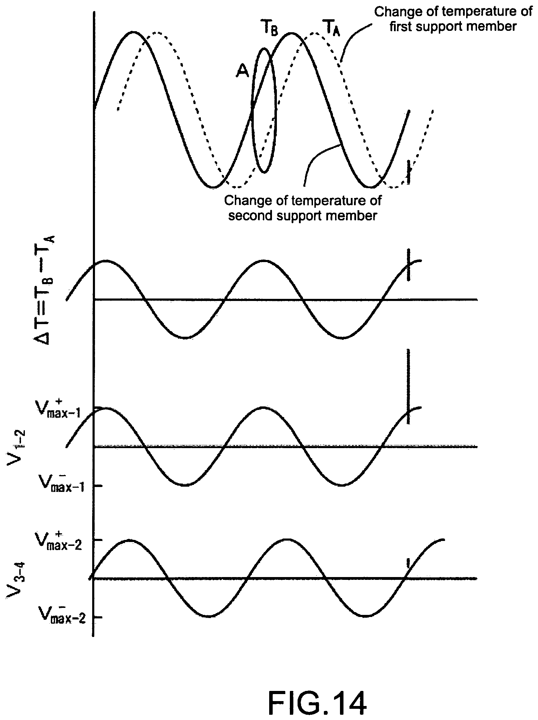

Example 10 is a modification of Example 9. Each of (A) and (B) of Fig. 13 is a schematic partial sectional view showing the thermoelectric generation device of Example 10. Fig. 14 schematically shows the temperature ($T_A$) of the first support member, the temperature ($T_B$) of the second support member, the change of the temperature difference ($\Delta T = T_B - T_A$) between those temperatures, the change of the voltage $V_{1-2}$ between the first output unit and the second output unit, and the change of the voltage $V_{3-4}$ between the third output unit and the fourth output unit.

In the thermoelectric generation device of Example 9, each of the first thermoelectric conversion member 21E, the second thermoelectric conversion member 22E, the third thermoelectric conversion member 23E, and the fourth thermoelectric conversion member 24E is a truncated square pyramid. Meanwhile, in the thermoelectric generation device of Example 10, each of the first thermoelectric conversion member 21F, the second thermoelectric conversion member 22F, the third thermoelectric conversion member 23F, and the fourth thermoelectric conversion member 24F is a rectangular prism. Further,

$VL_1 \neq VL_3$,

$VL_2 \neq VL_4$,

$VL_1 \neq VL_2$, and

$VL_3 \neq VL_4$ are satisfied

where the volume of the first thermoelectric conversion member 21 is $VL_1$, the volume of the second thermoelectric conversion member 22 is $VL_2$, the volume of the third thermoelectric conversion member 23 is $VL_3$, and the volume of the fourth thermoelectric conversion member 24 is $VL_4$. Except for the above, the thermoelectric generation device and the thermoelectric generation method of Example 10 may be similar to the thermoelectric generation device and the thermoelectric generation method of Example 9, and detailed description will be omitted.

Example 11

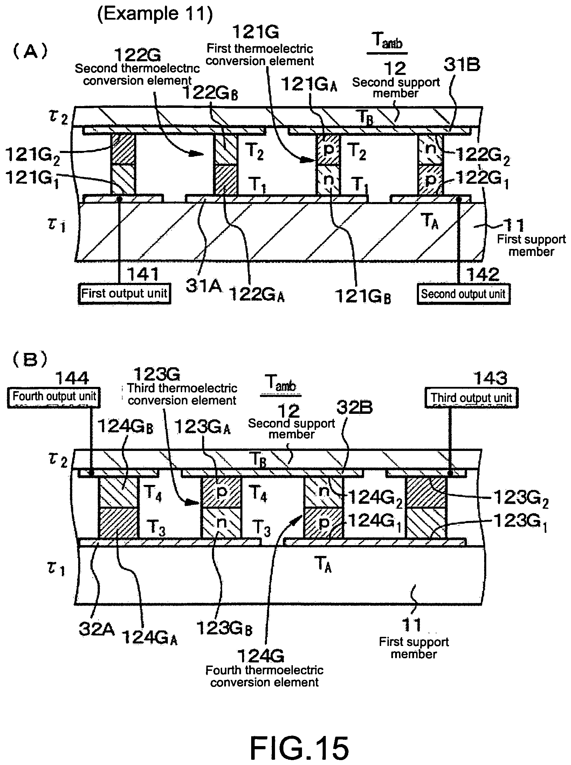

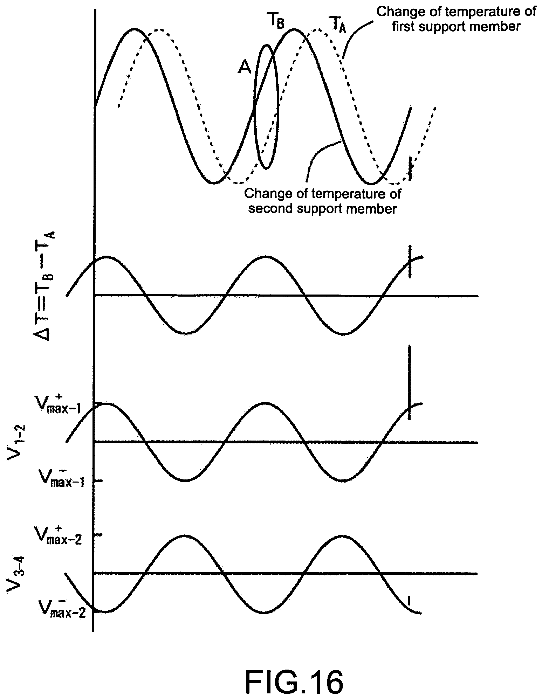

Example 11 relates to the thermoelectric generation method of the fifth-A mode. Each of (A) and (B) of Fig. 15 is a schematic partial sectional view showing the thermoelectric generation device suitable for the thermoelectric generation method of Example 11. Fig. 16 schematically shows the temperature ($T_A$) of the first support member, the temperature ($T_B$) of the second support member, the change of the temperature difference ($\Delta T = T_B - T_A$) between those temperatures, the change of the voltage $V_{1-2}$ between the first output unit and the second output unit, and the change of the voltage $V_{3-4}$ between the third output unit and the fourth output unit.

The thermoelectric generation device of Example 11 or Example 12 to Example 13 (described later) includes

(A) a first support member 11,

(B) a second support member 12 facing the first support member 11,

(C) a first thermoelectric conversion element 121G, 121H, 121J arranged between the first support member 11 and the second support member 12,

(D) a second thermoelectric conversion element 122G, 122H, 122J arranged between the first support member 11 and the second support member 12,

(E) a third thermoelectric conversion element 123G, 123H, 123J arranged between the first support member 11 and the second support member 12,

(F) a fourth thermoelectric conversion element 124G, 124H, 124J arranged between the first support member 11 and the second support member 12, and

(G) a first output unit 141, a second output unit 142, a third output unit 143, and a fourth output unit 144,

the first thermoelectric conversion element 121G, 121H, 121J includes a first-A thermoelectric conversion member $121G_A$, $121H_A$, $121J_A$ on the second support member and a first-B thermoelectric conversion member $121G_B$, $121H_B$, $121J_B$ on the first support member 11, the first-A thermoelectric conversion member $121G_A$, $121H_A$, $121J_A$ being (specifically, layered) on the first-B thermoelectric conversion member $121G_B$, $121H_B$, $121J_B$,

the second thermoelectric conversion element 122G, 122H, 122J includes a second-A thermoelectric conversion member $122G_A$, $122H_A$, $122J_A$ on the first support member 11 and a second-B thermoelectric conversion member $122G_B$, $122H_B$, $122J_B$ on the second support member 12, the second-A thermoelectric conversion member $122G_A$, $122H_A$, $122J_A$ being (specifically, layered) on the second-B thermoelectric conversion member $122G_B$, $122H_B$, $122J_B$,

the third thermoelectric conversion element 123G, 123H, 123J includes a third-A thermoelectric conversion member $123G_A$, $123H_A$, $123J_A$ on the second support member 12 and a third-B thermoelectric conversion member $123G_B$, $123H_B$, $123J_B$ on the first support member 11, the third-A thermoelectric conversion member $123G_A$, $123H_A$, $123J_A$ being (specifically, layered) on the third-B thermoelectric conversion member $123G_B$, $123H_B$, $123J_B$, and

the fourth thermoelectric conversion element 124G, 124H, 124J includes a fourth-A thermoelectric conversion member $124G_A$, $124H_A$, $124J_A$ on the first support member 11 and a fourth-B thermoelectric conversion member $124G_B$, $124H_B$, $124J_B$ on the second support member 12, the fourth-A thermoelectric conversion member $124G_A$, $124H_A$, $124J_A$ being (specifically, layered) on the fourth-B thermoelectric conversion member $124G_B$, $124H_B$, $124J_B$.

Further, the first thermoelectric conversion element 121G, 121H, 121J and the second thermoelectric conversion element 122G, 122H, 122J are electrically connected in series, and the third thermoelectric conversion element 123G, 123H, 123J and the fourth thermoelectric conversion element 124G, 124H, 124J are electrically connected in series. Further, the first output unit 141 is connected to the first thermoelectric conversion element 121G, 121H, 121J, the second output unit 142 is connected to the second thermoelectric conversion element 122G, 122H, 122J, the third output unit 143 is connected to the third thermoelectric conversion element 123G, 123H, 123J, and the fourth output unit 144 is connected to the fourth thermoelectric conversion element 124G, 124H, 124J. That is, the first output unit 141 and the second output unit 142, the third output unit 143 and the fourth output unit 144 are arranged on the different support members.

Specifically, in Example 11, the first output unit 141 is connected to an end of the first-B thermoelectric conversion member $121G_B$, the second output unit 142 is connected to an end of the second-A thermoelectric conversion member $122G_A$, the third output unit 143 is connected to an end of the third-A thermoelectric conversion member $123G_A$, and the fourth output unit 144 is connected to an end of the fourth-B thermoelectric conversion member $124G_B$. Specifically, the first-A thermoelectric conversion member $121G_A$ is electrically connected to the second-B thermoelectric conversion member $122G_B$ via the wiring 31B provided on the second support member 12, the second-A thermoelectric conversion member $122G_A$ is electrically connected to the first-B thermoelectric conversion member $121G_B$ via the wiring 31A provided on the first support member 11, the third-A thermoelectric conversion member $123G_A$ is electrically connected to the fourth-B thermoelectric conversion member $124G_B$ via the wiring 32B provided on the second support member 12, and the fourth-A thermoelectric conversion member $124G_A$ is electrically connected to the third-B thermoelectric conversion member $123G_B$ via the wiring 32A provided on the first support member 11.

Further, in Example 11,

$\tau_{SM1} \neq \tau_{SM2}$ is satisfied

where a constant in thermal response of the first support member 11 is $\tau_{SM1}$, and a constant in thermal response of the second support member 12 is $\tau_{SM2}$. Each of the first thermoelectric conversion element 121G, the second thermoelectric conversion element 122G, the third thermoelectric conversion element 123G, and the fourth thermoelectric conversion element 124G is a prism, more specifically, a rectangular prism.

The thermoelectric generation method of Example 11 includes: arranging the thermoelectric generation device in an atmosphere, the atmospheric temperature changing; bringing current to the exterior, the current being generated due to temperature difference between the first support member 11 and the second support member 12 when the temperature of the second support member 12 is higher than the temperature of the first support member 11, the current flowing from the second thermoelectric conversion element 122G to the first thermoelectric conversion element 121G, the first output unit 141 being a positive electrode, the second output unit 142 being a negative electrode; and meanwhile, bringing current to the exterior, the current being generated due to temperature difference between the first support member 11 and the second support member 12 when the temperature of the first support member 11 is higher than the temperature of the second support member 12, the current flowing from the third thermoelectric conversion element 123G to the fourth thermoelectric conversion element 124G, the fourth output unit 144 being a positive electrode, the third output unit 143 being a negative electrode. In this case, alternate current flows between the first output unit 141 and the second output unit 142, alternate current flows between the third output unit 143 and the fourth output unit 144, and a known half-wave rectifier circuit may convert the alternate current into direct current, and may further smooth the current. Note that the phase-1 of the voltage brought to the exterior, where the first output unit 141 is a positive electrode and the second output unit 142 is a negative electrode, is out of phase with the phase-2 of the voltage brought to the exterior where the fourth output unit 144 is a positive electrode and the third output unit 143 is a negative electrode, by about 180 degrees. That is, the phase-1 and the phase-2 are in the relation of opposite phase or approximately opposite phase.

Current may be brought to the exterior, the current being generated due to temperature difference between the first support member 11 and the second support member 12 when the temperature of the first support member 11 is higher than the temperature of the second support member 12, the current flowing from the first thermoelectric conversion element 121G to the second thermoelectric conversion element 122G, the second output unit 142 being a positive electrode, the first output unit 141 being a negative electrode. Further, current may be brought to the exterior, when the temperature of the second support member 12 is higher than the temperature of the first support member 11, the current flowing from the fourth thermoelectric conversion element 124G to the third thermoelectric conversion element 123G, the third output unit 143 being a positive electrode, the fourth output unit 144 being a negative electrode. In this case, a known full-wave rectifier circuit may convert alternate current into direct current, and may further smooth the current. Note that the above description may apply to Example 12 to Example 13 (described later).

Here, if $\tau_{SM1}>\tau_{SM2}$ is satisfied, if the thermoelectric generation device is arranged in an atmosphere of which temperature changes (in Fig. 16, atmospheric temperature at time surrounded by ellipse "A" is $T_{amb}$), the temperature $T_B$ of the second support member 12 immediately reaches the atmospheric temperature $T_{amb}$ or the temperature in the vicinity thereof. Meanwhile, because $\tau_{SM1}>\tau_{SM2}$ is satisfied, the temperature $T_A$ of the first support member 11 changes after the temperature of the second support member 12 changes. Therefore, the temperature difference $\Delta T$ (=$T_B$-$T_A$) is generated between the temperature $T_A$ (<$T_{amb}$) of the first support member 11 and the temperature $T_B$ (=$T_{amb}$) of the second support member 12.

$T_2>T_1$ and

$T_4>T_3$ are satisfied

where the temperature in the vicinity of a second surface $121G_2$ of the first-A thermoelectric conversion member $121G_A$ and a second surface $122G_2$ of the second-B thermoelectric conversion member $122G_B$, which are on the second support member 12, is $T_2$, the temperature in the vicinity of a first surface $121G_1$ of the first-B thermoelectric conversion member $121G_B$ and a first surface $122G_1$ of the second-A thermoelectric conversion member $122G_A$, which are on the first support member 11, is $T_1$, the temperature in the vicinity of a second surface $123G_2$ of the third-A thermoelectric conversion member $123G_A$ and a second surface $124G_2$ of the fourth-B thermoelectric conversion member $124G_B$, which are on the second support member 12, is $T_4$, and the temperature in the vicinity of a first surface $123G_1$ of the third-B thermoelectric conversion member $123G_B$ and a first surface $124G_1$ of the fourth-A thermoelectric conversion member $124G_A$, which are on the first support member 11, is $T_3$. Further, an electromotive force $EMF_1$ of a pair of the first thermoelectric conversion element and the second thermoelectric conversion element, and an electromotive force $EMF_2$ of a pair of the third thermoelectric conversion element and the fourth thermoelectric conversion element are obtained based on the following equations.

$$EMF_1 = T_2 \times SB_1 - T_1 \times SB_2$$

$$EMF_2 = T_4 \times SB_3 - T_3 \times SB_4$$

Example 12

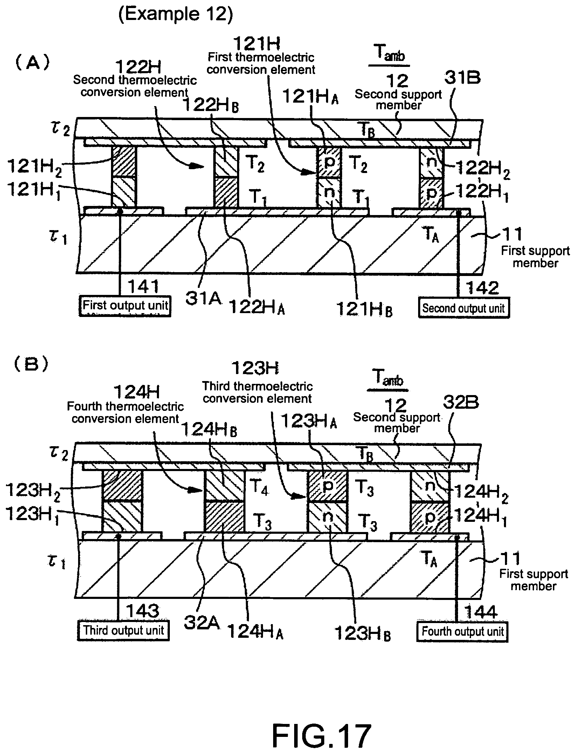

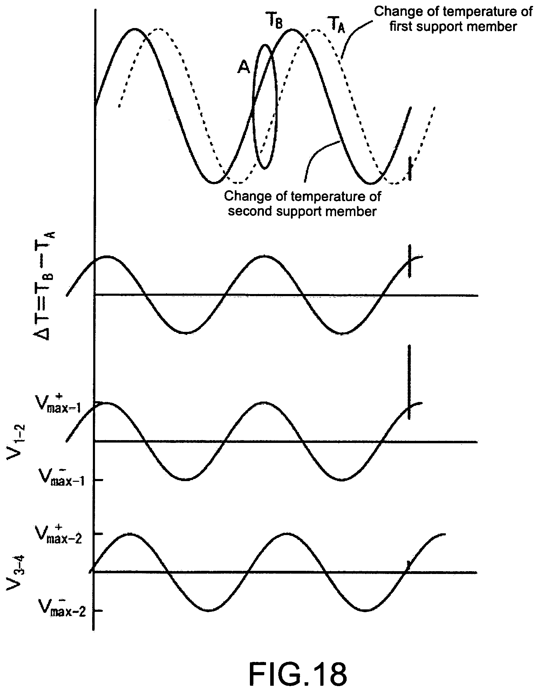

Example 12 relates to the thermoelectric generation device of the fifth mode, and the thermoelectric generation method of the fifth-B mode. Each of (A) and (B) of Fig. 17 is a schematic partial sectional view showing the thermoelectric generation device of Example 12. Fig. 18 schematically shows the temperature ($T_A$) of the first support member, the temperature ($T_B$) of the second support member, the change of the temperature difference ($\Delta T=T_B-T_A$) between those temperatures, the change of the voltage $V_{1\text{-}2}$ between the first output unit and the second output unit, and the change of the voltage $V_{3\text{-}4}$ between the third output unit and the fourth output unit.

In Example 12 or Example 13 (described later), the first output unit 141 is connected to an end of the first-B thermoelectric conversion member $121H_B$, $121J_B$, the second output unit 142 is connected to an end of the second-A thermoelectric conversion member $122H_A$, $122J_A$, the third output unit 143 is connected to an end of the third-B thermoelectric conversion member $123H_B$, $123J_B$, and the fourth output unit 144 is connected to an end of the fourth-A thermoelectric conversion member $124H_A$, $124J_A$. That is, the first output unit 141, the second output unit 142, the third output unit 143, and the fourth output unit 144 are arranged on the same support member. The first-A thermoelectric conversion member $121H_A$, $121J_A$ is electrically connected to the second-B thermoelectric conversion member $122H_B$, $122J_B$ via the wiring 31B provided on the second support member 12, the first-B thermoelectric conversion member $121H_B$, $121J_B$ is electrically connected to the second-A thermoelectric conversion member $122H_A$, $122J_A$ via the wiring 31A provided on the first support member 11, the third-A thermoelectric conversion member $123H_A$, $123J_A$ is electrically connected to the fourth-B thermoelectric conversion member $124H_B$, $124J_B$ via the wiring 32B provided on the second support member 12, and the third-B thermoelectric conversion member $123H_B$, $123J_B$ is electrically connected to the fourth-A thermoelectric conversion member $124H_A$, $124J_A$ via the wiring 32A provided on the first support member 11.

Further,

$\tau_{TE1} \neq \tau_{TE3}$ and
$\tau_{TE2} \neq \tau_{TE4}$ are satisfied

where a constant in thermal response of the first support member 11 is $\tau_{SM1}$, a constant in thermal response of the second support member 12 is $\tau_{SM2}$, a constant in thermal response of the first thermoelectric conversion element 121H, 121J is $\tau_{TE1}$, a constant in thermal response of the second thermoelectric conversion element 122H, 122J is $\tau_{TE2}$, a constant in thermal response of the third thermoelectric conversion element 123H, 123J is $\tau_{TE3}$, and a constant in thermal response of the fourth thermoelectric conversion element 124H, 124J is $\tau_{TE4}$. Further, in Example 12,

$VL_1 = VL_2 \neq VL_3 = VL_4$ (where, in Example 12, specifically, $VL_1 = VL_2 < VL_3 = VL_4$) is satisfied

where the volume of the first thermoelectric conversion member 121H is $VL_1$, the volume of the second thermoelectric conversion member 122H is $VL_2$, the volume of the third thermoelectric conversion member 123H is $VL_3$, and the volume of the fourth thermoelectric conversion member 124H is $VL_4$. Each of the first thermoelectric conversion element 121H, the second thermoelectric conversion element 122H, the third thermoelectric conversion element 123H, and the fourth thermoelectric conversion element 124H is a prism, more specifically, a rectangular prism.

The thermoelectric generation method of Example 12 includes: arranging the thermoelectric generation device in an atmosphere, the atmospheric temperature changing; bringing current to the exterior, the current being generated due to temperature difference between the first support member 11 and the second support member 12 when the temperature of the second support member 12 is higher than the temperature of the first support member 11, the current flowing from the second thermoelectric conversion element 122H to the first thermoelectric conversion element 121H, the first output unit 141 being a positive electrode, the second output unit 142 being a negative electrode; and bringing current to the exterior, the current flowing from the fourth thermoelectric conversion element 124H to the third thermoelectric conversion element 123H, the third output unit 143 being a positive electrode, the fourth output unit 144 being a negative electrode. In this case, alternate current flows between the first output unit 141 and the second output unit 142, alternate current flows between the third output unit 143 and the fourth output unit 144, and a known half-wave rectifier circuit may convert the alternate current into direct current, and may further smooth the current. Note that the phase-1 of the voltage brought to the exterior, where the first output unit 141 is a positive electrode and the second output unit 142 is a negative electrode, is out of phase with the phase-2 of the voltage brought to the exterior where the third output unit 143 is a positive electrode and the fourth output unit 144 is a negative electrode, by more than 0 degrees and less than 180 degrees.

Here, if $\tau_{SM1} > \tau_{SM2}$ is satisfied, if the thermoelectric generation device is arranged in an atmosphere of which temperature changes (in Fig. 18, atmospheric temperature at time surrounded by ellipse "A" is $T_{amb}$), the temperature $T_B$ of the second support member 12 immediately reaches the atmospheric temperature $T_{amb}$ or the temperature in the vicinity thereof. Meanwhile, because $\tau_{SM1} > \tau_{SM2}$ is satisfied, the temperature $T_A$ of the first support member 11 changes after the temperature of the second support member 12 changes. Therefore, the temperature difference $\Delta T$ ($=T_B-T_A$) is generated between the temperature $T_A$ ($<T_{amb}$) of the first support member 11 and the temperature $T_B$ ($=T_{amb}$) of the second support member 12.

$T_2 > T_1$ and
$T_4 > T_3$ are satisfied

where the temperature in the vicinity of a second surface $121H_2$ of the first-A thermoelectric conversion member $121H_A$ and a second surface $122H_2$ of the second-B thermoelectric conversion member $122H_B$, which are on the second support member 12, is $T_2$, the temperature in the vicinity of a first surface $121H_1$ of the first-A thermoelectric conversion member $121H_A$ and a first surface $122H_1$ of the second-B thermoelectric conversion member $122H_B$, which are on the first support member 11, is $T_1$, the temperature in the vicinity of a second surface $123H_2$ of the third-A thermoelectric conversion member $123H_A$ and a second surface $124H_2$ of the fourth-B thermoelectric conversion member $124H_B$, which are on the second support member 12, is $T_4$, and the temperature in the vicinity of a first surface $123H_1$ of the third-A thermoelectric conversion member $123H_A$ and a first surface $124H_1$ of the fourth-B thermoelectric conversion member $124H_B$, which are on the first support member 11, is $T_3$. Further, an electromotive force $EMF_1$ of a pair of the first thermoelectric conversion element and the second thermoelectric conversion element, and an electromotive force $EMF_2$ of a pair of the third thermoelectric conversion element and the fourth thermoelectric conversion element are obtained based on the following equations.

$$EMF_1 = T_2 \times SB_1 - T_1 \times SB_2$$

$$EMF_2 = T_4 \times SB_3 - T_3 \times SB_4$$

Example 13

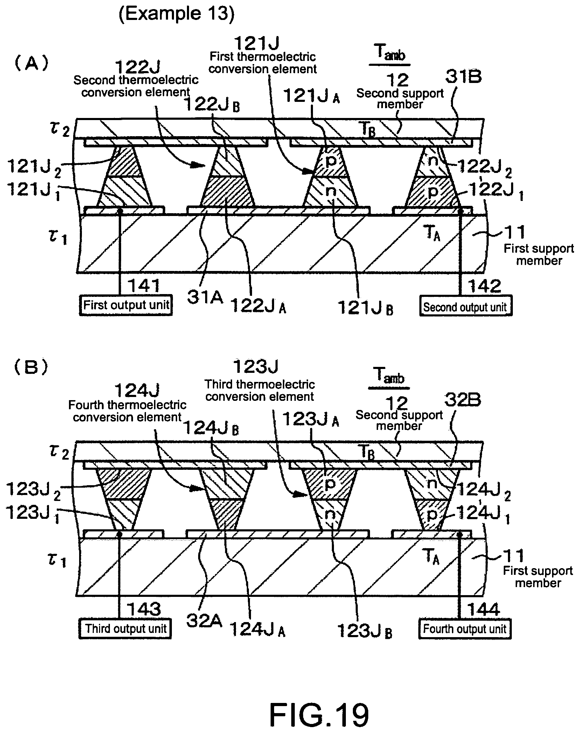

Example 13 is a modification of Example 12. Each of (A) and (B) of Fig. 19 is a schematic partial sectional view showing the thermoelectric generation device of Example 13.

In the thermoelectric generation device of Example 12, each of the first thermoelectric conversion element 121H, the second thermoelectric conversion element 122H, the third thermoelectric conversion element 123H, and the fourth thermoelectric conversion element 124H is a rectangular prism. Meanwhile, in the thermoelectric generation device of Example 13, each of the first thermoelectric conversion element 121J, the second thermoelectric conversion element 122J, the third thermoelectric conversion element 123J, and the fourth thermoelectric conversion element 124J is a truncated square pyramid. Specifically,
$S_{12} \neq S_{32}$,
$S_{21} \neq S_{41}$,
$S_{12} \neq S_{21}$, and
$S_{31} \neq S_{42}$ are satisfied
where the area of a part (second surface $121J_2$) of the first-A thermoelectric conversion member $121J_A$, which is on the second support member 12, is $S_{12}$, the area of a part (second surface $122J_2$) of the second-B thermoelectric conversion member $122J_B$, which is on the second support member 12, is $S_{22}$, the area of a part (first surface $121J_{11}$) of the first-B thermoelectric conversion member $121J_B$, which is on the first support member 11, is $S_{11}$, the area of a part (first surface $122J_1$) of the second-A thermoelectric conversion member $122J_A$, which is on the first support member 11, is $S_{21}$, the area of a part (second surface $123J_2$) of the third-A thermoelectric conversion member $123J_A$, which is on the second support member 12, is $S_{32}$, the area of a part (second surface $124J_2$) of the fourth-B thermoelectric conversion member $124J_B$, which is on the second support member 12, is $S_{42}$, the area of a part (first surface $123J_1$) of the third-B thermoelectric conversion member $123J_B$, which is on the first support member 11, is $S_{31}$, and the area of a part (first surface $124J_1$) of the fourth-A thermoelectric conversion member $124J_A$, which is on the first support member 11, is $S_{41}$. Except for the above, the thermoelectric generation device and the thermoelectric generation method of Example 13 may be similar to the thermoelectric generation device and the thermoelectric generation method of Example 12, and detailed description will be omitted.

Example 14

Each of the various thermoelectric generation devices described in Example 4 to Example 13 may be used as an electric signal detecting device, and may be applied to Example 1 to Example 3. Specifically, the thermoelectric generation device described in each of Example 4 to Example 13 is arranged in an atmosphere of which temperature changes. Further, the atmospheric temperature changes in a specific manner, and the thermoelectric generation device generates thermoelectricity corresponding to the temperature change, whereby it is possible to detect an electric signal where the temperature change is a kind of trigger. Further, for example, in a case where a plurality of sensors are arranged in a sensor network system or the like, the sensors are not calibrated one by one based on the detected electric signal, but all the sensors or some sensors in the system may be collectively calibrated. That is, in Example 14, not only indirectly and collectively supplying electric power and generating electric power, but also a device may be calibrated collectively. Further, the thermoelectric generation device may be applied to a method of specifying the location of a specific article, specifically, may be applied to a method of detecting, for example, a key, a mobile phone, or the like, on which the thermoelectric generation device is mounted, easily.

The constant in thermal response $\tau$ is determined depending on, as described above, the density p, the specific heat c, and the heat transfer coefficient h of the materials of the support member, the thermoelectric conversion element, and the thermoelectric conversion member, and depending on the volume VL and the area S of the support member, the thermoelectric conversion element, and the thermoelectric conversion member. So they may be appropriately selected to obtain desired information (electric signal). As a result, for example, it is possible to obtain an electric signal detecting device including thermoelectric generation devices having a plurality of constants in thermal response $\tau$, thermal response difference with respect to the temperature change is generated, and it is possible to obtain a plurality of electric signals from an electric signal detecting device. As a result, it is possible to obtain a plurality of pieces of information from one electric signal detecting device.

(D) of Fig. 20 is a conceptual diagram showing an example of an application of the thermoelectric generation device. In the application, the thermoelectric generation device supplies electric power to a sensor, and, in addition, the thermoelectric generation device supplies electric power to an A/D converter, a sending device, and a timer of a sensor control device. Further, when the timer works, a value from the sensor is sent to the A/D converter and the sending device transmits the value to the exterior as data at predetermined time intervals. Further, the sensor receives the electric signal from the thermoelectric generation device, and calibrates the electric signal.

According to the electric signal detecting method of the first mode, substantially similar to Example 4, current is brought to the exterior as an electric signal, the current being generated due to temperature difference between the first support member 11 and the second support member 12 when the temperature of the second support member 12 is higher than the temperature of the first support member 11, the current flowing from the second thermoelectric conversion member 22A, 22B to the first thermoelectric conversion member 21A, 21B, the first output unit 41 being a positive electrode (+ electrode), the second output unit 42 being a negative electrode (- electrode). Here, in Example 4, the current flowing from the second thermoelectric conversion member 22A, 22B to the first thermoelectric conversion member 21A, 21B is used as an energy source. Meanwhile, in Example 14, the current flowing from the second thermoelectric conversion member 22A, 22B to the first thermoelectric conversion member 21A, 21B is used as an electric signal, i.e., an electric signal including information. Further, one kind of electric signal or a plurality of kinds of electric signals is/are obtained from the electric signal. As necessary, the obtained electric signal may pass through a bandpass filter, a lowpass filter, or a highpass filter. The same applies to the following description.

Alternatively, substantially similar to Example 5, the electric signal detecting method of the second mode includes: arranging the thermoelectric generation device in an atmosphere, the atmospheric temperature changing; and bringing current to the exterior as an electric signal, the current being generated due to temperature difference between the first support member 11 and the second support member 12 when the temperature of the second support member 12 is higher than the temperature of the first support member 11, the current flowing from the second thermoelectric conversion member 22A, 22B to the first thermoelectric conversion member 21A, 21B, the first output unit 41 being a positive electrode (+ electrode), the second output unit 42 being a negative electrode (- electrode).

Alternatively, similar to Example 6 to Example 7, the electric signal detecting method of the third mode includes arranging the thermoelectric generation device in an atmosphere, the atmospheric temperature changing. Further, substantially similar to Example 6 to Example 7, current is brought to the exterior as an electric signal, the current being generated due to temperature difference between the first support member 11, 211 and the second support member 12, 212 when the temperature of the second support member 12, 212 is higher than the temperature of the first support member 11, 211, the current flowing from the second thermoelectric conversion element 122C, 222C to the first thermoelectric conversion element 121C, 221C, the first output unit 141, 241 being a positive electrode, the second output unit 142, 242 being a negative electrode.

As described above, the thermoelectric generation device is arranged in an atmosphere, the atmospheric temperature changing.

Current is brought to the exterior as an electric signal, the current being generated due to temperature difference between the first support member and the second support member when the temperature of the second support member is higher than the temperature of the first support member, the current flowing from the second thermoelectric conversion member to the first thermoelectric conversion member, the first output unit being a positive electrode, the second output unit being a negative electrode (electric signal detecting method of first mode or second mode). Alternatively, current is brought to the exterior as an electric signal, the current flowing from the second thermoelectric conversion element to the first thermoelectric conversion element, the first output unit being a positive electrode, the second output unit being a negative electrode (electric signal detecting method of third mode). One kind of electric signal or a plurality of kinds of electric signals is/are obtained from the electric signal.

Alternatively, similar to Example 8, the electric signal detecting method of the fourth-A mode includes arranging the thermoelectric generation device in an atmosphere, the atmospheric temperature changing. Further, substantially similar to Example 8, current is brought to the exterior as an electric signal, the current being generated due to temperature difference between the first support member 11 and the second support member 12 when the temperature of the second support member 12 is higher than the temperature of the first support member 11, the current flowing from the second thermoelectric conversion member 22D to the first thermoelectric conversion member 21D, the first output unit 41 being a positive electrode, the second output unit 42 being a negative electrode; and meanwhile current is brought to the exterior as an electric signal, the current being generated due to temperature difference between the first support member 11 and the second support member 12 when the temperature of the first support member 11 is higher than the temperature of the second support member 12, the current flowing from the fourth thermoelectric conversion member 24D to the third thermoelectric conversion member 23D, the third output unit 43 being a positive electrode, the fourth output unit 44 being a negative electrode.

That is, the electric signal detecting method of the fourth-A mode includes:

arranging the thermoelectric generation device in an atmosphere, the atmospheric temperature changing;

bringing current to the exterior as an electric signal, the current being generated due to temperature difference between the first support member and the second support member when the temperature of the second support member is higher than the temperature of the first support member, the current flowing from the second thermoelectric conversion member to the first thermoelectric conversion member, the first output unit being a positive electrode, the second output unit being a negative electrode;

bringing current to the exterior as an electric signal, the current being generated due to temperature difference between the first support member and the second support member when the temperature of the first support member is higher than the temperature of the second support member, the current flowing from the fourth thermoelectric conversion member to the third thermoelectric conversion member, the third output unit being a positive electrode, the fourth output unit being a negative electrode; and

obtaining one kind of electric signal or a plurality of kinds of electric signals from the electric signal.

Alternatively, similar to Example 9 to Example 10, the electric signal detecting method of the fourth-B mode includes arranging the thermoelectric generation device in an atmosphere, the atmospheric temperature changing. Further, substantially similar to Example 9 to Example 10, current is brought to the exterior as an electric signal, the current being generated due to temperature difference between the first support member 11 and the second support member 12 when the temperature of the second support member 12 is higher than the temperature of the first support member 11, the current flowing from the second thermoelectric conversion member 22E, 22F to the first thermoelectric conversion member 21E, 21F, the first output unit 41 being a positive electrode, the second output unit 42 being a negative electrode; and current is brought to the exterior as an electric signal, the current flowing from the fourth thermoelectric conversion member 24E, 24F to the third thermoelectric conversion member 23E, 23F, the third output unit 43 being a positive electrode, the fourth output unit 44 being a negative electrode.

That is, the electric signal detecting method of the fourth-B mode includes:

instead of bringing current to the exterior, the current being generated due to temperature difference between the first support member and the second support member when the temperature of the second support member is higher than the temperature of the first support member, the current flowing from the second thermoelectric conversion member to the first thermoelectric conversion member, the first output unit being a positive electrode, the second output unit being a negative electrode, and bringing current to the exterior, the current being generated due to temperature difference between the first support member and the second support member when the temperature of the first support member is higher than the temperature of the second support member, the current flowing from the fourth thermoelectric conversion member to the third thermoelectric conversion member, the third output unit being a positive electrode, the fourth output unit being a negative electrode,

bringing current to the exterior as an electric signal, the current being generated due to temperature difference between the first support member and the second support member when the temperature of the second support member is higher than the temperature of the first support member, the current flowing from the second thermoelectric conversion member to the first thermoelectric conversion member, the first output unit being a positive electrode, the second output unit being a negative electrode; and bringing current to the exterior as an electric signal, the current flowing from the fourth thermoelectric conversion member to the third thermoelectric conversion member, the third output unit being a positive electrode, the fourth output unit being a negative electrode; and

obtaining one kind of electric signal or a plurality of kinds of electric signals from the electric signal.

Alternatively, similar to Example 11, the electric signal detecting method of the fifth-A mode includes arranging the thermoelectric generation device in an atmosphere, the atmospheric temperature changing. Further, substantially similar to Example 11, current is brought to the exterior as an electric signal, the current being generated due to temperature difference between the first support member 11 and the second support member 12 when the temperature of the second support member 12 is higher than the temperature of the first support member 11, the current flowing from the second thermoelectric conversion element 122G to the first thermoelectric conversion element 121G, the first output unit 141 being a positive electrode, the second output unit 142 being a negative electrode; and meanwhile current is brought to the exterior as an electric signal, the current being generated due to temperature difference between the first support member 11 and the second support member 12 when the temperature of the first support member 11 is higher than the temperature of the second support member 12, the current flowing from the third thermoelectric conversion element 123G to the fourth thermoelectric conversion element 124G, the fourth output unit 144 being a positive electrode, the third output unit 143 being a negative electrode.

That is, the electric signal detecting method of the fifth-A mode includes:

arranging the thermoelectric generation device in an atmosphere, the atmospheric temperature changing;
bringing current to the exterior as an electric signal, the current being generated due to temperature difference between the first support member and the second support member when the temperature of the second support member is higher than the temperature of the first support member, the current flowing from the second thermoelectric conversion element to the first thermoelectric conversion element, the first output unit being a positive electrode, the second output unit being a negative electrode;
bringing current to the exterior as an electric signal, the current being generated due to temperature difference between the first support member and the second support member when the temperature of the first support member is higher than the temperature of the second support member, the current flowing from the third thermoelectric conversion element to the fourth thermoelectric conversion element, the fourth output unit being a positive electrode, the third output unit being a negative electrode; and
obtaining one kind of electric signal or a plurality of kinds of electric signals from the electric signal.

Alternatively, similar to Example 12 to Example 13, the electric signal detecting method of the fifth-B mode includes arranging the thermoelectric generation device in an atmosphere, the atmospheric temperature changing. Further, substantially similar to Example 12 to Example 13, current is brought to the exterior as an electric signal, the current being generated due to temperature difference between the first support member 11 and the second support member 12 when the temperature of the second support member 12 is higher than the temperature of the first support member 11, the current flowing from the second thermoelectric conversion element 122H, 122J to the first thermoelectric conversion element 121H, 121J, the first output unit 141 being a positive electrode, the second output unit 142 being a negative electrode; and current is brought to the exterior as an electric signal, the current flowing from the fourth thermoelectric conversion element 124H, 124J to the third thermoelectric conversion element 123H, 123J, the third output unit 143 being a positive electrode, the fourth output unit 144 being a negative electrode.

That is, the electric signal detecting method of the fifth-B mode includes:

instead of bringing current to the exterior, the current being generated due to temperature difference between the first support member and the second support member when the temperature of the second support member is higher than the temperature of the first support member, the current flowing from the second thermoelectric conversion element to the first thermoelectric conversion element, the first output unit being a positive electrode, the second output unit being a negative electrode, and bringing current to the exterior, the current being generated due to temperature difference between the first support member and the second support member when the temperature of the first support member is higher than the temperature of the second support member, the current flowing from the third thermoelectric conversion element to the fourth thermoelectric conversion element, the fourth output unit being a positive electrode, the third output unit being a negative electrode,
bringing current to the exterior as an electric signal, the current being generated due to temperature difference between the first support member and the second support member when the temperature of the second support member is higher than the temperature of the first support member, the current flowing from the second thermoelectric conversion element to the first thermoelectric conversion element, the first output unit being a positive electrode, the second output unit being a negative electrode; and bringing current to the exterior as an electric signal, the current flowing from the fourth thermoelectric conversion element to the third thermoelectric conversion element, the third output unit being a positive electrode, the fourth output unit being a negative electrode; and
obtaining one kind of electric signal or a plurality of kinds of electric signals from the electric signal.

The above-mentioned electric signal detecting device includes at least two thermoelectric generation devices of the first mode to the fifth mode, and may obtain current obtained from each thermoelectric generation device as an electric signal. Specifically, the electric signal detecting device may employ the following ten modes

(01) including at least one thermoelectric generation device of the first mode and at least one thermoelectric generation device of the second mode,
(02) including at least one thermoelectric generation device of the first mode and at least one thermoelectric generation device of the third mode,

(03) including at least one thermoelectric generation device of the first mode and at least one thermoelectric generation device of the fourth mode,

(04) including at least one thermoelectric generation device of the first mode and at least one thermoelectric generation device of the fifth mode,

(05) including at least one thermoelectric generation device of the second mode and at least one thermoelectric generation device of the third mode,

(06) including at least one thermoelectric generation device of the second mode and at least one thermoelectric generation device of the fourth mode,

(07) including at least one thermoelectric generation device of the second mode and at least one thermoelectric generation device of the fifth mode,

(08) including at least one thermoelectric generation device of the third mode and at least one thermoelectric generation device of the fourth mode,

(09) including at least one thermoelectric generation device of the third mode and at least one thermoelectric generation device of the fifth mode, and

(10) including at least one thermoelectric generation device of the fourth mode, and at least one thermoelectric generation device of the fifth mode. The electric signal detecting device may be one of ten combinations of three kinds, e.g., three thermoelectric generation devices, one of five combinations of four kinds, e.g., four thermoelectric generation devices, or one combination of five kinds, e.g., five thermoelectric generation devices, selected from the thermoelectric generation devices of (the first mode, the second mode, the third mode, the fourth mode, and the fifth mode).

As described above, according to the electric signal detecting method of the first mode to the fifth mode, one kind of electric signal or a plurality of kinds of electric signals is/are obtained from one kind of electric signal. Further, according to the electric signal detecting device of the present invention, one electric signal detecting device obtains one kind of electric signal or a plurality of kinds of electric signals from one kind of electric signal. Further, the electric signal detecting device itself also functions as a power generation device. As a result, the electric signal detecting device may be downsized, may be made simple, and may always perform monitoring. Further, electric power of the entire system may be saved.

The present invention has been described above based on the preferable examples, and the present invention is not limited to those examples. The configurations and the structure of thermoelectric generation devices of the examples, and the various materials, the size, and the like used in the examples are shown as examples, and may be appropriately changed. In Example 1 to Example 3, if a capacitor or a secondary battery, of which leakage current value is determined, is connected to the output unit of the thermoelectric generation circuit 50, the capacitor or the secondary battery functions as a kind of filter, and the value of current output from the capacitor or the secondary battery may be determined.

For example, the first thermoelectric conversion member, the third thermoelectric conversion member, the first-A thermoelectric conversion member, the second-A thermoelectric conversion member, the third-A thermoelectric conversion member, or the fourth-A thermoelectric conversion member may be made from $Mg_2Si$, $SrTiO_3$, $MnSi_2$, a Si-Ge series material, $\beta$-$FeSi_2$, a PbTe series material, a ZnSb series material, a CoSb series material, a Si series material, a clathrate compound, $NaCo_2O_4$, $Ca_3Co_4O_9$, a chromel alloy, or the like, instead of p-type bismuth tellurium antimony. The second thermoelectric conversion member, the fourth thermoelectric conversion member, the first-B thermoelectric conversion member, the second-B thermoelectric conversion member, the third-B thermoelectric conversion member, or the fourth-B thermoelectric conversion member may be made from $Mg_2Si$, $SrTiO_3$, $MnSi_2$, a Si-Ge series material, $\beta$-$FeSi_2$, a PbTe series material, a ZnSb series material, a CoSb series material, a Si series material, a clathrate compound, constantan, an alumel alloy, or the like, instead of n-type bismuth tellurium. Further, the structure of the first thermoelectric conversion element or the second thermoelectric conversion element of Example 13 may apply to the thermoelectric conversion element of Example 6. Further, the structure and the configuration of the thermoelectric conversion element of Example 7 may apply to the thermoelectric conversion element of Example 11 to Example 12.

For example, in the thermoelectric generation device of the first mode to the fifth mode, if a third support member is mounted on the second support member by using a flexible heat-conductive elastic material (for example, silicone rubber), the constant in thermal response $\tau$ of all the second support member, the elastic material, and the third support member changes because of flexibility of the elastic material. As a result, the extracted electric signal changes, whereby it is possible to detect movement of the third support member with respect to the second support member. Specifically, for example, if the first support member, the second support member, and the like are mounted on a predetermined portion of the arm member, and the third support member is mounted on another portion of the arm member, it is possible to detect change of the position relation between the predetermined position of the arm member and the other position of the arm member (for example, state where arm member is bent and state where arm member is extended). Further, in a case where the electric signal detecting device of the present invention is mounted on a machine or a building, when the temperature of the machine or the building is changed periodically, it is possible to know that a certain abnormality is generated if an electric signal different from an electric signal based on the periodic temperature change is detected. This detecting method may be used in place of, for example, a method of knocking a machine or a building with a hammer, and knowing abnormality based on the generated sound.

Description of Symbols

10 thermoelectric generation device
11, 211 first support member
12, 212 second support member
213 bonding member
21A, 21B, 21D, 21E, 21F, 121H, 121J first thermoelectric conversion member
22A, 22B, 22D, 22E, 22F, 122H, 122J second thermoelectric conversion member
23A, 23B, 23D, 23E, 23F, 123H, 123J third thermoelectric conversion member
24A, 24B, 24D, 24E, 24F, 124H, 124J fourth thermoelectric conversion member
$121G_A$, $121H_A$, $121J_A$, $221C_A$ first-A thermoelectric conversion member
$121G_B$, $121H_B$, $121J_B$, $221C_B$ first-B thermoelectric conversion member
$122G_A$, $122H_A$, $122J_A$, $222C_A$ second-A thermoelectric conversion member
$122G_B$, $122H_B$, $122J_B$, $222C_B$ second-B thermoelectric conversion member
$123G_A$, $123H_A$, $123J_A$ third-A thermoelectric conversion member
$123G_B$, $123H_B$, $123J_B$ third-B thermoelectric conversion member
$124G_A$, $124H_A$, $124J_A$ fourth-A thermoelectric conversion member
$1234_B$, $124H_B$, $124J_B$ fourth-B thermoelectric conversion member
121C, 121G, 121G, 121H, 121J, 221C first thermoelectric conversion element
122C, 122G, 122G, 122H, 122J, 222C second thermoelectric conversion element
123G, 123H, 123J third thermoelectric conversion element
124G, 124H, 124J fourth thermoelectric conversion element
31, 31A, 31B, 32, 32A, 32B, 231, 232 wiring
41, 141, 241 first output unit
42, 142, 242 second output unit
43, 143 third output unit
44, 144 fourth output unit
50 thermoelectric generation circuit
51 rectifier
52 DC/DCboost converter
53 charge-discharge control circuit
54 secondary battery
60 temperature control device
61 frequency control circuit
62 temperature adjusting device
64 output controller
70 electronic tag
71 book management device

**Claims**

1.  A wireless power supply system, comprising:

    (A) a thermoelectric generation device (10) configured to be arranged in an atmosphere within a space of a room as a receiver side, the thermoelectric generation device (10) is configured to generate thermoelectricity in response to temperature change of the atmosphere of the room; and the system is **characterized in that** it also comprises:
    (B) a temperature control device (60) configured to be arranged away from the thermoelectric generation device (10) as a transmission side, the temperature control device (60) is configured to cause a periodical change of the temperature to the atmosphere of the room,

wherein the temperature control device (60) is configured to set a pattern of an amplitude and a cycle of the periodical change.

2. The wireless power supply system according to claim 1, comprising:

a plurality of thermoelectric generation devices (10), wherein
thermal response characteristics of the thermoelectric generation devices (10) are the same.

3. The wireless power supply system according to claim 1, comprising:

a plurality of thermoelectric generation devices (10), wherein
thermal response characteristics of the thermoelectric generation devices (10) are different from each other, and the temperature control device (60) is configured to periodically change the temperature of an atmosphere in sequence based on temperature change corresponding to thermoelectric generation devices (10), thermal response characteristics of the thermoelectric generation devices (10) being different from each other.

4. The wireless power supply system according to claim 1, comprising:

a plurality of thermoelectric generation devices (10), wherein
thermal response characteristics of the thermoelectric generation devices (10) are different from each other, and the temperature control device (60) is configured to periodically change temperature of an atmosphere in sequence based on synthesized temperature change corresponding to thermoelectric generation devices (10), thermal response characteristics of the thermoelectric generation devices (10) being different from each other.

5. The wireless power supply system according to any one of claim 1 to claim 4, wherein
the thermoelectric generation device includes

(A) a first support member (11),
(B) a second support member (12) facing the first support member (11),
(C) a thermoelectric conversion element arranged between the first support member (11) and the second support member (12), and
(D) a first output unit (41) and a second output unit (42) connected to the thermoelectric conversion element, the thermoelectric conversion element includes
(C-1) a first thermoelectric conversion member (21A) arranged between the first support member (11) and the second support member (12), and
(C-2) a second thermoelectric conversion member (22A) arranged between the first support member (11) and the second support member (12), a material of the second thermoelectric conversion member (22A) being different from a material of the first thermoelectric conversion member (21A), the second thermoelectric conversion member (22A) being electrically connected to the first thermoelectric conversion member (21A) in series, the first output unit (41) is connected to an end of the first thermoelectric conversion member (21A), the end being at the first support member side,
the second output unit (42) is connected to an end of the second thermoelectric conversion member (22A), the end being at the first support member side, and
$\tau_{SM1} > \tau_{SM2}$ and
$S_{12} \neq S_{22}$ are satisfied
where the area of a first surface of the first thermoelectric conversion member (21A) is $S_{11}$, the first surface being on the first support member (11), the area of a second surface of the first thermoelectric conversion member (21A) is $S_{12}$ (where $S_{11} > S_{12}$), the second surface being on the second support member (12), the area of a first surface of the second thermoelectric conversion member (22A) is $S_{21}$, the first surface being on the first support member (11), the area of a second surface of the second thermoelectric conversion member (22A) is $S_{22}$ (where $S_{21} > S_{22}$), the second surface being on the second support member (12), a thermal time constant of the first support member (11) is $\tau_{SM1}$, and a thermal time constant of the second support member (12) is $\tau_{SM2}$.

6. The wireless power supply system according to any one of claim 1 to claim 4, wherein
the thermoelectric generation device (10) includes

(A) a first support member (11),
(B) a second support member (12) facing the first support member (11),

(C) a thermoelectric conversion element arranged between the first support member (11) and the second support member (12), and

(D) a first output unit and a second output unit connected to the thermoelectric conversion element, the thermoelectric conversion element includes

(C-1) a first thermoelectric conversion member (21B) arranged between the first support member (11) and the second support member (12), and

(C-2) a second thermoelectric conversion member (22B) arranged between the first support member (11) and the second support member (12), a material of the second thermoelectric conversion member (22B) being different from a material of the first thermoelectric conversion member (21B), the second thermoelectric conversion member (22B) being electrically connected to the first thermoelectric conversion member (21B) in series, the first output unit (41) is connected to an end of the first thermoelectric conversion member (21B), the end being at the first support member side,

the second output unit (42) is connected to an end of the second thermoelectric conversion member (22B), the end being at the first support member side, and

$\tau_{SM1} > \tau_{SM2}$ and
$VL_1 \neq VL_2$ are satisfied

where the volume of the first thermoelectric conversion member (21B) is $VL_1$, the volume of the second thermoelectric conversion member (22B) is $VL_2$, a thermal time constant of the first support member (11) is $\tau_{SM1}$, and a thermal time constant of the second support member (12) is $\tau_{SM2}$.

7.  The wireless power supply system according to any one of claim 1 to claim 4, wherein
    the thermoelectric generation device (10) includes

    (A) a first support member (11),
    (B) a second support member (12) facing the first support member (11),
    (C) a first thermoelectric conversion element (121C) arranged between the first support member (11) and the second support member (12),
    (D) a second thermoelectric conversion element (122C) arranged between the first support member (11) and the second support member (12), and
    (E) a first output unit (41) and a second output unit (42),

    the first thermoelectric conversion element (121C) includes a first-A thermoelectric conversion member (121CA) of an A-type on the second support member (12) and a first-B thermoelectric conversion member (121CB) of a B-type on the first support member (11), the first-A thermoelectric conversion member (121CA) being on the first-B thermoelectric conversion member (121CB),
    the second thermoelectric conversion element (122C) includes a second-A thermoelectric conversion member (122CA) of the A-type on the first support member (11) and a second-B thermoelectric conversion member (122CB) of the B-type on the second support member (12), the second-A thermoelectric conversion member (122CA) being on the second-B thermoelectric conversion member (122CB),
    the first thermoelectric conversion element (121C) and the second thermoelectric conversion element (122C) are electrically connected in series,
    the first output unit (41) is connected to an end of the first-B thermoelectric conversion member (121CB),
    the second output unit (42) is connected to an end of the second-A thermoelectric conversion member (122CA), and
    $\tau_{SM1} \neq \tau_{SM2}$ is satisfied
    where a thermal time constant of the first support member (11) is $\tau_{SM1}$, and a thermal time constant of the second support member (12) is $\tau_{SM2}$.

8.  The wireless power supply system according to any one of claim 1 to claim 4, wherein
    the thermoelectric generation device includes

    (A) a first support member (11),
    (B) a second support member (12) facing the first support member (11),
    (C) a first thermoelectric conversion element arranged between the first support member (11) and the second support member (12),
    (D) a second thermoelectric conversion element arranged between the first support member (11) and the second support member (12), and
    (E) a first output unit (41), a second output unit (42), a third output unit (43), and a fourth output unit (44),
    the first thermoelectric conversion element includes

(C-1) a first thermoelectric conversion member (21D) arranged between the first support member (11) and the second support member (12), and

(C-2) a second thermoelectric conversion member (22D) arranged between the first support member (11) and the second support member (12), a material of the second thermoelectric conversion member (22D) being different from a material of the first thermoelectric conversion member (21D), the second thermoelectric conversion member (22D) being electrically connected to the first thermoelectric conversion member (21D) in series, the second thermoelectric conversion element includes

(D-1) a third thermoelectric conversion member (23D) arranged between the first support member (11) and the second support member (12), and

(D-2) a fourth thermoelectric conversion member (24D) arranged between the first support member (11) and the second support member (12), a material of the fourth thermoelectric conversion member (24D) being different from a material of the third thermoelectric conversion member (23D), the fourth thermoelectric conversion member (24D) being electrically connected to the third thermoelectric conversion member (23D) in series, the first output unit (41) is connected to the first thermoelectric conversion member (21D),

the second output unit (42) is connected to the second thermoelectric conversion member (22D),

the third output unit (43) is connected to the third thermoelectric conversion member (23D),

the fourth output unit (44) is connected to the fourth thermoelectric conversion member (24D), and

$\tau_{SM1} \neq \tau_{SM2}$ is satisfied

where a thermal time constant of the first support member (11) is $\tau_{SM1}$, and a thermal time constant of the second support member (12) is $\tau_{SM2}$.

9. The wireless power supply system according to any one of claim 1 to claim 4, wherein the thermoelectric generation device (10) includes

(A) a first support member (11),

(B) a second support member (12) facing the first support member (11),

(C) a first thermoelectric conversion element (121G) arranged between the first support member (11) and the second support member (12),

(D) a second thermoelectric conversion element (122G) arranged between the first support member (11) and the second support member (12),

(E) a third thermoelectric conversion element (123G) arranged between the first support member (11) and the second support member (12),

(F) a fourth thermoelectric conversion element (124G) arranged between the first support member (11) and the second support member (12), and

(G) a first output unit (41), a second output unit (42), a third output unit (43), and a fourth output unit (44),

the first thermoelectric conversion element (121G) includes a first-A thermoelectric conversion member (121GA) of an A-type on the second support member (12) and a first-B thermoelectric conversion member (121GB) of a B-type on the first support member (11), the first-A thermoelectric conversion member (121GA) being on the first-B thermoelectric conversion member (121GB),

the second thermoelectric conversion element (122G) includes a second-A thermoelectric conversion member (122GA) of the A-type on the first support member (11) and a second-B thermoelectric conversion member (122GB) of the B-type on the second support member (12), the second-A thermoelectric conversion member (122GA) being on the second-B thermoelectric conversion member (122GB),

the third thermoelectric conversion element (123G) includes a third-A thermoelectric conversion member (123GA) of the A-type on the second support member (12) and a third-B thermoelectric conversion member (123GB) of the B-type on the first support member (11), the third-A thermoelectric conversion member (123GA) being on the third-B thermoelectric conversion member (123GB),

the fourth thermoelectric conversion element (124G) includes a fourth-A thermoelectric conversion member (124GA) of the A-type on the first support member (11) and a fourth-B thermoelectric conversion member (124GB) of the B-type on the second support member (12), the fourth-A thermoelectric conversion member (124GA) being on the fourth-B thermoelectric conversion member (124GB),

the first thermoelectric conversion element (121G) and the second thermoelectric conversion element (122G) are electrically connected in series,

the third thermoelectric conversion element (123G) and the fourth thermoelectric conversion element (124G) are electrically connected in series,

the first output unit (41) is connected to the first thermoelectric conversion element (121G),

the second output unit (42) is connected to the second thermoelectric conversion element (122G),

the third output unit (43) is connected to the third thermoelectric conversion element (123G),
the fourth output unit (44) is connected to the fourth thermoelectric conversion element (124G), and
$\tau_{SM1} \neq \tau_{SM2}$ is satisfied
where a thermal time constant of the first support member (11) is $\tau_{SM1}$, and a thermal time constant of the second support member (12) is $\tau_{SM2}$.

10. A wireless power supply method using a wireless power supply system, the wireless power supply system including a thermoelectric generation device (10) arranged in an atmosphere within a space of a room as a receiver side and a temperature control device (60) arranged away from a thermoelectric generation device (10) as a transmission side, the wireless power supply method comprising:

setting, by the temperature control device (60), a pattern of an amplitude and a cycle of a periodical change the temperature;
causing, by the temperature control device (60), the periodical change of the temperature to the atmosphere of the room with the pattern;
generating, by the thermoelectric generation device (10), thermoelectricity in response to temperature change of the atmosphere of the room;
and bringing the obtained electric power to the exterior.

11. The wireless power supply method according to claim 10, wherein
the wireless power supply system includes a plurality of thermoelectric generation devices (10), and
thermal response characteristics of the thermoelectric generation devices (10) are the same.

12. The wireless power supply method according to claim 10, wherein
the wireless power supply system includes a plurality of thermoelectric generation devices,
thermal response characteristics of the thermoelectric generation devices (10) are different from each other, and
the wireless power supply method comprises periodically changing, by the temperature control device (60), the temperature of an atmosphere in sequence based on temperature change corresponding to thermoelectric generation devices (10), thermal response characteristics of the thermoelectric generation devices (10) being different from each other.

13. The wireless power supply method according to claim 10, wherein
the wireless power supply system includes a plurality of thermoelectric generation devices,
thermal response characteristics of the thermoelectric generation devices (10) are different from each other, and
the wireless power supply method comprises periodically changing, by the temperature control device (60), the temperature of an atmosphere in sequence based on synthesized temperature change corresponding to thermoelectric generation devices (10), thermal response characteristics of the thermoelectric generation devices (10) being different from each other.

14. The wireless power supply method according to any one of claim 10 to claim 13, wherein
the thermoelectric generation device (10) includes

(A) a first support member (11),
(B) a second support member (12) facing the first support member (11),
(C) a thermoelectric conversion element arranged between the first support member (11) and the second support member (12), and
(D) a first output unit (41) and a second output unit (42) connected to the thermoelectric conversion element,
the thermoelectric conversion element includes
(C-1) a first thermoelectric conversion member (21A) arranged between the first support member (11) and the second support member (12), and
(C-2) a second thermoelectric conversion member (22A) arranged between the first support member (11) and the second support member (12), a material of the second thermoelectric conversion member (22A) being different from a material of the first thermoelectric conversion member (21A), the second thermoelectric conversion member (22A) being electrically connected to the first thermoelectric conversion member (21A) in series,
the first output unit (41) is connected to an end of the first thermoelectric conversion member (21A), the end being at the first support member side,
the second output unit (42) is connected to an end of the second thermoelectric conversion member (22A), the end being at the first support member side,

$\tau_{SM1} > \tau_{SM2}$ and
$S_{12} \neq S_{22}$ are satisfied
where the area of a first surface of the first thermoelectric conversion member (21A) is $S_{11}$, the first surface being on the first support member (11), the area of a second surface of the first thermoelectric conversion member (21A) is $S_{12}$ (where $S_{11} > S_{12}$), the second surface being on the second support member (12), the area of a first surface of the second thermoelectric conversion member (22A) is $S_{21}$, the first surface being on the first support member (11), the area of a second surface of the second thermoelectric conversion member (22A) is $S_{22}$ (where $S_{21} > S_{22}$), the second surface being on the second support member (12), a thermal time constant of the first support member (11) is $\tau_{SM1}$, and a thermal time constant of the second support member (12) is $\tau_{SM2}$, and
the wireless power supply method comprises:

arranging the thermoelectric generation device in an atmosphere, the atmospheric temperature changing; and

bringing current to the exterior, the current being generated due to temperature difference between the first support member (11) and the second support member (12) when the temperature of the second support member (12) is higher than the temperature of the first support member (11), the current flowing from the second thermoelectric conversion member (22A) to the first thermoelectric conversion member (21A), the first output unit (41) being a positive electrode, the second output unit (42) being a negative electrode.

15. The wireless power supply method according to any one of claim 10 to claim 13, wherein
the thermoelectric generation device (10) includes

(A) a first support member (11),
(B) a second support member (12) facing the first support member (11),
(C) a thermoelectric conversion element arranged between the first support member (11) and the second support member (12), and
(D) a first output unit (41) and a second output unit (42) connected to the thermoelectric conversion element,
the thermoelectric conversion element includes
(C-1) a first thermoelectric conversion member (21B) arranged between the first support member (11) and the second support member (12), and
(C-2) a second thermoelectric conversion member (22B) arranged between the first support member (11) and the second support member (12), a material of the second thermoelectric conversion member (22B) being different from a material of the first thermoelectric conversion member (21B), the second thermoelectric conversion member (22B) being electrically connected to the first thermoelectric conversion member (21B) in series,
the first output unit (41) is connected to an end of the first thermoelectric conversion member (21B), the end being at the first support member side,
the second output unit (42) is connected to an end of the second thermoelectric conversion member (22B), the end being at the first support member side,
$\tau_{SM1} > \tau_{SM2}$ and
$VL_1 \neq VL_2$ are satisfied
where the volume of the first thermoelectric conversion member (21B) is $VL_1$, the volume of the second thermoelectric conversion member (22B) is $VL_2$, a thermal time constant of the first support member (11) is $\tau_{SM1}$, and a thermal time constant of the second support member (12) is $\tau_{SM2}$, and
the wireless power supply method comprises:

arranging the thermoelectric generation device in an atmosphere, the atmospheric temperature changing; and

bringing current to the exterior, the current being generated due to temperature difference between the first support member (11) and the second support member (12) when the temperature of the second support member (12) is higher than the temperature of the first support member (11), the current flowing from the second thermoelectric conversion member (22B) to the first thermoelectric conversion member (21B), the first output unit (41) being a positive electrode, the second output unit (42) being a negative electrode.

**Patentansprüche**

1. Drahtloses Energieversorgungssystem, das aufweist:

(A) eine thermoelektrische Erzeugungsvorrichtung (10), die dazu ausgebildet ist, in einer Umgebung innerhalb eines Raumbereichs als eine Empfängerseite angeordnet zu sein, wobei die thermoelektrische Erzeugungsvorrichtung (10) dazu ausgebildet ist, Thermoelektrizität als Reaktion auf eine Temperaturänderung der Umgebung des Raumes zu erzeugen; und wobei das System **dadurch gekennzeichnet ist, dass** es auch aufweist:
(B) eine Temperatursteuervorrichtung (60), die dazu ausgebildet ist, als eine Übertragungsseite entfernt von der thermoelektrischen Erzeugungsvorrichtung (10) angeordnet zu sein, wobei die Temperatursteuervorrichtung (60) dazu ausgebildet ist, eine periodische Änderung der Temperatur an der Umgebung des Raumes zu bewirken,
wobei die Temperatursteuervorrichtung (60) dazu ausgebildet ist, ein Muster einer Amplitude und eines Zyklus der periodischen Änderung einzustellen.

2. Drahtloses Energieversorgungssystem nach Anspruch 1, das aufweist:

   eine Mehrzahl von thermoelektrischen Erzeugungsvorrichtungen (10), wobei
   thermische Ansprecheigenschaften der thermoelektrischen Erzeugungsvorrichtungen (10) die gleichen sind.

3. Drahtloses Energieversorgungssystem nach Anspruch 1, das aufweist:

   eine Mehrzahl von thermoelektrischen Erzeugungsvorrichtungen (10), wobei
   thermische Ansprecheigenschaften der thermoelektrischen Erzeugungsvorrichtungen (10) sich voneinander unterscheiden und
   die Temperatursteuervorrichtung (60) dazu ausgebildet ist, die Temperatur einer Umgebung nacheinander auf Grundlage einer Temperaturänderung entsprechend thermoelektrischen Erzeugungsvorrichtungen (10) periodisch zu ändern, wobei sich thermische Ansprecheigenschaften der thermoelektrischen Erzeugungsvorrichtungen (10) voneinander unterscheiden.

4. Drahtloses Energieversorgungssystem nach Anspruch 1, das aufweist:

   eine Mehrzahl von thermoelektrischen Erzeugungsvorrichtungen (10), wobei
   thermische Ansprecheigenschaften der thermoelektrischen Erzeugungsvorrichtungen (10) sich voneinander unterscheiden und
   die Temperatursteuervorrichtung (60) dazu ausgebildet ist, eine Temperatur einer Umgebung nacheinander auf Grundlage einer synthetisierten Temperaturänderung entsprechend thermoelektrischen Erzeugungsvorrichtungen (10) periodisch zu ändern, wobei sich thermische Ansprecheigenschaften der thermoelektrischen Erzeugungsvorrichtungen (10) voneinander unterscheiden.

5. Drahtloses Energieversorgungssystem nach einem der Ansprüche 1 bis 4, wobei
   die thermoelektrische Erzeugungsvorrichtung beinhaltet:

   (A) ein erstes Stützelement (11),
   (B) ein zweites Stützelement (12), das dem ersten Stützelement (11) zugewandt ist,
   (C) ein thermoelektrisches Umwandlungselement, das zwischen dem ersten Stützelement (11) und dem zweiten Stützelement (12) angeordnet ist, und
   (D) eine erste Ausgabeeinheit (41) und eine zweite Ausgabeeinheit (42), die mit dem thermoelektrischen Umwandlungselement verbunden sind,

   das thermoelektrische Umwandlungselement beinhaltet:

   (C-1) ein erstes thermoelektrisches Umwandlungselement (21A), das zwischen dem ersten Stützelement (11) und dem zweiten Stützelement (12) angeordnet ist, und
   (C-2) ein zweites thermoelektrisches Umwandlungselement (22A), das zwischen dem ersten Stützelement (11) und dem zweiten Stützelement (12) angeordnet ist, wobei sich ein Material des zweiten thermoelektrischen Umwandlungselements (22A) von einem Material des ersten thermoelektrischen Umwandlungselements (21A) unterscheidet, wobei das zweite thermoelektrische Umwandlungselement (22A) mit dem ersten thermoelektrischen Umwandlungselement (21A) elektrisch in Reihe geschaltet ist,
   die erste Ausgabeeinheit (41) mit einem Ende des ersten thermoelektrischen Umwandlungselements (21A) verbunden ist, wobei sich das Ende an der Seite des ersten Stützelements befindet,
   die zweite Ausgabeeinheit (42) mit einem Ende des zweiten thermoelektrischen Umwandlungselements (22A) verbunden ist, wobei sich das Ende an der Seite des ersten Stützelements befindet, und

$\tau_{SM1} > \tau_{SM2}$ sowie
$S_{12} \neq S_{22}$ erfüllt sind,
wobei die Fläche einer ersten Oberfläche des ersten thermoelektrischen Umwandlungselements (21A) $S_{11}$ ist, wobei die erste Oberfläche auf dem ersten Stützelement (11) ist, die Fläche einer zweiten Oberfläche des ersten thermoelektrischen Umwandlungselements (21A) $S_{12}$ ist (wobei $S_{11} > S_{12}$ gilt), wobei die zweite Oberfläche auf dem zweiten Stützelement (12) ist, die Fläche einer ersten Oberfläche des zweiten thermoelektrischen Umwandlungselements (22A) $S_{21}$ ist, wobei die erste Oberfläche auf dem ersten Stützelement (11) ist, die Fläche einer zweiten Oberfläche des zweiten thermoelektrischen Umwandlungselements (22A) $S_{22}$ ist (wobei $S_{21} > S_{22}$ gilt), wobei die zweite Oberfläche auf dem zweiten Stützelement (12) ist, eine thermische Zeitkonstante des ersten Stützelements (11) $\tau_{SM1}$ ist und eine thermische Zeitkonstante des zweiten Stützelements (12) $\tau_{SM2}$ ist.

6. Drahtloses Energieversorgungssystem nach einem der Ansprüche 1 bis 4, wobei die thermoelektrische Erzeugungsvorrichtung (10) beinhaltet:

(A) ein erstes Stützelement (11),
(B) ein zweites Stützelement (12), das dem ersten Stützelement (11) zugewandt ist,
(C) ein thermoelektrisches Umwandlungselement, das zwischen dem ersten Stützelement (11) und dem zweiten Stützelement (12) angeordnet ist, und
(D) eine erste Ausgabeeinheit und eine zweite Ausgabeeinheit, die mit dem thermoelektrischen Umwandlungselement verbunden sind,

das thermoelektrische Umwandlungselement beinhaltet:

(C-1) ein erstes thermoelektrisches Umwandlungselement (21B), das zwischen dem ersten Stützelement (11) und dem zweiten Stützelement (12) angeordnet ist, und
(C-2) ein zweites thermoelektrisches Umwandlungselement (22B), das zwischen dem ersten Stützelement (11) und dem zweiten Stützelement (12) angeordnet ist, wobei sich ein Material des zweiten thermoelektrischen Umwandlungselements (22B) von einem Material des ersten thermoelektrischen Umwandlungselements (21B) unterscheidet, wobei das zweite thermoelektrische Umwandlungselement (22B) mit dem ersten thermoelektrischen Umwandlungselement (21B) elektrisch in Reihe geschaltet ist,
die erste Ausgabeeinheit (41) mit einem Ende des ersten thermoelektrischen Umwandlungselements (21B) verbunden ist, wobei sich das Ende an der Seite des ersten Stützelements befindet,
die zweite Ausgabeeinheit (42) mit einem Ende des zweiten thermoelektrischen Umwandlungselements (22B) verbunden ist, wobei sich das Ende an der Seite des ersten Stützelements befindet, und
$\tau_{SM1} > \tau_{SM2}$ sowie
$VL_1 \neq VL_2$ erfüllt sind,
wobei das Volumen des ersten thermoelektrischen Umwandlungselements (21B) $VL_1$ ist, das Volumen des zweiten thermoelektrischen Umwandlungselements (22B) $VL_2$ ist, eine thermische Zeitkonstante des ersten Stützelements (11) $\tau_{SM1}$ ist und eine thermische Zeitkonstante des zweiten Stützelements (12) $\tau_{SM2}$ ist.

7. Drahtloses Energieversorgungssystem nach einem der Ansprüche 1 bis 4, wobei die thermoelektrische Erzeugungsvorrichtung (10) beinhaltet:

(A) ein erstes Stützelement (11),
(B) ein zweites Stützelement (12), das dem ersten Stützelement (11) zugewandt ist,
(C) ein erstes thermoelektrisches Umwandlungselement (121C), das zwischen dem ersten Stützelement (11) und dem zweiten Stützelement (12) angeordnet ist,
(D) ein zweites thermoelektrisches Umwandlungselement (122C), das zwischen dem ersten Stützelement (11) und dem zweiten Stützelement (12) angeordnet ist, und
(E) eine erste Ausgabeeinheit (41) und eine zweite Ausgabeeinheit (42),

das erste thermoelektrische Umwandlungselement (121C) ein A-erstes thermoelektrisches Umwandlungselement (121CA) eines A-Typs auf dem zweiten Stützelement (12) und ein B-erstes thermoelektrisches Umwandlungselement (121CB) eines B-Typs auf dem ersten Stützelement (11) beinhaltet, wobei das A-erste thermoelektrische Umwandlungselement (121CA) auf dem B-ersten thermoelektrischen Umwandlungselement (121CB) angeordnet ist,

das zweite thermoelektrische Umwandlungselement (122C) ein A-zweites thermoelektrisches Umwandlungselement (122CA) des A-Typs auf dem ersten Stützelement (11) und ein B-zweites thermoelektrisches Umwandlungselement (122CB) des B-Typs auf dem zweiten Stützelement (12) beinhaltet, wobei das A-zweite thermoelektrische Umwandlungselement (122CA) auf dem B-zweiten thermoelektrischen Umwandlungselement (122CB) angeordnet ist,

das erste thermoelektrische Umwandlungselement (121C) und das zweite thermoelektrische Umwandlungselement (122C) elektrisch in Reihe geschaltet sind,

die erste Ausgabeeinheit (41) mit einem Ende des B-ersten thermoelektrischen Umwandlungselements (121CB) verbunden ist,

die zweite Ausgabeeinheit (42) mit einem Ende des A-zweiten thermoelektrischen Umwandlungselements (122CA) verbunden ist und

$\tau_{SM1} \neq \tau_{SM2}$ erfüllt ist,

wobei eine thermische Zeitkonstante des ersten Stützelements (11) $\tau_{SM1}$ ist und eine thermische Zeitkonstante des zweiten Stützelements (12) $\tau_{SM2}$ ist.

8.  Drahtloses Energieversorgungssystem nach einem der Ansprüche 1 bis 4, wobei
    die thermoelektrische Erzeugungsvorrichtung beinhaltet:

    (A) ein erstes Stützelement (11),
    (B) ein zweites Stützelement (12), das dem ersten Stützelement (11) zugewandt ist,
    (C) ein erstes thermoelektrisches Umwandlungselement, das zwischen dem ersten Stützelement (11) und dem zweiten Stützelement (12) angeordnet ist,
    (D) ein zweites thermoelektrisches Umwandlungselement, das zwischen dem ersten Stützelement (11) und dem zweiten Stützelement (12) angeordnet ist, und
    (E) eine erste Ausgabeeinheit (41), eine zweite Ausgabeeinheit (42), eine dritte Ausgabeeinheit (43) und eine vierte Ausgabeeinheit (44),

    das erste thermoelektrische Umwandlungselement beinhaltet:

    (C-1) ein erstes thermoelektrisches Umwandlungselement (21D), das zwischen dem ersten Stützelement (11) und dem zweiten Stützelement (12) angeordnet ist, und
    (C-2) ein zweites thermoelektrisches Umwandlungselement (22D), das zwischen dem ersten Stützelement (11) und dem zweiten Stützelement (12) angeordnet ist, wobei sich ein Material des zweiten thermoelektrischen Umwandlungselements (22D) von einem Material des ersten thermoelektrischen Umwandlungselements (21D) unterscheidet, wobei das zweite thermoelektrische Umwandlungselement (22D) mit dem ersten thermoelektrischen Umwandlungselement (21D) elektrisch in Reihe geschaltet ist,

    das zweite thermoelektrische Umwandlungselement beinhaltet:

    (D-1) ein drittes thermoelektrisches Umwandlungselement (23D), das zwischen dem ersten Stützelement (11) und dem zweiten Stützelement (12) angeordnet ist, und
    (D-2) ein viertes thermoelektrisches Umwandlungselement (24D), das zwischen dem ersten Stützelement (11) und dem zweiten Stützelement (12) angeordnet ist, wobei sich ein Material des vierten thermoelektrischen Umwandlungselements (24D) von einem Material des dritten thermoelektrischen Umwandlungselements (23D) unterscheidet, wobei das vierte thermoelektrische Umwandlungselement (24D) mit dem dritten thermoelektrischen Umwandlungselement (23D) elektrisch in Reihe geschaltet ist,
    die erste Ausgabeeinheit (41) mit dem ersten thermoelektrischen Umwandlungselement (21D) verbunden ist,
    die zweite Ausgabeeinheit (42) mit dem zweiten thermoelektrischen Umwandlungselement (22D) verbunden ist,
    die dritte Ausgabeeinheit (43) mit dem dritten thermoelektrischen Umwandlungselement (23D) verbunden ist,
    die vierte Ausgabeeinheit (44) mit dem vierten thermoelektrischen Umwandlungselement (24D) verbunden ist und
    $\tau_{SM1} \neq \tau_{SM2}$ erfüllt ist,
    wobei eine thermische Zeitkonstante des ersten Stützelements (11) $\tau_{SM1}$ ist und eine thermische Zeitkonstante des zweiten Stützelements (12) $\tau_{SM2}$ ist.

9.  Drahtloses Energieversorgungssystem nach einem der Ansprüche 1 bis 4, wobei
    die thermoelektrische Erzeugungsvorrichtung (10) beinhaltet:

(A) ein erstes Stützelement (11),

(B) ein zweites Stützelement (12), das dem ersten Stützelement (11) zugewandt ist,

(C) ein erstes thermoelektrisches Umwandlungselement (121G), das zwischen dem ersten Stützelement (11) und dem zweiten Stützelement (12) angeordnet ist,

(D) ein zweites thermoelektrisches Umwandlungselement (122G), das zwischen dem ersten Stützelement (11) und dem zweiten Stützelement (12) angeordnet ist,

(E) ein drittes thermoelektrisches Umwandlungselement (123G), das zwischen dem ersten Stützelement (11) und dem zweiten Stützelement (12) angeordnet ist,

(F) ein viertes thermoelektrisches Umwandlungselement (124G), das zwischen dem ersten Stützelement (11) und dem zweiten Stützelement (12) angeordnet ist, und

(G) eine erste Ausgabeeinheit (41), eine zweite Ausgabeeinheit (42), eine dritte Ausgabeeinheit (43) und eine vierte Ausgabeeinheit (44),

das erste thermoelektrische Umwandlungselement (121G) ein A-erstes thermoelektrisches Umwandlungselement (121GA) eines A-Typs auf dem zweiten Stützelement (12) und ein B-erstes thermoelektrisches Umwandlungselement (121GB) eines B-Typs auf dem ersten Stützelement (11) beinhaltet, wobei das A-erste thermoelektrische Umwandlungselement (121GA) auf dem B-ersten thermoelektrischen Umwandlungselement (121GB) angeordnet ist,

das zweite thermoelektrische Umwandlungselement (122G) ein A-zweites thermoelektrisches Umwandlungselement (122GA) des A-Typs auf dem ersten Stützelement (11) und ein B-zweites thermoelektrisches Umwandlungselement (122GB) des B-Typs auf dem zweiten Stützelement (12) beinhaltet, wobei das A-zweite thermoelektrische Umwandlungselement (122GA) auf dem B-zweiten thermoelektrischen Umwandlungselement (122GB) angeordnet ist,

das dritte thermoelektrische Umwandlungselement (123G) ein A-drittes thermoelektrisches Umwandlungselement (123GA) des A-Typs auf dem zweiten Stützelement (12) und ein B-drittes thermoelektrisches Umwandlungselement (123GB) des B-Typs auf dem ersten Stützelement (11) beinhaltet, wobei das A-dritte thermoelektrische Umwandlungselement (123GA) auf dem B-dritten thermoelektrischen Umwandlungselement (123GB) angeordnet ist,

das vierte thermoelektrische Umwandlungselement (124G) ein A-viertes thermoelektrisches Umwandlungselement (124GA) des A-Typs auf dem ersten Stützelement (11) und ein B-viertes thermoelektrisches Umwandlungselement (124GB) des B-Typs auf dem zweiten Stützelement (12) beinhaltet, wobei das A-vierte thermoelektrische Umwandlungselement (124GA) auf dem B-vierten thermoelektrischen Umwandlungselement (124GB) angeordnet ist,

das erste thermoelektrische Umwandlungselement (121G) und das zweite thermoelektrische Umwandlungselement (122G) elektrisch in Reihe geschaltet sind,

das dritte thermoelektrische Umwandlungselement (123G) und das vierte thermoelektrische Umwandlungselement (124G) elektrisch in Reihe geschaltet sind,

die erste Ausgabeeinheit (41) mit dem ersten thermoelektrischen Umwandlungselement (121G) verbunden ist,

die zweite Ausgabeeinheit (42) mit dem zweiten thermoelektrischen Umwandlungselement (122G) verbunden ist,

die dritte Ausgabeeinheit (43) mit dem dritten thermoelektrischen Umwandlungselement (123G) verbunden ist,

die vierte Ausgabeeinheit (44) mit dem vierten thermoelektrischen Umwandlungselement (124G) verbunden ist und

$\tau_{SM1} \neq \tau_{SM2}$ erfüllt ist,

wobei eine thermische Zeitkonstante des ersten Stützelements (11) $\tau_{SM1}$ ist und eine thermische Zeitkonstante des zweiten Stützelements (12) $\tau_{SM2}$ ist.

10. Drahtloses Energieversorgungsverfahren, das ein drahtloses Energieversorgungssystem verwendet, wobei das drahtlose Energieversorgungssystem eine thermoelektrische Erzeugungsvorrichtung (10) beinhaltet, die in einer Umgebung innerhalb eines Raumbereichs als eine Empfängerseite angeordnet ist, sowie eine Temperatursteuervorrichtung (60), die als eine Übertragungsseite entfernt von einer thermoelektrischen Erzeugungsvorrichtung (10) angeordnet ist, wobei das drahtlose Energieversorgungsverfahren umfasst:

das Einstellen eines Musters einer Amplitude und eines Zyklus einer periodischen Änderung der Temperatur durch die Temperatursteuervorrichtung (60);

das Bewirken der periodischen Änderung der Temperatur an der Umgebung des Raumes mit dem Muster durch die Temperatursteuervorrichtung (60);

das Erzeugen von Thermoelektrizität durch die thermoelektrische Erzeugungsvorrichtung (10) als Reaktion auf eine Temperaturänderung der Umgebung des Raumes;

und das Führen der erlangten elektrischen Energie an die Außenseite.

11. Drahtloses Energieversorgungsverfahren nach Anspruch 10, wobei

das drahtlose Energieversorgungssystem eine Mehrzahl von thermoelektrischen Erzeugungsvorrichtungen (10) beinhaltet und

thermische Ansprecheigenschaften der thermoelektrischen Erzeugungsvorrichtungen (10) die gleichen sind.

**12.** Drahtloses Energieversorgungsverfahren nach Anspruch 10, wobei
das drahtlose Energieversorgungssystem eine Mehrzahl von thermoelektrischen Erzeugungsvorrichtungen beinhaltet,
thermische Ansprecheigenschaften der thermoelektrischen Erzeugungsvorrichtungen (10) sich voneinander unterscheiden und
das drahtlose Energieversorgungsverfahren das periodische Ändern der Temperatur einer Umgebung nacheinander auf Grundlage einer Temperaturänderung entsprechend thermoelektrischen Erzeugungsvorrichtungen (10) durch die Temperatursteuervorrichtung (60) umfasst, wobei sich thermische Ansprecheigenschaften der thermoelektrischen Erzeugungsvorrichtungen (10) voneinander unterscheiden.

**13.** Drahtloses Energieversorgungsverfahren nach Anspruch 10, wobei
das drahtlose Energieversorgungssystem eine Mehrzahl von thermoelektrischen Erzeugungsvorrichtungen beinhaltet,
thermische Ansprecheigenschaften der thermoelektrischen Erzeugungsvorrichtungen (10) sich voneinander unterscheiden und
das drahtlose Energieversorgungsverfahren das periodische Ändern der Temperatur einer Umgebung nacheinander auf Grundlage einer synthetisierten Temperaturänderung entsprechend thermoelektrischen Erzeugungsvorrichtungen (10) durch die Temperatursteuervorrichtung (60) umfasst, wobei sich thermische Ansprecheigenschaften der thermoelektrischen Erzeugungsvorrichtungen (10) voneinander unterscheiden.

**14.** Drahtloses Energieversorgungsverfahren nach einem der Ansprüche 10 bis 13, wobei
die thermoelektrische Erzeugungsvorrichtung (10) beinhaltet:

(A) ein erstes Stützelement (11),
(B) ein zweites Stützelement (12), das dem ersten Stützelement (11) zugewandt ist,
(C) ein thermoelektrisches Umwandlungselement, das zwischen dem ersten Stützelement (11) und dem zweiten Stützelement (12) angeordnet ist, und
(D) eine erste Ausgabeeinheit (41) und eine zweite Ausgabeeinheit (42), die mit dem thermoelektrischen Umwandlungselement verbunden sind,

das thermoelektrische Umwandlungselement beinhaltet:

(C-1) ein erstes thermoelektrisches Umwandlungselement (21A), das zwischen dem ersten Stützelement (11) und dem zweiten Stützelement (12) angeordnet ist, und
(C-2) ein zweites thermoelektrisches Umwandlungselement (22A), das zwischen dem ersten Stützelement (11) und dem zweiten Stützelement (12) angeordnet ist, wobei sich ein Material des zweiten thermoelektrischen Umwandlungselements (22A) von einem Material des ersten thermoelektrischen Umwandlungselements (21A) unterscheidet, wobei das zweite thermoelektrische Umwandlungselement (22A) mit dem ersten thermoelektrischen Umwandlungselement (21A) elektrisch in Reihe geschaltet ist,

die erste Ausgabeeinheit (41) mit einem Ende des ersten thermoelektrischen Umwandlungselements (21A) verbunden ist, wobei sich das Ende an der Seite des ersten Stützelements befindet,
die zweite Ausgabeeinheit (42) mit einem Ende des zweiten thermoelektrischen Umwandlungselements (22A) verbunden ist, wobei sich das Ende an der Seite des ersten Stützelements befindet,
$\tau_{SM1} > \tau_{SM2}$ sowie
$S_{12} \neq S_{22}$ erfüllt sind,
wobei die Fläche einer ersten Oberfläche des ersten thermoelektrischen Umwandlungselements (21A) $S_{11}$ ist, wobei die erste Oberfläche auf dem ersten Stützelement (11) ist, die Fläche einer zweiten Oberfläche des ersten thermoelektrischen Umwandlungselements (21A) $S_{12}$ ist (wobei $S_{11} > S_{12}$ gilt), wobei die zweite Oberfläche auf dem zweiten Stützelement (12) ist, die Fläche einer ersten Oberfläche des zweiten thermoelektrischen Umwandlungselements (22A) $S_{21}$ ist, wobei die erste Oberfläche auf dem ersten Stützelement (11) ist, die Fläche einer zweiten Oberfläche des zweiten thermoelektrischen Umwandlungselements (22A) $S_{22}$ ist (wobei $S_{21} > S_{22}$ gilt), wobei die zweite Oberfläche auf dem zweiten Stützelement (12) ist, eine thermische Zeitkonstante des ersten Stützelements (11) $\tau_{SM1}$ ist und eine thermische Zeitkonstante des zweiten Stützelements (12) $\tau_{SM2}$ ist, und

das drahtlose Energieversorgungsverfahren umfasst:

das Anordnen der thermoelektrischen Erzeugungsvorrichtung in einer Umgebung, das Ändern der Umgebungstemperatur; und
das Führen von Strom an die Außenseite, wobei der Strom aufgrund einer Temperaturdifferenz zwischen dem ersten Stützelement (11) und dem zweiten Stützelement (12) erzeugt wird, wenn die Temperatur des zweiten Stützelements (12) höher ist als die Temperatur des ersten Stützelements (11), wobei der Strom von dem zweiten thermoelektrischen Umwandlungselement (22A) zu dem ersten thermoelektrischen Umwandlungselement (21A) fließt, die erste Ausgabeeinheit (41) eine positive Elektrode ist und die zweite Ausgabeeinheit (42) eine negative Elektrode ist.

15. Drahtloses Energieversorgungsverfahren nach einem der Ansprüche 10 bis 13, wobei
die thermoelektrische Erzeugungsvorrichtung (10) beinhaltet:

(A) ein erstes Stützelement (11),
(B) ein zweites Stützelement (12), das dem ersten Stützelement (11) zugewandt ist,
(C) ein thermoelektrisches Umwandlungselement, das zwischen dem ersten Stützelement (11) und dem zweiten Stützelement (12) angeordnet ist, und
(D) eine erste Ausgabeeinheit (41) und eine zweite Ausgabeeinheit (42), die mit dem thermoelektrischen Umwandlungselement verbunden sind,

das thermoelektrische Umwandlungselement beinhaltet:

(C-1) ein erstes thermoelektrisches Umwandlungselement (21B), das zwischen dem ersten Stützelement (11) und dem zweiten Stützelement (12) angeordnet ist, und
(C-2) ein zweites thermoelektrisches Umwandlungselement (22B), das zwischen dem ersten Stützelement (11) und dem zweiten Stützelement (12) angeordnet ist, wobei sich ein Material des zweiten thermoelektrischen Umwandlungselements (22B) von einem Material des ersten thermoelektrischen Umwandlungselements (21B) unterscheidet, wobei das zweite thermoelektrische Umwandlungselement (22B) mit dem ersten thermoelektrischen Umwandlungselement (21B) elektrisch in Reihe geschaltet ist,

die erste Ausgabeeinheit (41) mit einem Ende des ersten thermoelektrischen Umwandlungselements (21B) verbunden ist, wobei sich das Ende an der Seite des ersten Stützelements befindet,
die zweite Ausgabeeinheit (42) mit einem Ende des zweiten thermoelektrischen Umwandlungselements (22B) verbunden ist, wobei sich das Ende an der Seite des ersten Stützelements befindet,
$\tau_{SM1} > \tau_{SM2}$ sowie
$VL_1 \neq VL_2$ erfüllt sind,
wobei das Volumen des ersten thermoelektrischen Umwandlungselements (21B) $VL_1$ ist, das Volumen des zweiten thermoelektrischen Umwandlungselements (22B) $VL_2$ ist, eine thermische Zeitkonstante des ersten Stützelements (11) $\tau_{SM1}$ ist und eine thermische Zeitkonstante des zweiten Stützelements (12) $\tau_{SM2}$ ist, und
das drahtlose Energieversorgungsverfahren umfasst:

das Anordnen der thermoelektrischen Erzeugungsvorrichtung in einer Umgebung, das Ändern der Umgebungstemperatur; und
das Führen von Strom an die Außenseite, wobei der Strom aufgrund einer Temperaturdifferenz zwischen dem ersten Stützelement (11) und dem zweiten Stützelement (12) erzeugt wird, wenn die Temperatur des zweiten Stützelements (12) höher ist als die Temperatur des ersten Stützelements (11), wobei der Strom von dem zweiten thermoelektrischen Umwandlungselement (22B) zu dem ersten thermoelektrischen Umwandlungselement (21B) fließt, die erste Ausgabeeinheit (41) eine positive Elektrode ist und die zweite Ausgabeeinheit (42) eine negative Elektrode ist.

**Revendications**

1. Dispositif d'alimentation électrique sans fil, comprenant :

(A) un dispositif de génération thermoélectrique (10) configuré pour être agencé dans une atmosphère dans un espace d'une pièce en tant que côté de réception, le dispositif de génération thermoélectrique (10) étant configuré pour générer de la thermoélectricité en réponse à un changement de température de l'atmosphère de la pièce ; et le système étant **caractérisé en ce qu'**il comprend également :

(B) un dispositif de régulation de température (60) configuré pour être agencé à l'écart du dispositif de génération thermoélectrique (10) en tant que côté de transmission, le dispositif de régulation de température (60) étant configuré pour provoquer un changement périodique de la température dans l'atmosphère de la pièce,
dans lequel le dispositif de régulation de température (60) est configuré pour établir un schéma d'amplitude et de cycle du changement périodique.

2. Dispositif d'alimentation électrique sans fil selon la revendication 1, comprenant
une pluralité de dispositifs de génération thermoélectrique (10), dans lequel
des caractéristiques de réponse thermique des dispositifs de génération thermoélectrique (10) sont les mêmes.

3. Dispositif d'alimentation électrique sans fil selon la revendication 1, comprenant :

une pluralité de dispositifs de génération thermoélectrique (10), dans lequel
des caractéristiques de réponse thermique des dispositifs de génération thermoélectrique (10) sont différentes les unes des autres, et
le dispositif de régulation de température (60) est configuré pour changer périodiquement la température d'une atmosphère de manière séquentielle sur la base d'un changement de température correspondant aux dispositifs de génération thermoélectrique (10), des caractéristiques de réponse thermique des dispositifs de génération thermoélectrique (10) étant différentes les unes des autres.

4. Dispositif d'alimentation électrique sans fil selon la revendication 1, comprenant :

une pluralité de dispositifs de génération thermoélectrique (10), dans lequel
des caractéristiques de réponse thermique des dispositifs de génération thermoélectrique (10) sont différentes les unes des autres, et
le dispositif de régulation de température (60) est configuré pour changer périodiquement la température d'une atmosphère de manière séquentielle sur la base d'un changement de température synthétisé correspondant aux dispositifs de génération thermoélectrique (10), des caractéristiques de réponse thermique des dispositifs de génération thermoélectrique (10) étant différentes les unes des autres.

5. Dispositif d'alimentation électrique sans fil selon l'une quelconque de la revendication 1 à la revendication 4, dans lequel
le dispositif de génération thermoélectrique comporte

(A) un premier élément de support (11),
(B) un second élément de support (12) opposé au premier élément de support (11),
(C) un élément de conversion thermoélectrique agencé entre le premier élément de support (11) et le second élément de support (12), et
(D) une première unité de sortie (41) et une deuxième unité de sortie (42) connectées à l'élément de conversion thermoélectrique,
l'élément de conversion thermoélectrique comporte
(C-1) un premier élément de conversion thermoélectrique (21A) agencé entre le premier élément de support (11) et le second élément de support (12), et
(C-2) un deuxième élément de conversion thermoélectrique (22A) agencé entre le premier élément de support (11) et le second élément de support (12), un matériau du deuxième élément de conversion thermoélectrique (22A) étant différent d'un matériau du premier élément de conversion thermoélectrique (21A), le deuxième élément de conversion thermoélectrique (22A) étant connecté électriquement au premier élément de conversion thermoélectrique (21A) en série,
la première unité de sortie (41) est connectée à une extrémité du premier élément de conversion thermoélectrique (21A), l'extrémité se trouvant du côté du premier élément de support,
la deuxième unité de sortie (42) est connectée à une extrémité du deuxième élément de conversion thermoélectrique (22A), l'extrémité se trouvant du côté du premier élément de support, et les équations
$T_{SM1} > T_{SM2}$ et
$S_{12} \neq S_{22}$ sont satisfaites
où l'aire d'une première surface du premier élément de conversion thermoélectrique (21A) est $S_{11}$, la première surface se trouvant sur le premier élément de support (11), l'aire d'une seconde surface du premier élément de conversion thermoélectrique (21A) est $S_{12}$ (où $S_{11}>S_{12}$), la seconde surface se trouvant sur le second élément de support (12), l'aire d'une première surface du deuxième élément de conversion thermoélectrique (22A) est $S_{21}$, la première surface se trouvant sur le premier élément de support (11), l'aire d'une seconde surface du deuxième élément de conversion thermoélectrique (22A) est $S_{22}$ (où $S_{21}>S_{22}$), la seconde surface se trouvant sur le second élément de support (12), une constante de temps thermique du premier élément de support (11) est $T_{SM1}$, et une constante de temps thermique du second élément de support (12) est $T_{SM2}$.

6. Dispositif d'alimentation électrique sans fil selon l'une quelconque de la revendication 1 à la revendication 4, dans lequel

le dispositif de génération thermoélectrique (10) comporte

(A) un premier élément de support (11),
(B) un second élément de support (12) opposé au premier élément de support (11),
(C) un élément de conversion thermoélectrique agencé entre le premier élément de support (11) et le second élément de support (12), et
(D) une première unité de sortie et une deuxième unité de sortie connectées à l'élément de conversion thermoélectrique, l'élément de conversion thermoélectrique comportant
(C-1) un premier élément de conversion thermoélectrique (21B) agencé entre le premier élément de support (11) et le second élément de support (12), et
(C-2) un deuxième élément de conversion thermoélectrique (22B) agencé entre le premier élément de support (11) et le second élément de support (12), un matériau du deuxième élément de conversion thermoélectrique (22B) étant différent d'un matériau du premier élément de conversion thermoélectrique (21B), le deuxième élément de conversion thermoélectrique (22B) étant connecté électriquement au premier élément de conversion thermoélectrique (21B) en série,
la première unité de sortie (41) est connectée à une extrémité du premier élément de conversion thermoélectrique (21B), l'extrémité se trouvant du côté du premier élément de support,
la deuxième unité de sortie (42) est connectée à une extrémité du deuxième élément de conversion thermoélectrique (22B), l'extrémité se trouvant du côté du premier élément de support, et les équations
$T_{SM1}>T_{SM2}$ et
$VL_1 \neq VL_2$ sont satisfaites
où le volume du premier élément de conversion thermoélectrique (21B) est $VL_1$, le volume du deuxième élément de conversion thermoélectrique (22B) est $VL_2$, une constante de temps thermique du premier élément de support (11) est $T_{SM1}$, et une constante de temps thermique du second élément de support (12) est $T_{SM2}$.

7. Dispositif d'alimentation électrique sans fil selon l'une quelconque de la revendication 1 à la revendication 4, dans lequel
le dispositif de génération thermoélectrique (10) comporte

(A) un premier élément de support (11),
(B) un second élément de support (12) opposé au premier élément de support (11),
(C) un premier élément de conversion thermoélectrique (121C) agencé entre le premier élément de support (11) et le second élément de support (12),
(D) un deuxième élément de conversion thermoélectrique (122C) agencé entre le premier élément de support (11) et le second élément de support (12), et
(E) une première unité de sortie (41) et une deuxième unité de sortie
le premier élément de conversion thermoélectrique (121C) comporte un premier élément de conversion thermoélectrique A (121CA) d'un type A sur le second élément de support (12) et un premier élément de conversion thermoélectrique B (121CB) d'un type B sur le premier élément de support (11), le premier élément de conversion thermoélectrique A (121CA) se trouvant sur le premier élément de conversion thermoélectrique B (121CB),
le deuxième élément de conversion thermoélectrique (122C) comporte un deuxième élément de conversion thermoélectrique A (122CA) du type A sur le premier élément de support (11) et un deuxième élément de conversion thermoélectrique B (122CB) du type B sur le second élément de support (12), le deuxième élément de conversion thermoélectrique A (122CA) se trouvant sur le deuxième élément de conversion thermoélectrique B (122CB),
le premier élément de conversion thermoélectrique (121C) et le deuxième élément de conversion thermoélectrique (122C) sont connectés électriquement en série,
la première unité de sortie (41) est connectée à une extrémité du premier élément de conversion thermoélectrique B (121CB),

la deuxième unité de sortie (42) est connectée à une extrémité du deuxième élément de conversion thermoélectrique A (122CA), et l'équation

$T_{SM1} \neq T_{SM2}$ est satisfaite

où une constante de temps thermique du premier élément de support (11) est $T_{SM1}$, et une constante de temps thermique du second élément de support (12) est $T_{SM2}$.

8. Dispositif d'alimentation électrique sans fil selon l'une quelconque de la revendication 1 à la revendication 4, dans lequel

le dispositif de génération thermoélectrique comporte

(A) un premier élément de support (11),

(B) un second élément de support (12) opposé au premier élément de support (11),

(C) un premier élément de conversion thermoélectrique agencé entre le premier élément de support (11) et le second élément de support (12),

(D) un deuxième élément de conversion thermoélectrique agencé entre le premier élément de support (11) et le second élément de support (12), et

(E) une première unité de sortie (41), une deuxième unité de sortie (42), une troisième unité de sortie (43), et une quatrième unité de sortie (44),

le premier élément de conversion thermoélectrique comporte

(C-1) un premier élément de conversion thermoélectrique (21D) agencé entre le premier élément de support (11) et le second élément de support (12), et

(C-2) un deuxième élément de conversion thermoélectrique (22D) agencé entre le premier élément de support (11) et le second élément de support (12), un matériau du deuxième élément de conversion thermoélectrique (22D) étant différent d'un matériau du premier élément de conversion thermoélectrique (21D), le deuxième élément de conversion thermoélectrique (22D) étant connecté électriquement au premier élément de conversion thermoélectrique (21D) en série,

le deuxième élément de conversion thermoélectrique comporte

(D-1) un troisième élément de conversion thermoélectrique (23D) agencé entre le premier élément de support (11) et le second élément de support (12), et

(D-2) un quatrième élément de conversion thermoélectrique (24D) agencé entre le premier élément de support (11) et le second élément de support (12), un matériau du quatrième élément de conversion thermoélectrique (24D) étant différent d'un matériau du troisième élément de conversion thermoélectrique (23D), le quatrième élément de conversion thermoélectrique (24D) étant connecté électriquement au troisième élément de conversion thermoélectrique (23D) en série,

la première unité de sortie (41) est connectée au premier élément de conversion thermoélectrique (21D),

la deuxième unité de sortie (42) est connectée au deuxième élément de conversion thermoélectrique (22D),

la troisième unité de sortie (43) est connectée au troisième élément de conversion thermoélectrique (23D),

la quatrième unité de sortie (44) est connectée au quatrième élément de conversion thermoélectrique (24D), et l'équation

$T_{SM1} \neq T_{SM2}$ est satisfaite

où une constante de temps thermique du premier élément de support (11) est $T_{SM1}$, et une constante de temps thermique du second élément de support (12) est $T_{SM2}$.

9. Dispositif d'alimentation électrique sans fil selon l'une quelconque de la revendication 1 à la revendication 4, dans lequel

le dispositif de génération thermoélectrique (10) comporte

(A) un premier élément de support (11),

(B) un second élément de support (12) opposé au premier élément de support (11),

(C) un premier élément de conversion thermoélectrique (121G) agencé entre le premier élément de support (11) et le second élément de support (12),

(D) un deuxième élément de conversion thermoélectrique (122G) agencé entre le premier élément de support (11) et le second élément de support (12),

(E) un troisième élément de conversion thermoélectrique (123G) agencé entre le premier élément de support (11) et le second élément de support (12),

(F) un quatrième élément de conversion thermoélectrique (124G) agencé entre le premier élément de support (11) et le second élément de support (12), et

(G) une première unité de sortie (41), une deuxième unité de sortie (42), une troisième unité de sortie (43), et une quatrième unité de sortie (44),
le premier élément de conversion thermoélectrique (121G) comporte un premier élément de conversion thermoélectrique A (121GA) d'un type A sur le second élément de support (12) et un premier élément de conversion thermoélectrique B (121GB) d'un type B sur le premier élément de support (11), le premier élément de conversion thermoélectrique A (121GA) se trouvant sur le premier élément de conversion thermoélectrique B (121GB),
le deuxième élément de conversion thermoélectrique (122G) comporte un deuxième élément de conversion thermoélectrique A (122GA) du type A sur le premier élément de support (11) et un deuxième élément de conversion thermoélectrique B (122GB) du type B sur le second élément de support (12), le deuxième élément de conversion thermoélectrique A (122GA) se trouvant sur le deuxième élément de conversion thermoélectrique B (122GB),
le troisième élément de conversion thermoélectrique (123G) comporte un troisième élément de conversion thermoélectrique A (123GA) du type A sur le second élément de support (12) et un troisième élément de conversion thermoélectrique B (123GB) du type B sur le premier élément de support (11), le troisième élément de conversion thermoélectrique A (123GA) se trouvant sur le troisième élément de conversion thermoélectrique B (123GB),
le quatrième élément de conversion thermoélectrique (124G) comporte un quatrième élément de conversion thermoélectrique A (124GA) du type A sur le premier élément de support (11) et un quatrième élément de conversion thermoélectrique B (124GB) du type B sur le second élément de support (12), le quatrième élément de conversion thermoélectrique A (124GA) se trouvant sur le quatrième élément de conversion thermoélectrique B (124GB),
le premier élément de conversion thermoélectrique (121G) et le deuxième élément de conversion thermoélectrique (122G) sont connectés électriquement en série,
le troisième élément de conversion thermoélectrique (123G) et le quatrième élément de conversion thermoélectrique (124G) sont connectés électriquement en série,
la première unité de sortie (41) est connectée au premier élément de conversion thermoélectrique (121G),
la deuxième unité de sortie (42) est connectée au deuxième élément de conversion thermoélectrique (122G),
la troisième unité de sortie (43) est connectée au troisième élément de conversion thermoélectrique (123G),
la quatrième unité de sortie (44) est connectée au quatrième élément de conversion thermoélectrique (124G),
et l'équation
$T_{SM1} \neq T_{SM2}$ est satisfaite
où une constante de temps thermique du premier élément de support (11) est $T_{SM1}$, et une constante de temps thermique du second élément de support (12) est $T_{SM2}$.

10. Procédé d'alimentation électrique sans fil utilisant un système d'alimentation électrique sans fil, le dispositif d'alimentation électrique sans fil comportant un dispositif de génération thermoélectrique (10) agencé dans une atmosphère dans un espace d'une pièce en tant que côté de réception et un dispositif de régulation de température (60) agencé à l'écart d'un a dispositif de génération thermoélectrique (10) en tant que côté de transmission, le procédé d'alimentation électrique sans fil comprenant :

l'établissement, par le dispositif de régulation de température (60), d'un schéma d'une amplitude et d'un cycle d'un changement périodique de température ;
la provocation, par le dispositif de régulation de température (60), du changement périodique de la température dans l'atmosphère de la pièce selon le schéma ;
la génération, par le dispositif de génération thermoélectrique (10), de thermoélectricité en réponse à un changement de température de l'atmosphère de la pièce ;
et l'envoi de la puissance électrique obtenue à l'extérieur.

11. Procédé d'alimentation électrique sans fil selon la revendication 10, dans lequel
le dispositif d'alimentation électrique sans fil comporte une pluralité de dispositifs de génération thermoélectrique (10), et
de caractéristiques de réponse thermique des dispositifs de génération thermoélectrique (10) sont les mêmes.

12. Procédé d'alimentation électrique sans fil selon la revendication 10, dans lequel
le dispositif d'alimentation électrique sans fil comporte une pluralité de dispositifs de génération thermoélectrique,
des caractéristiques de réponse thermique des dispositifs de génération thermoélectrique (10) sont différentes les unes des autres, et le procédé d'alimentation électrique sans fil comprend le changement périodique, par le dispositif de régulation de température (60), de la température d'une atmosphère de manière séquentielle sur la base d'un changement de température correspondant aux dispositifs de génération thermoélectrique (10), des caractéristiques de réponse thermique des dispositifs de génération thermoélectrique (10) étant différentes les unes des autres .

**13.** Procédé d'alimentation électrique sans fil selon la revendication 10, dans lequel
le dispositif d'alimentation électrique sans fil comporte une pluralité de dispositifs de génération thermoélectrique, des caractéristiques de réponse thermique des dispositifs de génération thermoélectrique (10) sont différentes les unes des autres, et
le procédé d'alimentation électrique sans fil comprend le changement périodique, par le dispositif de régulation de température (60), de la température d'une atmosphère de manière séquentielle sur la base d'un changement de température synthétisé correspondant aux dispositifs de génération thermoélectrique (10), des caractéristiques de réponse thermique des dispositifs de génération thermoélectrique (10) étant différentes les unes des autres.

**14.** Procédé d'alimentation électrique sans fil selon l'une quelconque de la revendication 10 à la revendication 13, dans lequel
le dispositif de génération thermoélectrique (10) comporte

(A) un premier élément de support (11),
(B) un second élément de support (12) opposé au premier élément de support (11),
(C) un élément de conversion thermoélectrique agencé entre le premier élément de support (11) et le second élément de support (12), et
(D) une première unité de sortie (41) et une deuxième unité de sortie (42) connectées à l'élément de conversion thermoélectrique,
l'élément de conversion thermoélectrique comporte
(C-1) un premier élément de conversion thermoélectrique (21A) agencé entre le premier élément de support (11) et le second élément de support (12), et
(C-2) un deuxième élément de conversion thermoélectrique (22A) agencé entre le premier élément de support (11) et le second élément de support (12), un matériau du deuxième élément de conversion thermoélectrique (22A) étant différent d'un matériau du premier élément de conversion thermoélectrique (21A), le deuxième élément de conversion thermoélectrique (22A) étant connecté électriquement au premier élément de conversion thermoélectrique (21A) en série,
la première unité de sortie (41) est connectée à une extrémité du premier élément de conversion thermoélectrique (21A), l'extrémité se trouvant du côté du premier élément de support,
la deuxième unité de sortie (42) est connectée à une extrémité du deuxième élément de conversion thermoélectrique (22A), l'extrémité se trouvant du côté du premier élément de support, les équations
$T_{SM1} > T_{SM2}$ et
$S_{12} \neq S_{22}$ sont satisfaites
où l'aire d'une première surface du premier élément de conversion thermoélectrique (21A) est $S_{11}$, la première surface se trouvant sur le premier élément de support (11), l'aire d'une seconde surface du premier élément de conversion thermoélectrique (21A) est $S_{12}$ (où $S_{11} > S_{12}$), la seconde surface se trouvant sur le second élément de support (12), l'aire d'une première surface du deuxième élément de conversion thermoélectrique (22A) est $S_{21}$, la première surface se trouvant sur le premier élément de support (11), l'aire d'une seconde surface du deuxième élément de conversion thermoélectrique (22A) est $S_{22}$ (où $S_{21} > S_{22}$), la seconde surface se trouvant sur le second élément de support (12), une constante de temps thermique du premier élément de support (11) es $T_{SM1}$, et une constante de temps thermique du second élément de support (12) est $T_{SM2}$, et
le procédé d'alimentation électrique sans fil comprend :

l'agencement du dispositif de génération thermoélectrique dans une atmosphère, la température atmosphérique changeant ; et
l'envoi de courant à l'extérieur, le courant étant généré en raison d'une différence de température entre le premier élément de support (11) et le second élément de support (12) quand la température du second élément de support (12) est supérieure à la température du premier élément de support (11), le courant passant du deuxième élément de conversion thermoélectrique (22A) au premier élément de conversion thermoélectrique (21A), la première unité de sortie (41) étant une électrode positive, la deuxième unité de sortie (42) étant un électrode négative.

**15.** Procédé d'alimentation électrique sans fil selon l'une quelconque de la revendication 10 à la revendication 13, dans lequel
le dispositif de génération thermoélectrique (10) comporte

(A) un premier élément de support (11),

(B) un second élément de support (12) opposé au premier élément de support (11),

(C) un élément de conversion thermoélectrique agencé entre le premier élément de support (11) et le second élément de support (12), et

(D) une première unité de sortie (41) et une deuxième unité de sortie (42) connectées à l'élément de conversion thermoélectrique,

l'élément de conversion thermoélectrique comporte

(C-1) un premier élément de conversion thermoélectrique (21B) agencé entre le premier élément de support (11) et le second élément de support (12), et

(C-2) un deuxième élément de conversion thermoélectrique (22B) agencé entre le premier élément de support (11) et le second élément de support (12), un matériau du deuxième élément de conversion thermoélectrique (22B) étant différent d'un matériau du premier élément de conversion thermoélectrique (21B), le deuxième élément de conversion thermoélectrique (22B) étant connecté électriquement au premier élément de conversion thermoélectrique (21B) en série,

la première unité de sortie (41) est connectée à une extrémité du premier élément de conversion thermoélectrique (21B), l'extrémité se trouvant du côté du premier élément de support,

la deuxième unité de sortie (42) est connectée à une extrémité du deuxième élément de conversion thermoélectrique (22B), l'extrémité se trouvant du côté du premier élément de support, les équations

$T_{SM1} > T_{SM2}$ et

$VL_1 \neq VL_2$ sont satisfaites

où le volume du premier élément de conversion thermoélectrique (21B) est $VL_1$, le volume du deuxième élément de conversion thermoélectrique (22B) est $VL_2$, une constante de temps thermique du premier élément de support (11) est $T_{SM1}$, et une constante de temps thermique du second élément de support (12) est $T_{SM2}$, et le procédé d'alimentation électrique sans fil comprend :

l'agencement du dispositif de génération thermoélectrique dans une atmosphère, la température atmosphérique changeant ; et

l'envoi de courant à l'extérieur, le courant étant généré en raison d'une différence de température entre le premier élément de support (11) et le second élément de support (12) quand la température du second élément de support (12) est supérieure à la température du premier élément de support (11), le courant passant du deuxième élément de conversion thermoélectrique (22B) au premier élément de conversion thermoélectrique (21B), la première unité de sortie (41) étant une électrode positive, la deuxième unité de sortie (42) étant un électrode négative.

(A)

Book

60

Temperature control device

61 — Frequency control circuit

62 — Temperature adjusting apparatus

63 — Output controller

Heat

50

Thermoelectric generation circuit

Thermoelectric generation device — 10

Rectifier — 51

DC/DC boost converter — 52

53

Charge-discharge control circuit

Secondary battery

54

Electronic tag — 70

(B)

60

Temperature control device

Heat

Book

Thermoelectric generation circuit — 50

Electronic tag — 70

Book

Thermoelectric generation circuit — 50

Electronic tag — 70

Book

Thermoelectric generation circuit — 50

Electronic tag — 70

Radio wave

Book management device

71

FIG.1

A: 1 hour
B: 10 minutes
C: 1 minute
D: 10 seconds
E: 1 second

FIG.2

EP 2 680 430 B1

FIG.3

(Example 4)

(A)

(B)

FIG.4

(Example 5)

FIG.5

(Example 6)

(A)

(B)

FIG.6

(Example 7)

**212**
Second support member

**222C_B**

**232**

**221C_A**

**242**
Second output unit

**213**

**241**
First output unit

**231**

**222C_A**

**211**
First support member

**221C_B**

**222C**
Second thermoelectric conversion element

**221C**
First thermoelectric conversion element

FIG.7

(Example 7)

FIG.8

(Example 8)

(A)

**12** Second support member

**22D** Second thermoelectric conversion member

$T_{amb}$

**31B**

$\tau_2$

$T_B$

$21D_2$

$21D_1$

$22D_2$

$22D_1$

$T_2$ p $T_2$ n

$T_1$ $T_1$

$\tau_1$

$T_A$

**41** First output unit

**31A**

**21D** First thermoelectric conversion member

**11** First support member

**42** Second output unit

(B)

**12** Second support member

**24D** Fourth thermoelectric conversion member

$T_{amb}$

**32B**

$\tau_2$

$T_B$

$24D_2$

$24D_1$

$23D_2$

$23D_1$

p $T_4$ n $T_4$

$T_3$ $T_3$

$\tau_1$

$T_A$

**43** Third output unit

**32A**

**23D** Third thermoelectric conversion member

**11** First support member

**44** Fourth output unit

# FIG.9

FIG.10

(Example 9)

(A)

(B)

FIG.11

FIG.12

(Example 10)

(A)

(B)

FIG.13

FIG.14

(Example 11)

(A)

(B)

FIG.15

FIG.16

(Example 12)

(A)

(B)

FIG.17

69

FIG.18

(Example 13)

(A)

(B)

FIG.19

( A )

( B )

( C )

( D )

FIG.20

FIG.21

FIG.22

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009501510 A
- JP 2011030317 A
- US 20090205695 A
- WO 2010112554 A
- WO 2010067367 A
- WO 2010071749 A
- AT 507533
- US 20090301539 A